# EUROPEAN PATENT APPLICATION

(11) **EP 4 629 269 A2**
(43) Date of publication of application: **08.10.2025**
(21) Application number: 25163563.7
(22) Date of filing: 13.03.2025
(51) Int. Cl.: H01F 27/28, H02M 3/00, H05K 1/16

(54) **RESONANT CONVERTER**

(30) Priority: 15.03.2024 US 202463565803 P
(71) Applicant: DELTA ELECTRONICS, INC., Taoyuan City 320023 (TW)
(72) Inventor: CHANG, Yi-Sheng, 320023 Taoyuan City (TW); HSU, Cheng-Chan, 320023 Taoyuan City (TW); LAI, Chien-An, 320023 Taoyuan City (TW); WU, Zhi-Yuan, 320023 Taoyuan City (TW); WANG, Yu-Tai, 320023 Taoyuan City (TW); LEE, Chyi-Jiunn, 320023 Taoyuan City (TW); TSAI, Meng-Chi, 320023 Taoyuan City (TW)
(74) Representative: 2K Patentanwälte Blasberg Kewitz & Reichel

(57) **Abstract**

A resonant converter (100) includes a circuit board (CB), a primary-side circuit (1A), a secondary-side circuit (3A) and a planar transformer (PE). The planar transformer (PE) includes a first through hole (H1), an iron core (C1), a plurality of vias (Via_A to Via_H), and a plurality of wirings (T_1 to T_n, T_(n), T_(m), T_1(n) to T_n(n), T_1(m) to T_n(m)). The primary-side circuit (1A), the secondary-side circuit (3A), and the planar transformer (PE) are disposed on the circuit board (CB), and the planar transformer (PE) is electrically connected to the primary-side circuit (1A) and the secondary-side circuit (3A). The first through hole (H1) penetrates through the circuit board (CB), and the iron core (C1) includes a first core column (C12) penetrating through the first through hole (H1). The vias (Via_A to Via_H) are electrically connected to a first sub-layer board (LA1 to LA12) and a second sub-layer board (LA1 to LA12) of the circuit board (CB), and the wirings (T_1 to T_n, T_(n), T_(m), T_1(n) to T_n(n), T_1(m) to T_n(m)) are formed around the first through hole (H1) to be used as a winding (22) of the planar transformer (PE). The wirings (T_1 to T_n, T_(n), T_(m), T_1(n) to T_n(n), T_1(m) to T_n(m)) interleavingly extend to the first sub-layer board (LA1 to LA12) and the second sub-layer board (LA1 to LA12) through the vias (Via_A to Via_H), and the wirings (T_1 to T_n, T_(n), T_(m), T_1(n) to T_n(n), T_1(m) to T_n(m)) on the same layer are arranged in parallel.

## Description

### BACKGROUND

### Technical Field

The present disclosure relates to a resonant converter, and more particularly to a resonant converter using a planar transformer.

### Description of Related Art

With the rapid development of the information industry, power supplies have played an indispensable role. The input voltage of information and household appliances is divided into an AC voltage and a DC voltage, and power supplies may generally be divided into two stages, i.e., a front stage and a rear stage. In general, the front stage is usually composed of an AC-to-DC converter, a power factor corrector (PFC) or a DC-to-DC converter, and the rear stage is usually composed of a resonant converter. The resonant converter is a DC-to-DC power converter, and it may operate in zero-voltage switching on the primary-side switches and zero-current switching on the secondary-side rectifier switches thereof. Therefore, compared with other converters, the resonant converter has the advantages of high output power and high conversion efficiency. Furthermore, by using synchronous rectification switches on the secondary side, it is easier to achieve high efficiency and high power density performance.

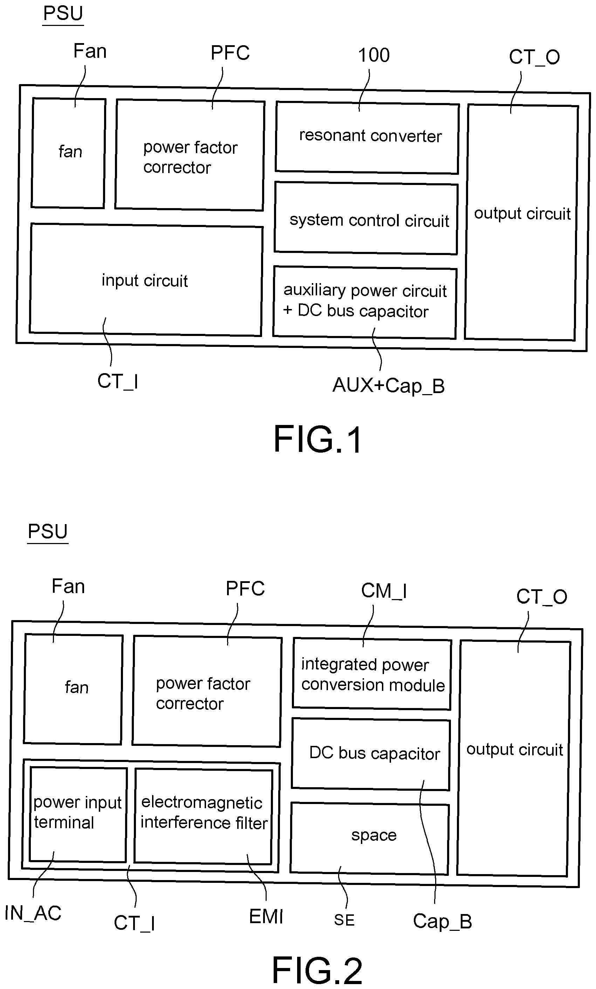

Furthermore, FIG. 1 shows a schematic diagram of an internal circuit configuration of a conventional power supply. The power supply unit PSU includes an input circuit CT_I, a power factor corrector PFC, an auxiliary power circuit AUX, a DC bus capacitor Cap_B, a resonant converter 100, a control circuit MCU, and an output circuit CT_O. The power supply unit PSU may also optionally include a fan Fan to dissipate heat during operation. The input circuit CT_I receives an AC power, performs power factor correction through the power factor corrector PFC, and converts the AC power into a DC power so as to store the DC power in the DC bus capacitor Cap_B. The auxiliary power circuit AUX converts the DC power into an auxiliary power to supply power to various components of the power supply unit PSU that require small DC power (such as, but not limited to, the controller of each converter, the driver, the fan Fan, the LED, etc.). The resonant converter 100 converts the DC power into an output power, and provides the output power to a load (for example, a server) coupled to a rear end through the output circuit CT_O to supply power to the load. The control circuit MCU is used for communicating with the load through the output circuit CT_O, and controlling the power supply unit PSU according to the communication results.

In the prior art, a resonant converter generally includes inductive components such as a resonant inductor and a transformer. These inductive components are generally composed of a winding, a bobbin, and an iron core. The winding should be formed by winding copper wires on a winding frame for more than dozens of turns, and then the winding is wrapped around the iron core to form a closed magnetic circuit. Therefore, the resonant inductor and transformer usually have the fatal disadvantage of being bulky and cannot effectively reduce the size of the resonant converter, resulting in the problem of a bulky power supply and poor power density.

Since the windings of the transformer are generally made of single-core wire wound in the same direction, the resonant converter used for high-frequency switching will have a large AC impedance. This results in low efficiency of the resonant converter, and the same winding direction will lead to superposition of magnetic flux, which can easily cause the transformer to be saturated and short-circuited during operation of the resonant converter.

### SUMMARY

Therefore, how to design a resonant converter to solve the problems and technical bottlenecks in the existing technology has become a critical topic in this field.

In order to solve the above-mentioned problems, the present disclosure provides a resonant converter. The resonant converter includes a circuit board, a primary-side circuit, a secondary-side circuit, and a planar transformer. The circuit board includes a plurality of sub-layer boards. The primary-side circuit is disposed on the circuit board. The secondary-side circuit is disposed on the circuit board. The planar transformer is disposed on the circuit board and is electrically connected to the primary-side circuit and the secondary-side circuit. The planar transformer includes a first through hole, an iron core, a plurality of vias, and a plurality of wirings. The first through hole penetrates the circuit board. The iron core includes a first core column penetrating the first through hole. The plurality of vias are electrically connected to a first sub-layer board and a second sub-layer board of the circuit board. The plurality of wirings are formed around the first through hole, and are used as a winding of the planar transformer. The plurality of wirings interleavingly extend to the first sub-layer board and the second sub-layer board through the plurality of vias, and the wirings on the same layer are arranged in parallel.

In order to solve the above-mentioned problems, the present disclosure further provides a resonant converter. The resonant converter includes a circuit board, a primary-side circuit, a secondary-side circuit, and a planar transformer. The circuit board includes a plurality of sub-layer boards. The primary-side circuit is disposed on the circuit board. The secondary-side circuit is disposed on the circuit board. The secondary-side circuit includes a first switch, a second switch, and an output capacitor. The first switch is disposed on the circuit board. The second switch is disposed on the circuit board. The output capacitor is disposed on the circuit board, and a first terminal of the output capacitor is electrically connected to a first terminal of the first switch and a first terminal of the second switch. The planar transformer is disposed on the circuit board and is electrically connected to a second terminal of the first switch, a second terminal of the second switch, and a second terminal of the output capacitor. The planar transformer includes a first through hole, an iron core, a first via and a second via, a third via and a fourth via, a first secondary-side wiring, and a second secondary-side wiring. The first through hole penetrates the circuit board. The iron core includes a first core column penetrating the first through hole. The first via and the second via are respectively formed on a first side of the first through hole and a second side opposite to the first side, and are electrically connected to a first sub-layer board and a second sub-layer board. The first switch, the second switch, and the output capacitor are disposed on the second side. The third via and the fourth via are respectively formed on the first side and the second side, and are electrically connected to the first sub-layer board and the second sub-layer board. The first secondary-side wiring is electrically connected to the first switch. The second secondary-side wiring is electrically connected to the second switch and the first secondary-side wiring. The first secondary-side wiring extends from the first sub-layer board to the first via in a first direction surrounding the first through hole, extends to the second sub-layer board through the first via, and continues to extend to the second side in the first direction to be electrically connected to the output capacitor through the second via. The second secondary-side wiring extends from the first sub-layer board to the third via in a second direction surrounding the first through hole, extends to the second sub-layer board through the third via, and continues to extend to the second side in the second direction to be electrically connected to the output capacitor through the fourth via. The first direction and the second direction are in opposite directions along the first through hole.

The effect of the present disclosure is that the winding of the transformer is planarized on a circuit board by the wiring interleaving winding, and the wiring interleaving layout produces an effect of magnetic flux cancellation, thereby achieving the effect of reducing the AC impedance of the resonant converter.

It is to be understood that both the foregoing general description and the following detailed description are exemplary, and are intended to provide further explanation of the present disclosure as claimed. Other advantages and features of the present disclosure will be apparent from the following description, drawings, and claims.

### BRIEF DESCRIPTION OF DRAWINGS

The present disclosure can be more fully understood by reading the following detailed description of the embodiment, with reference made to the accompanying drawing as follows:
FIG. 1 is a schematic diagram of an internal circuit configuration of a conventional power supply.
FIG. 2 is a schematic diagram of an internal circuit configuration of a power supply in combination with an integrated power conversion module according to the present disclosure.
FIG. 3A is a circuit diagram of a resonant converter according to a first embodiment of the present disclosure.
FIG. 3B is a circuit diagram of the resonant converter according to a second embodiment of the present disclosure.
FIG. 3C is a circuit diagram of the resonant converter according to a third embodiment of the present disclosure.
FIG. 4A is a perspective circuit structure assembled diagram of the resonant converter according to the first embodiment of the present disclosure.
FIG. 4B is a perspective circuit structure exploded diagram of the resonant converter according to the first embodiment of the present disclosure.
FIG. 5A is a wiring structure diagram of one surface layer of a circuit board according to a first embodiment of the present disclosure.
FIG. 5B is a wiring structure diagram of another surface layer of the circuit board according to the first embodiment of the present disclosure.
FIG. 6A to FIG. 6L are schematic diagrams of wiring the windings of the planar transformer on each sub-layer board of the circuit board according to a first embodiment of the present disclosure.
FIG. 7 is a schematic diagram of a wiring stacking structure of the planar transformer of FIG. 6A to FIG. 6L on each sub-layer board of the circuit board according to a first embodiment, and a magnetomotive force curve when using the planar transformer for the first secondary-side wirings in operation.
FIG. 8A is a diagram of a winding arrangement of a ring-shaped transformer according to the present disclosure.
FIG. 8B is a perspective view of a wiring interleaving winding of the first embodiment and the second embodiment of the ring-shaped transformer according to the present disclosure.
FIG. 8C is a comparison diagram of the wiring with different angles according to the present disclosure.
FIG. 8D is an impedance curve diagram of the wiring with different angles according to the present disclosure.
FIG. 9A is a diagram of the magnetic flux distribution of the wiring according to the present disclosure.
FIG. 9B is a schematic diagram of the magnetic flux cancellation of a wiring interleaving layout of a first embodiment according to the present disclosure.
FIG. 9C is a schematic diagram of the magnetic flux cancellation of a wiring interleaving layout of a second embodiment according to the present disclosure.
FIG. 10A is a perspective view of a wiring pattern formed in a wiring area according to the present disclosure.
FIG. 10B is a schematic diagram of the magnetic flux cancellation after enlarging areas A4, A5 of FIG. 10A according to the present disclosure.
FIG. 10C is a comparison diagram of the wiring with different widths in the same wiring area according to the present disclosure.
FIG. 10D is an impedance curve diagram of the wiring with different widths in the same wiring area according to the present disclosure.
FIG. 11A is a schematic diagram of a wiring arrangement of the planar transformer according to the present disclosure.
FIG. 11B is a perspective plan view of a wiring structure of the planar transformer according to the present disclosure.
FIG. 11C is a perspective view of the wiring structure of the planar transformer according to the present disclosure.
FIG. 12A is a schematic diagram of the extension of secondary-side wirings using wiring interleaving winding according to a first embodiment of the present disclosure.
FIG. 12B is a schematic diagram of the extension of secondary-side wirings using wiring interleaving winding according to a second embodiment of the present disclosure.
FIG. 13 is a structural diagram of the arrangement of secondary-side wirings using wiring interleaving winding according to the present disclosure.
FIG. 14A is a cross-sectional view of the circuit board for power components of the resonant converter using an embedding technology according to the present disclosure.
FIG. 14B is a top view of the circuit board for power components of the resonant converter using an embedding technology according to the present disclosure.
FIG. 14C is a circuit configuration diagram of power components on the secondary side of the resonant converter embedded in a surface layer of the circuit board using the embedding technology according to the present disclosure.
FIG. 14D is a circuit configuration diagram of power components on the secondary side of the resonant converter embedded in another surface layer of the circuit board using the embedding technology according to the present disclosure.
FIG. 14E is a top view and a cross-sectional view of the circuit board using the embedding technology for wiring the planar transformer according to a first embodiment of the present disclosure.
FIG. 14F is a top view and a cross-sectional view of the circuit board using the embedding technology for wiring the planar transformer according to a second embodiment of the present disclosure.
FIG. 14G is a side view of the circuit board using the embedding technology for wiring the power components and the planar transformer according to the present disclosure.
FIG. 15A is an arrangement diagram of components of a secondary-side circuit of the resonant converter according to the present disclosure.
FIG. 15B is an arrangement diagram of components of different secondary-side circuits of the resonant converter according to the present disclosure.
FIG. 16A is a perspective circuit structure assembled diagram in a first perspective of the resonant converter according to a second embodiment of the present disclosure.
FIG. 16B is a perspective circuit structure assembled diagram in a second perspective of the resonant converter according to the second embodiment of the present disclosure.
FIG. 16C is a perspective circuit structure assembled diagram in a third perspective of the resonant converter according to the second embodiment of the present disclosure.
FIG. 16D is a perspective circuit structure exploded diagram of the resonant converter according to the second embodiment of the present disclosure.
FIG. 17A is a wiring structure diagram of one surface layer of a first circuit board according to a second embodiment of the present disclosure.
FIG. 17B is a wiring structure diagram of one surface layer of the first circuit board according to the second embodiment of the present disclosure.
FIG. 18A is a wiring structure diagram of one surface layer of a second circuit board according to the second embodiment of the present disclosure.
FIG. 18B is a wiring structure diagram of one surface layer of the second circuit board according to the second embodiment of the present disclosure.
FIG. 19A to FIG. 19H are schematic diagrams of wiring the windings of the planar transformer on each sub-layer board of the first circuit board according to a second embodiment of the present disclosure.
FIG. 20A to FIG. 20H are schematic diagrams of wiring the windings of the planar transformer on each sub-layer board of the second circuit board according to the second embodiment of the present disclosure.
FIG. 21A is a schematic diagram of a wiring stacking structure of the planar transformer of FIG. 19A to FIG. 19H on each sub-layer board of the first circuit board according to a second embodiment, and a magnetomotive force curve when using the first circuit board for the first secondary-side wirings in operation.
FIG. 21B is a schematic diagram of a wiring stacking structure of the planar transformer of FIG. 20A to FIG. 20H on each sub-layer board of the second circuit board according to the second embodiment, and a magnetomotive force curve when using the second circuit board for the first secondary-side wirings in operation.

### DETAILED DESCRIPTION

Reference will now be made to the drawing figures to describe the present disclosure in detail. It will be understood that the drawing figures and exemplified embodiments of present disclosure are not limited to the details thereof.

Please refer to FIG. 2, which shows a schematic diagram of an internal circuit configuration of a power supply in combination with an integrated power conversion module according to the present disclosure. The power supply unit PSU includes an input circuit CT_I, a power factor corrector PFC, a DC bus capacitor Cap_B, an integrated power conversion module CM_I, and an output circuit CT_O. The power supply unit PSU may also optionally include a fan Fan to dissipate heat during operation. The input circuit CT_I includes a power input terminal IN_AC and an electromagnetic interference filter EMI. The integrated power conversion module CM_T includes a resonant converter 100, a system control circuit MCU, and an auxiliary power circuit AUX. The power supply unit PSU receives the AC power source Pac from the power input terminal IN_AC of the input circuit CT_I, and converts the AC power source Pac into the DC power source Pdc after being filtered by the electromagnetic interference filter EMI and corrected in power factor by the power factor corrector PFC, and the converted DC power source Pdc is stored in the DC bus capacitor Cap_B. The DC power source Pdc may be converted into an output power source Po by the resonant converter 100, and may be provided to a critical load (not shown) of a back-end system through the output circuit CT_O. The DC power source Pdc may also be converted into an auxiliary power supply Paux via the auxiliary power circuit AUX, and in addition to being provided to non-critical loads (not shown) of the back-end system through the output circuit CT_O, it may also be provided internally to peripheral devices, such as fans Fan.

In one embodiment, the system control circuit MCU includes a plurality of controllers (not shown), and each controller can control internal circuits such as the power factor corrector PFC, the resonant converter 100, and the auxiliary power circuit AUX of the power supply unit PSU, and can also control the power supply unit PSU to communicate with the outside (for example, a back-end system). In another embodiment, the present disclosure integrates the auxiliary power circuit AUX, the resonant converter 100, and the system control circuit MCU into an integrated power conversion module CM_I, and therefore a lot of wiring space can be saved and at least the space SE of the power supply unit PSU can be saved (indicated by the dotted line).

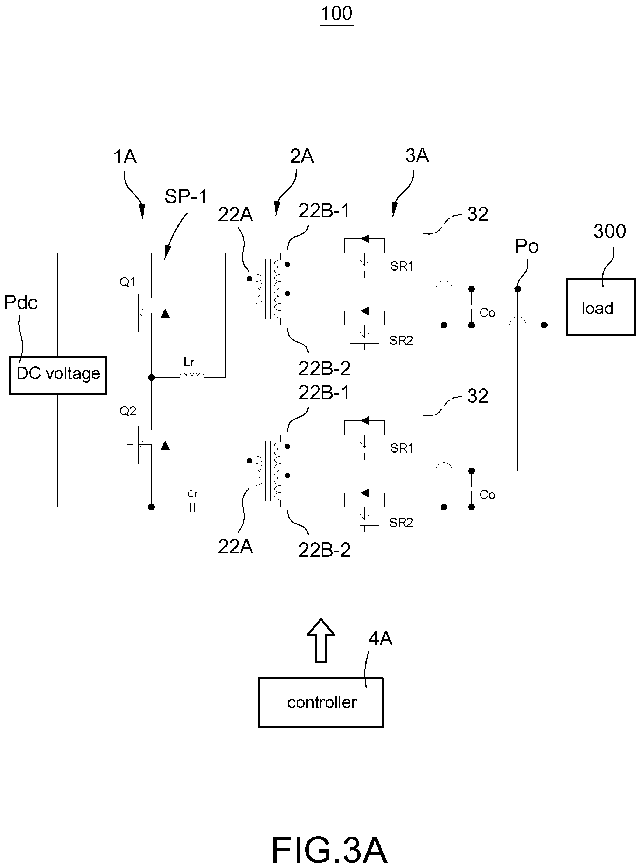

Please refer to FIG. 3A to FIG. 3C, which show circuit diagrams of a resonant converter according to a first embodiment, a second embodiment, and a third embodiment of the present disclosure, and also refer to FIG. 1 and FIG. 2 again. The resonant converter 100 receives a DC power source Pdc and is electrically connected to a load 300 (i.e., a critical load). The resonant converter 100 is, for example, an LLC converter, and includes a primary-side circuit 1A, a transformer 2A, a secondary-side circuit 3A, and a controller 4A in a system control circuit MCU for controlling the resonant converter 100. A first terminal of the primary-side circuit 1A receives the DC power source Pdc, and a second terminal of the primary-side circuit 1A is electrically connected to the primary-side winding 22A of the transformer 2A. A secondary-side winding 22B of the transformer 2A is electrically connected to a first terminal of the secondary-side circuit 3A, and a second terminal of the secondary-side circuit 3A is electrically connected to the load 300. The controller 4A is electrically connected to the primary-side circuit 1A and the secondary-side circuit 3A, and controls the resonant converter 100 to convert the DC power source Pdc into the output power source Po by controlling the primary-side circuit 1A and the secondary-side circuit 3A.

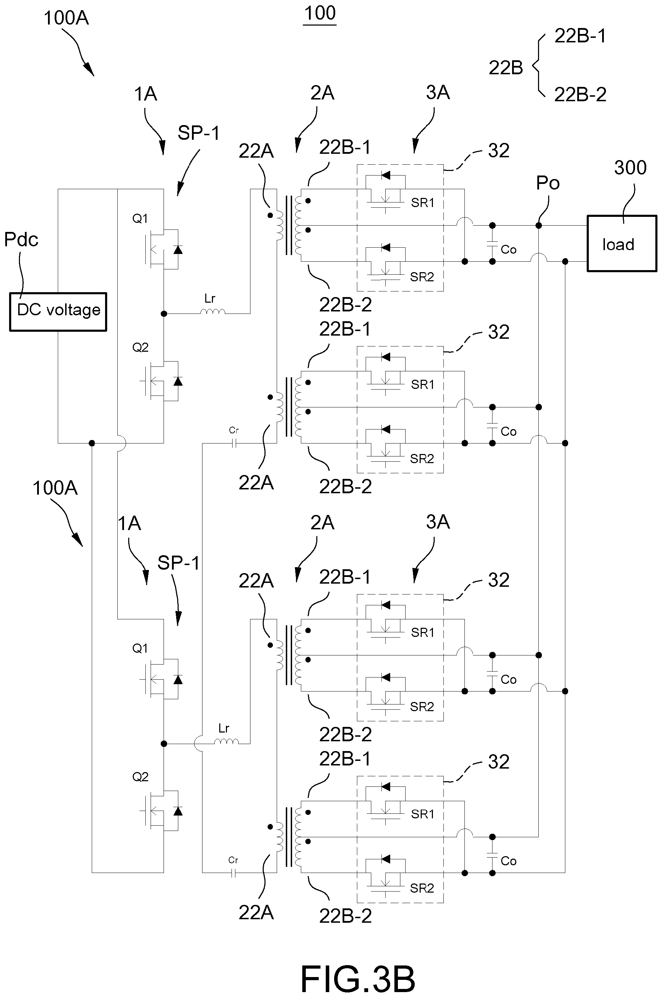

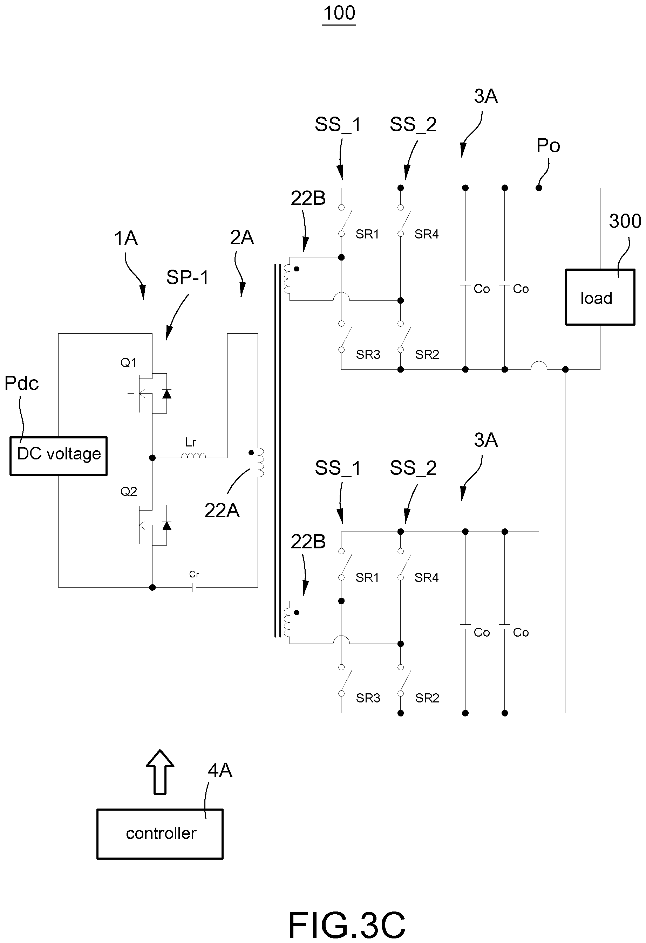

The resonant converter 100 includes a variety of implementation structures. For example, the primary-side circuit 1A may be a half-bridge type (see FIG. 3A to FIG. 3C), a full-bridge type, or the like. The secondary-side circuit 3A may be a half-bridge type, a center-tapped type (see FIG. 3A and FIG. 3B), a full-bridge type (see FIG. 3C), etc., and the secondary-side circuit 3A may be a single group or multiple groups in parallel. The number of the secondary-side windings 22B is determined by the number of the secondary-side circuits 3A. For example, FIG. 3A and FIG. 3C show two groups of secondary-side windings 22B and secondary-side circuits 3A. The number of primary-side windings 22A is an integer multiple of the secondary-side windings 22B, for example, FIG. 3A is two to two, and FIG. 3C is one to two. The resonant converter 100 may also be composed of multiple groups of resonant conversion circuits 100A, for example, the structure of FIG. 3B is composed of two groups of structures of FIG. 3A. The primary-side circuits 1A are connected in series through the primary-side windings 22A, and the output ends of the secondary-side circuits 3A are connected in parallel.

Please refer to FIG. 3A and FIG. 3B, the primary-side circuit 1A includes a primary-side switch bridge arm SP_1 and a resonant tank (including a resonant inductor Lr and a resonant capacitor Cr connected in series), and the primary-side switch bridge arm SP_1 includes two power switches Q1, Q2 connected in series to form a primary-side topology. The secondary-side circuit 3A includes a rectifier circuit 32 and an output capacitor Co, and the rectifier circuit 32 includes a first switch SR1 and a second switch SR2. The secondary-side winding 22B includes a first winding 22B-1 and a second winding 22B-2, and the first winding 22B-1 and the second winding 22B-2 are center-tapped windings. A first terminal of the first winding 22B-1 and a first terminal of the second winding 22B-2 are electrically connected to a first terminal of the first switch SR1 and a first terminal of the second switch SR2 respectively, and a second terminal of the first winding 22B-1 and a second terminal of the second winding 22B-2 are electrically connected to a first terminal of the output capacitor Co. A second terminal of the first switch SR1 and a second terminal of the second switch SR2 are electrically connected to a second terminal of the output capacitor Co, and the output capacitor Co of each group of secondary side circuit 3A is connected in parallel to form a topology of the secondary side.

The controller 4A controls the primary-side switch bridge arm SP_1 and the first switch SR1 and the second switch SR2 of the rectifier circuit 32 to store and release energy in the resonant tank and the transformer 2A, and the DC power source Pdc received by the resonant converter 100 is converted into an output power source Po through the energy storage and release of the resonant tank and the transformer 2A, and supplies power to the load 300. The difference between FIG. 3C and FIG. 3A and FIG. 3B is that the rectifier circuit 32 includes secondary-side switch bridge arms SS_1, SS_2. The secondary-side switch bridge arms SS_1, SS_2 are connected in parallel. The secondary-side switch bridge arm SS_1 includes a first switch SR1 and a third switch SR3 connected in series, and the secondary-side switch bridge arm SS_2 includes a fourth switch SR4 and a second switch SR2 connected in series. The two terminals of the secondary-side winding 22B are electrically connected to a series node between the first switch SR1 and the third switch SR3 and a series node between the fourth switch SR4 and the second switch SR2. In other embodiments, the primary-side circuit 1A, the transformer 2A, and the secondary-side circuit 3A of the resonant converter 100 may be changed according to different design considerations. For example, the primary-side circuit 1A uses a full-bridge structure, the transformer 2A includes only a primary-side winding 22A and a secondary-side winding 22B, and the secondary-side circuit 3A uses a half-bridge structure, and so on.

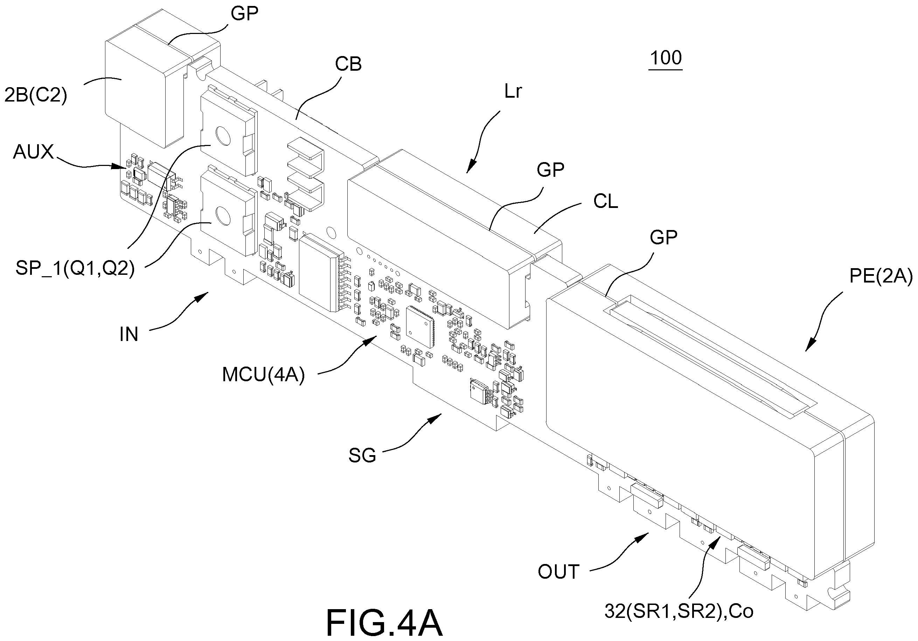

Please refer to FIG. 4A, which shows a perspective circuit structure assembled diagram of the resonant converter according to the first embodiment of the present disclosure. FIG. 4A mainly shows a circuit diagram of the resonant converter 100 (for example, the circuit diagrams of FIG. 3A to FIG. 3C) converted into a physical structure of a single circuit board CB so that the single circuit board CB has the function of converting the DC power source Pdc into the output power source Po. In terms of physical structure, the resonant converter 100 includes a circuit board CB, a primary-side circuit 1A, a secondary-side circuit 3A, and a planar transformer PE as a transformer 2A. The circuit board CB includes a plurality of sub-layer boards, and an input terminal IN and an output terminal OUT are formed at the edge of the circuit board CB. The input terminal IN receives a DC power source Pdc and the output terminal OUT provides an output power source Po. The input terminal IN and the output terminal OUT are formed at the edge of the circuit board CB, and the circuit board CB may be plugged into any device that needs power conversion, such as power supply unit, uninterruptible power supply, etc., and vertical plugging can save device space.

The primary-side circuit 1A is disposed on the circuit board CB, and the circuit components of the primary-side circuit 1A that can be clearly seen on the circuit board CB include power switches Q1, Q2 of the primary-side switch bridge arm SP_1 and an inductor core CL used for forming a resonant inductor Lr. The secondary-side circuit 3A is disposed on the circuit board CB, and the circuit components of the secondary-side circuit 3A that can be clearly seen on the circuit board CB include a first switch SR1 and a second switch SR2 of the rectifier circuit 32 and an output capacitor Co. The planar transformer PE is electrically connected to the primary-side circuit 1A and the secondary-side circuit 3A, and the planar transformer PE includes an iron core C1 for forming the planar transformer PE. In particular, the resonant inductor Lr and the planar transformer PE are arranged on the circuit board CB using a structure that can be planarized so that the original winding transformer/inductor with a larger volume is replaced to reduce the volume occupied by the resonant converter 100. The circuit board CB further includes a system control circuit MCU (including a controller 4A for controlling the resonant converter 100), and the system control circuit MCU can communicate with external devices through the signal transmission terminal SG.

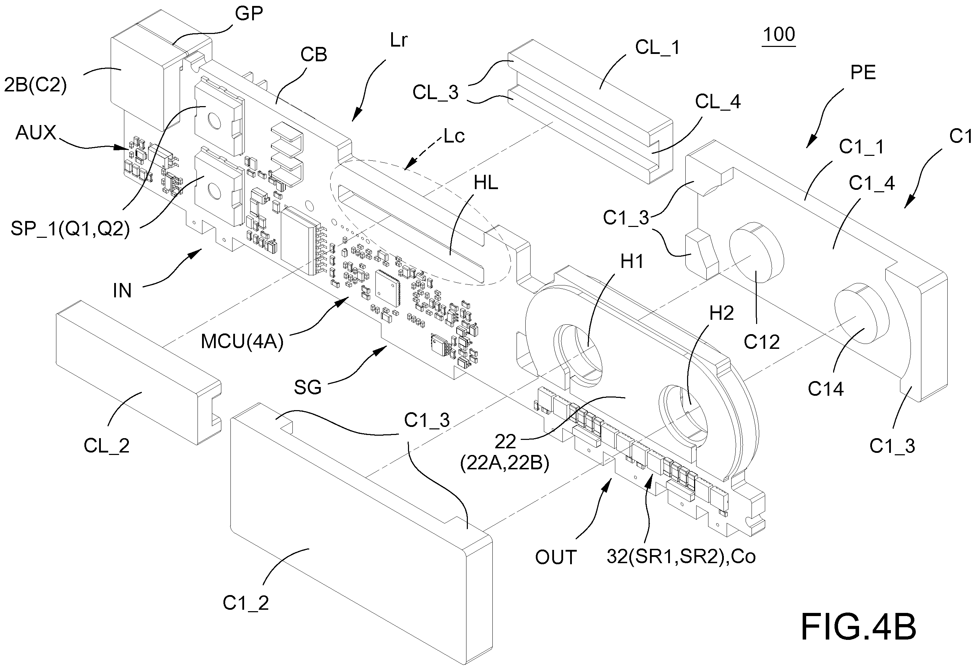

Please refer to FIG. 4B, which shows a perspective circuit structure exploded diagram of the resonant converter according to the first embodiment of the present disclosure, and also refer to FIG. 4A. FIG. 4B mainly decomposes the inductor core CL of the resonant inductor Lr and the iron core C1 of the transformer 2A. The planar transformer PE further includes a first through hole H1, a second through hole H2, a primary-side winding 22A, and a secondary-side winding 22B. The first through hole H1 and the second through hole H2 respectively penetrate the circuit board CB, and the primary-side winding 22A and the secondary-side winding 22B surround the first through hole H1 and the second through hole H2. That is, the primary-side winding 22A and the secondary-side winding 22B are formed on the sub-layer board of the circuit board CB in a wiring structure and surround the first through hole H1 and the second through hole H2, and the primary-side winding 22A and the secondary-side winding 22B are sleeved by the iron core C1 to form the planar transformer PE.

In one embodiment, the iron core C1 may be an EI-type, EE-type, ER-type core, etc. The iron core C1 includes two covers C1_1, C1_2, and at least one of the two covers C1_1, C1_2 forms a first core column C12 and a second core column C14. The two covers C1_1, C1_2 further include a main body and a plurality of side portions C1_3 respectively, and the side portions C1_3 of the two covers C1_1, C1_2 are correspondingly protruded from edges of the main body. An accommodation groove C1_4 is formed between the side portions C1_3 of the two covers C1_1, C1_2 and the first core column C12 and the second core column C14, and the accommodation groove C1_4 is used to accommodate the winding 22 of the transformer 2A. In one embodiment, the winding 22 may be a primary-side winding 22A and a secondary-side winding 22B, and in other embodiments, for example, the winding 22 may be at least one of the primary-side winding 22A and the secondary-side winding 22B as shown in FIG. 3A to FIG. 3C.

The planar transformer PE is covered by two covers C1_1, C1_2 so that the first core column C12 and the second core column C14 respectively penetrate the first through hole H1 and the second through hole H2 of the circuit board CB, and part of the side portions C1_3 of the two covers C1_1, C1_2 are located outside the circuit board CB. In one embodiment, the side portion C1_3 located at the outer side of the circuit board CB can form an air gap GP, and the air gap GP is formed on the outer side of the circuit board CB. Therefore, the size of the air gap GP can be easily adjusted to adjust the magnetic resistance of the planar transformer PE to avoid magnetic saturation when the circuit is in operation. In one embodiment, the iron core C1 includes two iron core columns C12, C14 that penetrate through two holes H1, H2 of the circuit board CB. In other embodiments, for example, the circuit board CB may include only a through hole H1, and the winding 22 surrounds the through hole H1, and an iron core column C12 of the iron core C1 penetrates through the through hole H1 to form the planar transformer PE.

Please refer to FIG. 4A and FIG. 4B, the resonant converter 100 further an inductor through hole HL and an inductor winding Lc, and the inductor through hole HL penetrates the circuit board CB. The inductor winding Lc is electrically connected to the winding 22 and surrounds the inductor through hole HL. The inductor winding Lc is formed on the sub-layer boards of the circuit board CB in a wiring structure so that the inductor winding Lc is sleeved by the inductor core CL to form the resonant inductor Lr. In one embodiment, the inductor core CL may be an UI-type, UU-type core, etc. The inductor core CL includes two covers CL_1, CL_2. The two covers CL_1, CL_2 include a main body, and at least one of the two covers CL_1, CL_2 includes two side portions CL_3. The two portions CL_3 are protruded from edges of the main body, and one of the two side portions CL_3 penetrates through the inductor through hole HL. An accommodation space CL_4 is formed between the side portions CL_3 of the two covers CL_1, CL_2, and the accommodation space CL_4 is used to accommodate a portion of the inductor winding Lc of the resonant inductor Lr. A portion of the side portions CL_3 of the two covers CL_1, CL_2 are located outside the circuit board CB, and in one embodiment, the side portions CL_3 located outside the circuit board CB can form an air gap GP, which functions like the air gap GP of the iron core C1.

In one embodiment, the circuit board CB of FIG. 4A and FIG. 4B further includes an auxiliary power circuit AUX, and the auxiliary power circuit AUX is electrically connected to the input terminal IN to receive a DC power source Pdc. The auxiliary power circuit AUX may be an isolated conversion circuit (for example, a flyback conversion circuit) and includes a transformer 2B. The transformer 2B is similar to the transformer 2A, and the wiring may be set on the circuit board CB and the transformer 2B may be formed by sleeving the iron core C2. The iron core C2 may also correspond to the iron core C1 and form an air gap GP at the side portion, and its function is the same as the air gap GP of the iron core C1. In one embodiment, a controller (not shown) of the auxiliary power circuit AUX may also be optionally integrated into the system control circuit MCU, which is not limited herein. Therefore, the single circuit board CB shown in FIG. 4A and FIG. 4B may include the auxiliary power circuit AUX, the system control circuit MCU, and the resonant converter 100, and save a lot of wiring space and at least save the space SE in FIG. 2.

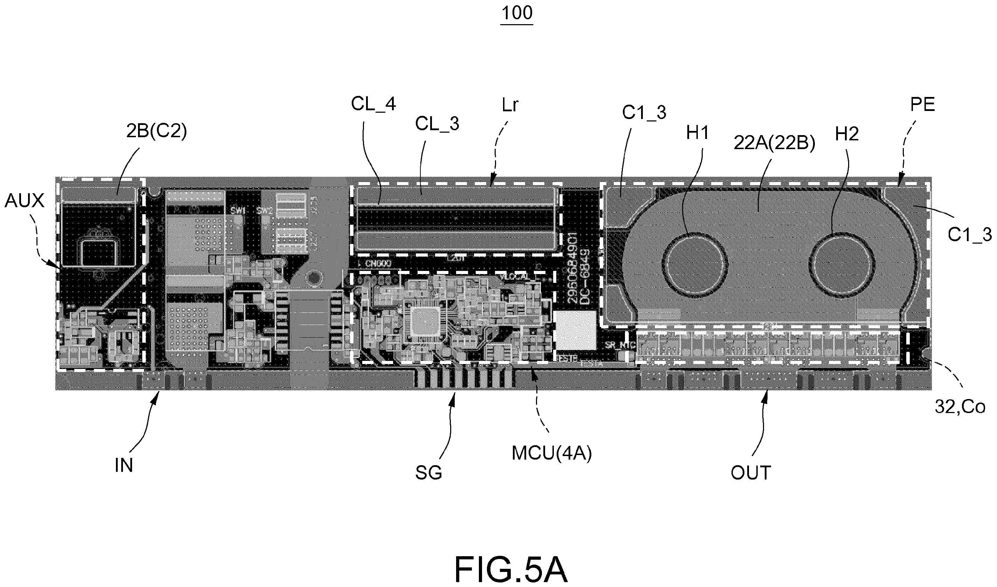

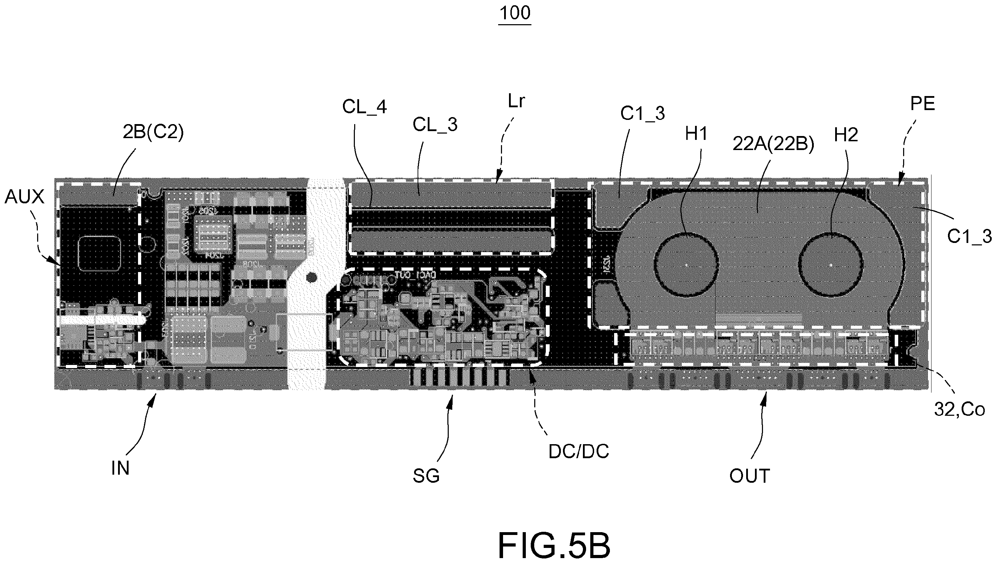

Please refer to FIG. 5A, which shows a wiring structure diagram of one surface layer of a circuit board according to a first embodiment of the present disclosure; please refer to FIG. 5B, which shows a wiring structure diagram of another surface layer of the circuit board according to the first embodiment of the present disclosure. The DC power source Pdc enters from the input terminal IN and passes through the primary-side switch bridge arm SP_1 and the resonant inductor Lr to the planar transformer PE. The DC power source Pdc is also provided to the auxiliary power circuit AUX so that the auxiliary power circuit AUX converts the DC power source Pdc into the auxiliary power source Paux. The planar transformer PE provides energy to the rectifier circuit 32 and the output capacitor Co through the coupling of the primary-side winding 22A and the secondary-side winding 22B, and finally provides the output power source Po to the load 300 through the output terminal OUT. According to the above path, the circuit board CB takes the path of large current (referred to as the power path) as described above, from the input terminal IN to the output terminal OUT, which is an n-type path, and the system control circuit MCU and its peripheral control and compensation circuits are located in the center of the n-type path and separated from the power path. The signal transmission terminal SG is directly electrically connected to the system control circuit MCU. The system control circuit MCU is short in distance from the power switches Q1, Q2, the first switch SR1 and the second switch SR2, and is less likely to pass through the power path and be separated from the power path. Therefore, the noise in the power path is less likely to interfere with the signal transmission of the system control circuit MCU, thereby reducing the path loss on the transmission path.

In FIG. 5B, the other side opposite to the position of the control circuit MCU includes a DC conversion circuit DC/DC, which is mainly composed of a number of small step-down converters (for example, buck). The main reason for configuring a plurality of step-down (buck) converters is that the auxiliary power source Paux converted by the auxiliary power circuit AUX is a single voltage (for example but not limited to, 12V). However, some controllers, drivers, etc. on the circuit board CB require different power sources (such as but not limited to, 5V, 3.3V, 1.8V, etc.), and therefore several small step-down converters of the DC conversion circuit DC/DC are used. The converter performs power conversion, that is, converting the appropriate voltage to supply power to these components for normal operation. The power switches Q1, Q2 of the primary-side switch bridge arm SP_1 are, for example but not limited to, transistors made of GaN materials, and the power switches Q1, Q2 are arranged with the shortest path. The secondary-side winding 22B, the first switch SR1, and the second switch SR2 are also arranged with the shortest path to facilitate the layout of the output terminal OUT. On the other hand, the wiring distance of the secondary-side winding 22B, the first switch SR1, the second switch SR2, and the output capacitor Co is closely related to their AC impedance, and therefore the closer the first switch SR1, the second switch SR2, and the output capacitor Co are to the secondary-side winding 22B, the smaller the AC impedance and the better the efficiency.

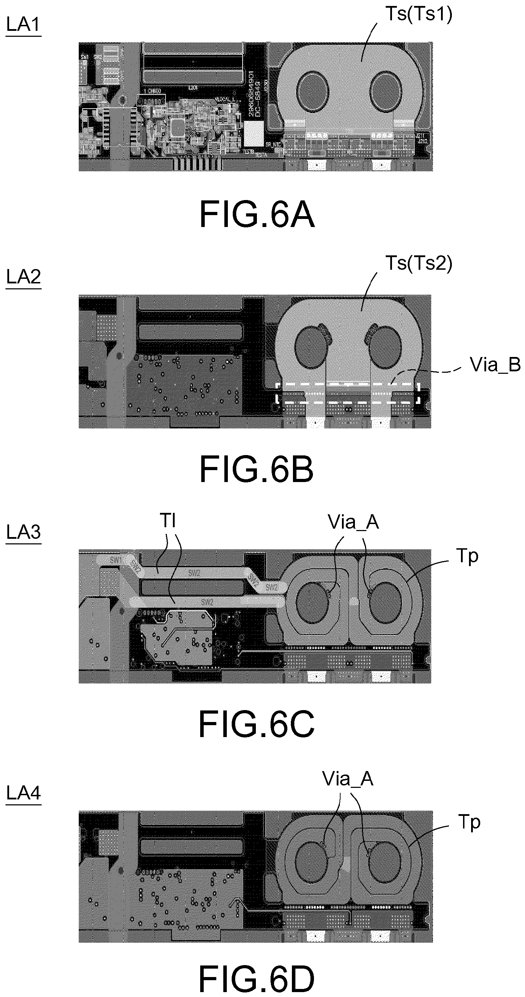

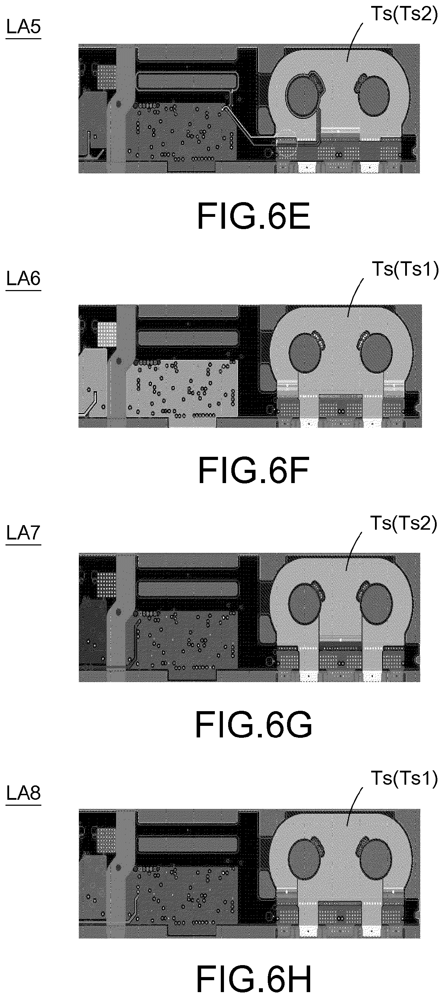

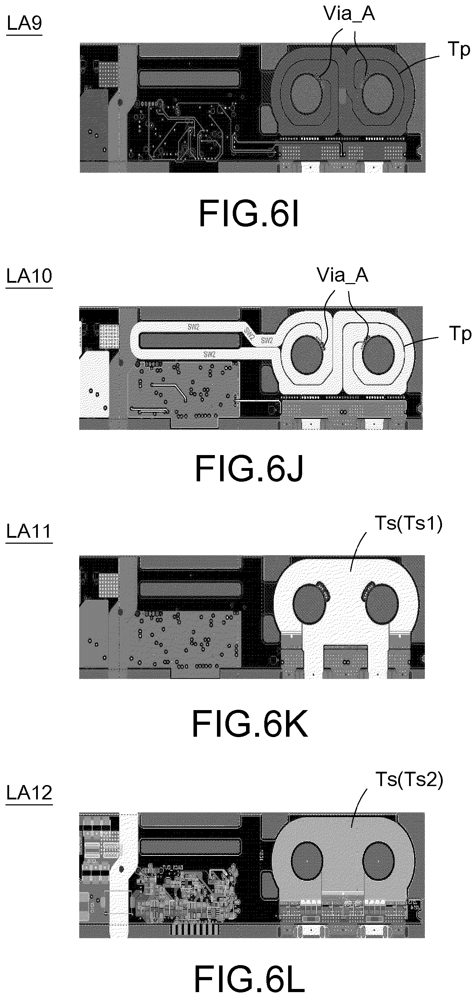

Please refer to FIG. 6A to FIG. 6L, which show schematic diagrams of wiring the windings of the planar transformer on each sub-layer board of the circuit board according to a first embodiment of the present disclosure. In one embodiment, the circuit board CB takes 12-layer sub-layer boards LA1 to LA12 as an example, and the sub-layer boards LA1 to LA12 are sequentially from a top layer board to a bottom layer board. In other embodiments, the number of layers of the circuit board CB may be increased or decreased according to actual circuit requirements. Please refer to FIG. 3A to FIG. 3C, in the wiring of the sub-layer boards LA1 to LA12, the inductor wiring T1 serves as the inductor winding Lc of the resonant inductor Lr, and the primary-side wiring Tp serves as the primary-side winding 22A of the transformer 2A. The secondary-side wiring Ts serves as the secondary-side winding 22B of the transformer 2A, and the secondary-side wiring Ts includes a first secondary-side wiring Ts1 and a second secondary-side wiring Ts2. The first secondary-side wiring Ts1 serves as the first winding 22B-1, and the second secondary-side wiring Ts2 serves as the second winding 22B-2.

In one embodiment, the copper foil of the primary-side wiring Tp and the copper foil of the inductor wiring Tl are integrally formed to form a common-wiring structure, and the primary-side wiring Tp and the secondary-side wiring Ts are located on different sub-layer boards LA1 to LA12 so that when the current flows through the sub-layer boards LA1 to LA12, the current can be evenly distributed. In other embodiments, the inductor wiring T1, the primary-side wiring Tp, and the secondary-side wiring Ts may be located on the same sub-layer boards LA1 to LA12 according to actual circuit requirements. The primary-side wiring Tp and the secondary-side wiring Ts are formed and surround the first through hole H1 and the second through hole H2 respectively so that the iron core C1 is sleeved behind the primary-side wiring Tp and the secondary-side wiring Ts, and a closed magnetic circuit may be formed to constitute the transformer 2A. The inductor wiring T1 is formed and surrounds the inductor through hole HL so that after the inductor core CL is sleeved on the inductor wiring T1, a closed magnetic circuit may be formed to constitute the resonant inductor Lr.

In FIG. 6C to FIG. 6D and FIG. 6I to FIG. 6J, the primary-side wiring Tp respectively surrounds the first through hole H1 and the second through hole H2 for more than one circle (depending on the turns ratio of the transformer 2A) in different directions to form an ∞-shaped wiring. A plurality of vias Via_A are formed on one side of the first through hole H1 and the second through hole H2. The vias Via_A are located at the end of the primary-side wiring Tp, and the vias Via_A are filled with a conductive material (such as but not limited to, a conductive material such as solder paste) so that the primary-side wiring Tp of each sub-layer board LA3-LA4, LA9-LA10 may be electrically connected through the vias Via_A to form the primary-side winding 22A.

In FIG. 6A to FIG. 6B, FIG. 6E to FIG. 6H, and FIG. 6K to FIG. 6L, the secondary-side wiring Ts and the first through hole H1 and the second through hole H2 form an m-shaped wiring. Due to Ampere's right-hand rule, the direction of the current determines the direction of the magnetic field. Therefore, the current direction of the primary-side wiring Tp and the secondary-side wiring Ts formed and surround around the first through hole H1 is the same (for example, clockwise). The current direction of the primary-side wiring Tp and the secondary-side wiring Ts formed and surround around the second through hole H2 is opposite to that of the first through hole H1 (for example, counterclockwise). The secondary-side wiring Ts may include a plurality of vias Via_B near the output terminal OUT, and the vias Via_B are filled with conductive material so that the secondary-side wiring Ts of each sub-layer board LA1-LA2, LA5-LA8, LA11-LA12 may be electrically connected through the vias Via_B to form the secondary-side winding 22B.

In FIG. 6C and FIG. 6J, the inductor wiring T1 is formed and surrounds the inductor through hole HL. In one embodiment, the copper foil of the inductor wiring T1 and the primary-side wiring Tp is an integrally formed structure, and a portion of the integrally formed copper foil belongs to the inductor wiring T1, and the other portion belongs to the primary-side wiring Tp. In other embodiments, the inductor wiring T1 and the primary-side wiring Tp may be separately arranged, for example, other circuit components such as a resonant capacitor Cr may be included between the two. In one embodiment, the primary-side wiring Tp of the inductor wiring Tl and the secondary-side wiring Ts are not limited to be stacked in the order of FIG. 6A to FIG. 6L. The first and second sub-layer boards described below are not in a stacking order, but only represent a sub-layer board LA1 and another sub-layer board LA12 in the circuit board CB.

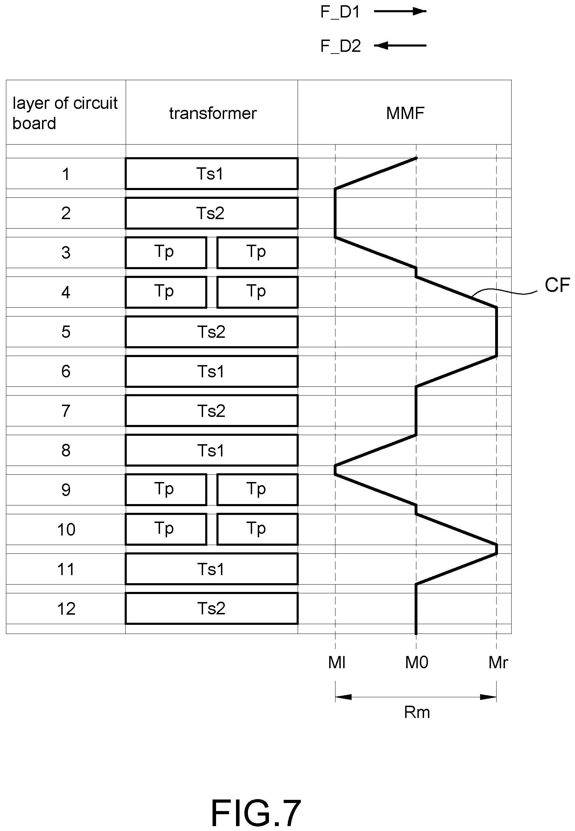

Please refer to FIG. 7, which shows a schematic diagram of a wiring stacking structure of the planar transformer of FIG. 6A to FIG. 6L on each sub-layer board of the circuit board according to a first embodiment, and a magnetomotive force curve when using the planar transformer for the first secondary-side wirings in operation. The left side of FIG. 7 shows the wiring stacking structure diagrams of FIG. 6A to FIG. 6L in order from top to bottom, and the right side of FIG. 7 shows the magnetomotive-force curve CF formed by the wiring stacking structure corresponding to the left side of FIG. 7. In one embodiment, a cube represents a circle of wiring (for example, the first secondary-side wiring Ts1, the second secondary-side wiring Ts2) formed by the sub-layer boards LA1 to LA12 with the through holes H1, H2 as the center), and the two cubes represent two circles of wiring (for example, the primary-side wiring Tp) formed by the sub-layer boards LA1 to LA12 with the through holes H1, H2 as the center. The spacing between each wiring may be regarded as the thickness between each sub-layer board LA1-LA12. The horizontal axis of the magnetomotive-force graph is magnetomotive force (MMF), and the vertical axis is position. The origin of the vertical axis is the magnetic flux origin M0, and the left and right of the magnetic flux origin M0 respectively include a first predetermined offset Ml and a second predetermined offset Mr.

In one embodiment, the first predetermined offset Ml and the second predetermined offset Mr are ideal predetermined offsets acquired after the parameters of the transformer 2A are calculated. Furthermore, when the transformer 2A actually operates, the actual offset may not be completely equal to the first predetermined offset Ml and the second predetermined offset Mr, but it may still be within an error range between the first predetermined offset Ml and the second predetermined offset Mr. The formation of the primary-side wiring Tp enables the primary-side wiring Tp to generate a first direction magnetic flux F_D1 when the primary-side circuit 1A operates. The formation of the first secondary-side wiring Ts1 enables the first secondary-side wiring Ts1 to generate a second direction magnetic flux F_D2 opposite to the first direction magnetic flux F_D1 when the first switch SR1 of the secondary-side circuit 3A operates.

When the primary-side wiring Tp generates the first direction magnetic flux F_D1, resulting in magnetic flux deviation, the second direction magnetic flux F_D2 generated by the first secondary-side wiring Ts1 will deviate the magnetomotive force MMF in the opposite direction so as to maintain the first direction magnetic flux F_D1 and the second direction magnetic flux F_D2 within a specific range Rm formed by the magnetic flux origin M0 and the first predetermined offset Ml and the second predetermined offset Mr. Therefore, the magnetomotive-force curve CF of the planar transformer 2A is maintained within the specific range Rm so that the magnetomotive force MMF is kept balanced.

In the center tap structure of the first winding 22B-1, since only the first switch SR1 or the second switch SR2 works in the same half cycle, when the first switch SR1 is turned on and the second switch SR2 is not turned on, the second winding 22B-2 and the rectifier switch SR2 do not form a current path so that the magnetomotive force MMF of the second secondary-side wiring Ts2 does not deviate toward the first predetermined offset Ml or the second predetermined offset Mr. According to the above logic, the magnetomotive-force curve CF can be inferred when the first switch SR1 is not turned on and the second switch SR2 is turned on, which will not be described in detail here.

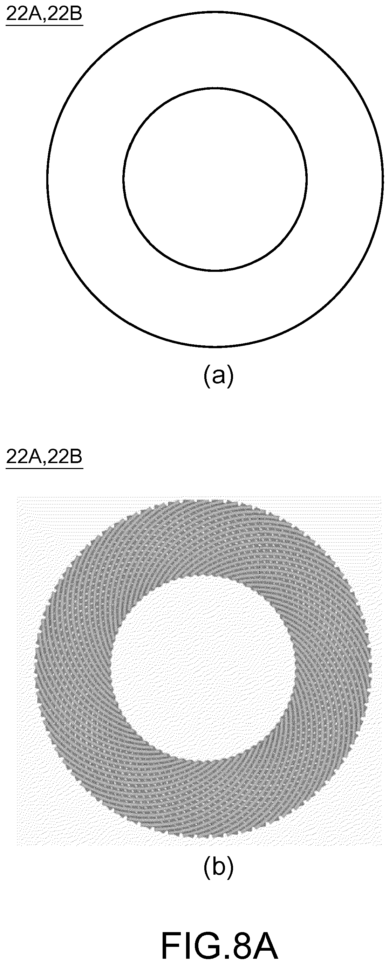

Please refer to FIG. 8A, which shows a diagram of a winding arrangement of a ring-shaped transformer according to the present disclosure. In the sub-diagram (a) of FIG. 8A, the winding 22 of the transformer 2A is arranged in a ring-shaped space and is copper-plated in a whole sheet, and its structure may be similar to that of FIG. 6A to FIG. 6L, and the primary-side wiring Tp and the secondary-side wiring Ts of each sub-layer board LA1-LA12 are laid with an integrally formed copper foil in the extending direction of the wirings. In one embodiment, if not specifically indicated, the winding 22 may be a primary-side winding 22A and/or a secondary-side winding 22B. Since the copper foil is extended in an integrally formed manner, the winding 22 in the sub-diagram (a) has a lower DC resistance. In the sub-diagram (b) of FIG. 8A, the winding 22 (for example, the primary-side winding 22A or the secondary-side winding 22B) of each sub-layer board LA1-LA12 forms a plurality of parallel wiring structures in the same direction, and the wiring between layers (for example, the primary-side wiring Tp or the secondary-side wiring Ts) is arranged in an overlapping and interleaving manner. The structure of multiple parallel wirings in the same direction is similar to the structure of Litz wire (commonly known as stranded wire), and it mainly uses multiple insulated wires to be twisted together. The characteristic is that the wiring structure of the sub-diagram (b) of FIG. 8A can effectively reduce the AC impedance, and especially when the resonant converter 100 is used in high-frequency switching, the AC impedance can be greatly reduced.

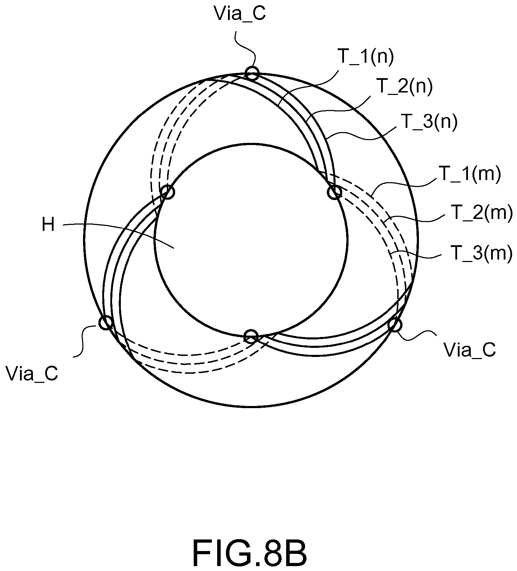

Please refer to FIG. 8B, which shows a perspective view of a wiring interleaving winding of the first embodiment and the second embodiment of the ring-shaped transformer according to the present disclosure. FIG. 8B is a schematic diagram of two sub-layer boards LA1, LA2, and a plurality of vias Via_C are included around the periphery of the wiring area where the winding 22 is disposed. The vias Via_C are used to electrically connect the first sub-layer board LA1 and the second sub-layer board LA2, and the wirings T_1 to T_3 are formed and surround the through hole H. Taking the wiring T_1 as an example, and (n) and (m) represent sub-layer boards LA1, LA2 of different layers, respectively. The wiring T_1 (n) of the first sub-layer board LA1 extends from the periphery of the wiring area where the winding 22 is arranged to the vias Via_C around the through hole H, and is electrically connected to the second sub-layer board LA2 through the vias Via_C. The wiring T_1(m) of the second sub-layer board LA2 extends from the vias Via_C to the vias Via_C at the periphery of the wiring area where the winding 22 is arranged, and is electrically connected to the first sub-layer board LA1 through the vias Via_C. Through the vias Via_C, the wirings T_1 to T_3 may be interleaved to extend to the first sub-layer board LA1 and the second sub-layer board LA2. When the entire wiring area is full, the wirings T_1 to T_3 on the same layer are arranged in parallel, and the wirings T_1(n) to T_3(n) on the first sub-layer board LA1 may be arranged in an overlapping and interleaving manner with the wirings T_1(m) to T_3(m) on the second sub-layer board LA2.

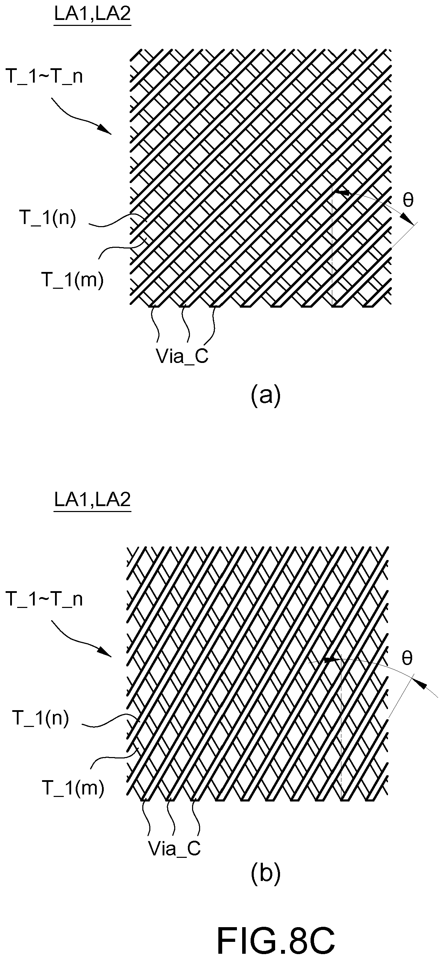

Please refer to FIG. 8C, which shows a comparison diagram of the wiring with different angles according to the present disclosure. In the embodiment of FIG. 8C, the plurality of wirings T_1 to T_n are arranged in an overlapping and interleaving manner. Taking the wiring T_1 as an example, the wiring T_1(n) of the first sub-layer board LA1 and the wiring T_1(m) of the second sub-layer board LA2 form an acute angle (angle θ is less than 90 degrees) with the via Via_C as the center. The angle θ refers to the angle between the wiring T_1(n) of the first sub-layer board LA1 and the wiring T_1(m) of the second sub-layer board LA2. In the sub-diagram (a) of FIG. 8C, the angle θ between the wiring T_1(n) and the wiring T_1(m) is 45 degrees, and in the sub-diagram (b) of FIG. 8C, the angle θ between the wiring T_1(n) and the wiring T_1(m) is 30 degrees.

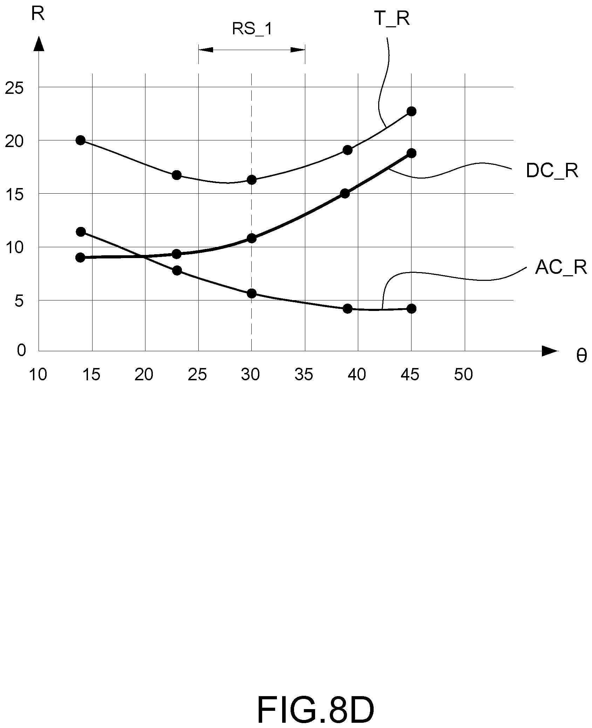

Please refer to FIG. 8D, which shows an impedance curve diagram of the wiring with different angles according to the present disclosure. In the sub-diagram (a) of FIG. 8C, when the angle θ between the wiring T_1(n) and the wiring T_1(m) is 45 degrees, the measured DC impedance DC_R is 20M ohms and the AC impedance AC_R is 5.4M ohms, and the converted total impedance T_R is approximately 23.5M ohms. In the sub-diagram (b) of FIG. 8C, when the angle θ between the wiring T_1(n) and the wiring T_1(m) is 30 degrees, the measured DC impedance DC_R is 14.2M ohms and the AC impedance AC_R is 8.8M ohms, and the converted total impedance T_R is approximately 16.5M ohms. Therefore, when the angle θ of the wiring T_1(n) and the wiring T_1(m) is 30 degrees, the total impedance T_R is lower. When the angle θ is within the range RS_1 between 25 degrees and 30 degrees, the AC impedance AC_R is not too high, and the total impedance T_R is located at a lower position in the curve, which is a preferred implementation.

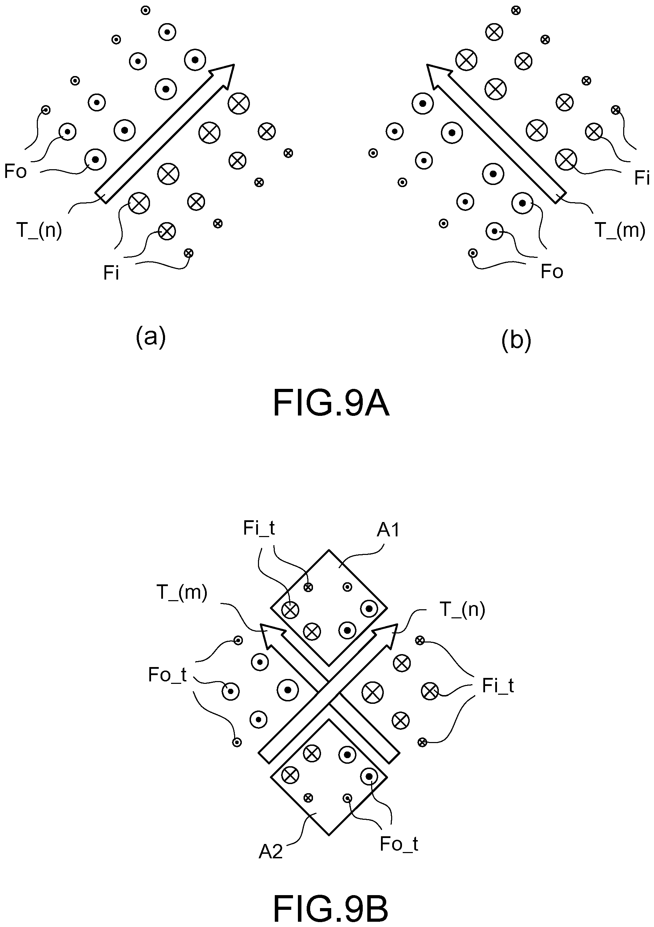

Please refer to FIG. 9A, which shows a diagram of the magnetic flux distribution of the wiring according to the present disclosure. In the sub-diagram (a) of FIG. 9A, the arrow direction indicates the extension direction of the wiring T_(n) of the first sub-layer board LA1, and when the current flows in the direction of the arrow, one-in and one-out magnetic fluxes Fi, Fo are generated on both sides of the arrows (in this embodiment, i and o represent the in and out directions, respectively). In the sub-diagram (b) of FIG. 9A, the arrow direction indicates the extension direction of the wiring T_(m) of the second sub-layer board LA2, and when the current flows in the direction of the arrow, one-in and one-out magnetic fluxes Fi, Fo are generated on both sides of the arrows. Since the extension directions of sub-diagram (a) and sub-diagram (b) are interleaved, the directions of the magnetic fluxes Fi, Fo are exactly opposite.

Please refer to FIG. 9B, which shows a schematic diagram of the magnetic flux cancellation of a wiring interleaving layout of a first embodiment according to the present disclosure. When the first sub-layer board LA1 and the second sub-layer board LA2 are stacked together, the magnetic fluxes Fi, Fo of the two layers will overlap to generate total magnetic fluxes Fi_t, Fo_t. The total magnetic fluxes Fi_t, Fo_t in areas A1, A2 are offset by the opposite directions of the magnetic fluxes Fi, Fo in the sub-diagram (a) and sub-diagram (b), thereby making the total magnetic fluxes Fi_t, Fo_t in areas A1, A2 are smaller (indicated by smaller circles). In the other two areas, the opposite happens, making the total magnetic fluxes Fi_t, Fo_t larger (indicated by larger circles).

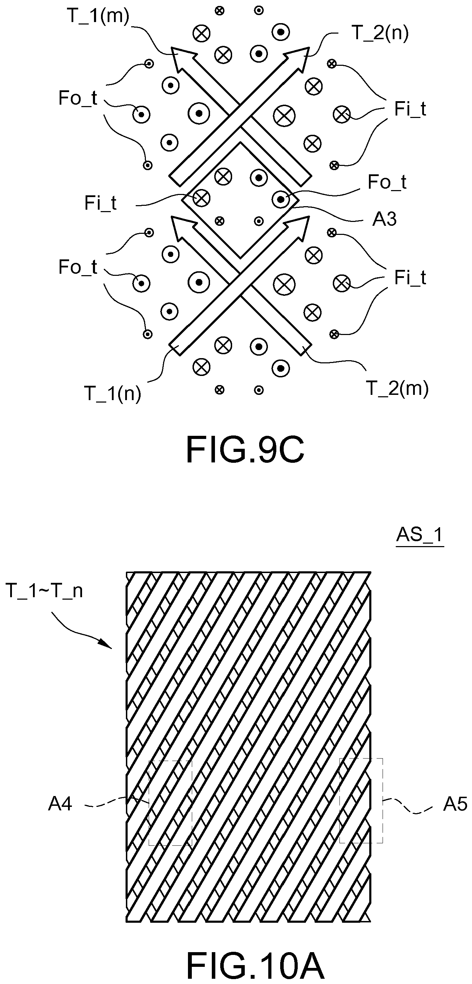

Please refer to FIG. 9C, which shows a schematic diagram of the magnetic flux cancellation of a wiring interleaving layout of a second embodiment according to the present disclosure. FIG. 9C mainly puts the structure of FIG. 9B together, and the wirings T_1(n), T_2(m) are set on different sub-layer boards LA1, LA2, and the wirings T_1(m), T_2(n) are also set on different sub-layer boards LA1, LA2. The wirings T_1(n), T_2(m) and the wirings T_1(m), T_2(n) are arranged in parallel and connected to different sub-layer boards LA1, LA2 through vias (not shown) to form an area A3. The area A3 may be mainly considered as the overlap of the total magnetic fluxes Fi_t, Fo_t of the two areas A1, A2 in FIG. 9B, and the total magnetic fluxes Fi_t, Fo_t are offset by their positive and negative directions, making the total magnetic fluxes Fi_t, Fo_t smaller in the area A3, and the total magnetic fluxes Fi_t, Fo_t larger in the remaining areas due to the stacking structure of magnetic fluxes.

Please refer to FIG. 10A, which shows a perspective view of a wiring pattern formed in a wiring area according to the present disclosure. FIG. 10A also shows two layers of sub-layer boards LA1, LA2, and a plurality of vias (not shown) are formed around the periphery of the wiring area AS_1 where the wirings T_1 to T_n are arranged to electrically connect the first sub-layer board LA1 and the second sub-layer board LA2. The principle of FIG. 10A is similar to that of FIG. 9C, and mainly utilizes the interleaving wiring structure to achieve the effect of magnetic flux cancellation, and expands its application range to the entire wiring area AS_1.

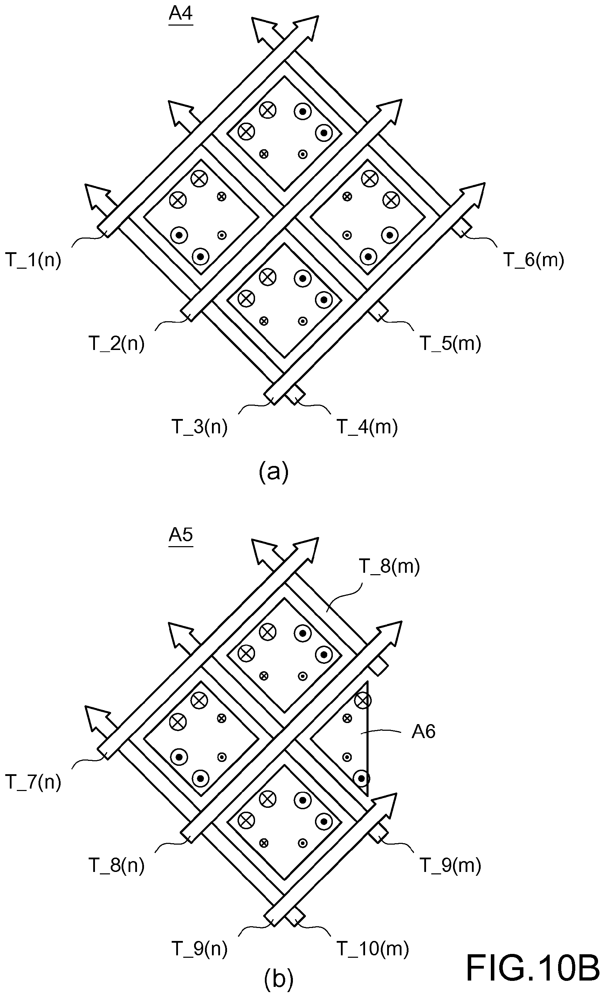

Please refer to FIG. 10B, which shows a schematic diagram of the magnetic flux cancellation after enlarging areas A4, A5 of FIG. 10A according to the present disclosure. The sub-diagram (a) of FIG. 10B mainly shows the wiring structure of an area A4 of FIG. 10A, and the wiring on the first sub-layer board LA1 is in sequence from T_1(n) to T_3(n), and the wiring on the second sub-layer board LA2 is in sequence from T_4(m) to T_6(m). Since the area A4 has the same structure as that in FIG. 9B, the entire area A4 is the same as the areas A1, A2 in FIG. 9B, and has the effect of magnetic flux cancellation. The sub-diagram (b) of FIG. 10B mainly shows the wiring structure of an area A5 of FIG. 10A, and the wiring on the first sub-layer board LA1 is in sequence from T_7(n) to T_9(n). The wiring on the second sub-layer board LA2 is in sequence from T_8(m) to T_10(m), and the wiring T_9(m) is an extension of the wiring T_9(n) through a via in on the same path. Since the area around area A5 except area A6 has the same structure as that of FIG. 9B, the rest of area A5 except area A6 is the same as areas A1, A2 of FIG. 9B, and also has the effect of magnetic flux cancellation. FIG. 10B and referring to FIG. 10A, except for the periphery of the wiring area AS_1 which is the same as the structure of the area A6 and does not have the effect of magnetic flux cancellation, the rest of the wiring area AS_1 has the effect of magnetic flux cancellation so as to reduce core losses and copper wire losses.

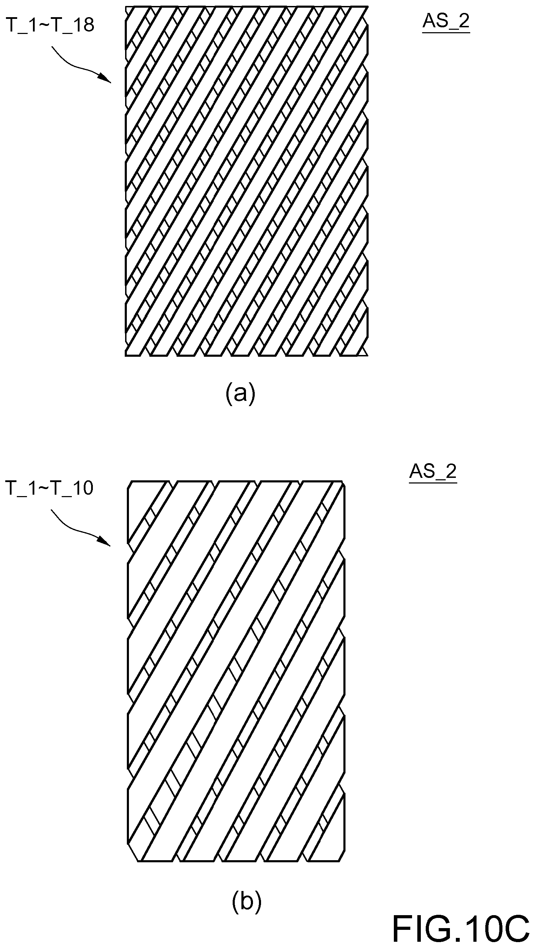

Please refer to FIG. 10C, which shows a comparison diagram of the wiring with different widths in the same wiring area according to the present disclosure. In the embodiment of FIG. 10C, a plurality of wirings T_1 to T_18 are arranged in an overlapping and interleaving manner within the same wiring area AS_2. In the sub-diagram (a) of FIG. 10C, the wirings T_1 to T_10 are relatively wider and 10 wirings T_1 to T_10 are formed in the wiring area AS_2, and in the sub-diagram (b) of FIG. 10C, the wirings T_1 to T_18 are relatively narrower and 18 wirings T_1 to T_18 are formed in the wiring area AS_2. When the wirings T_1 to T_10 are wider, the DC impedance is lower but the AC impedance is higher, and when the wirings T_1 to T_18 are narrower, the opposite is true. Therefore, the width adjustment of the wirings T_1 to T_18 will affect the number of wirings T_1 to T_8, and the AC impedance and the DC impedance can be adjusted at the same time. Another factor that affects the AC impedance is the distance between the wirings T_1 to T_18. When the distance between the wirings T_1 to T_18 is closer, the AC impedance is lower, and vice versa. Therefore, in the wiring area AS_2, adjusting the distance and width of the wirings T_1 to T_18 can effectively reduce the AC impedance, and if the AC impedance is allowed, the DC impedance can be improved by increasing the width of the wirings T_1 to T_18.

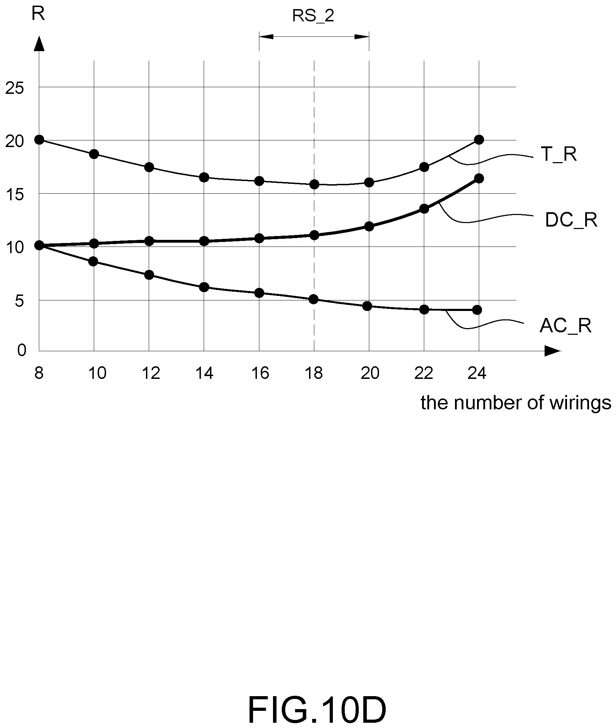

Please refer to FIG. 10D, which shows an impedance curve diagram of the wiring with different widths in the same wiring area according to the present disclosure. In the sub-diagram (a) of FIG. 10C, there are 10 wirings T_1 to T_10 which are wider than those in the sub-diagram (b) of FIG. 10C, and the distance between wirings T_1 to T_18 is relatively far. Therefore, the measured AC impedance AC_R and DC impedance DC_R are 9.4M ohms and 10M ohms respectively, and the converted total impedance T_R is approximately 18M ohms. In the sub-diagram (b) of FIG. 10C, there are 18 wirings T_1 to T_18 which are narrower than those in the sub-diagram (a) of FIG. 10C, and the distance between wirings T_1 to T_18 is relatively closer. Therefore, the measured AC impedance AC_R and DC impedance DC_R are 6.8M ohms and 11M ohms respectively, and the converted total impedance T_R is approximately 16M ohms. Therefore, in the same wiring area AS_2, when the number of wirings T_1 to T_18 falls within the range RS_2 of 16 to 18, the AC impedance AC_R is not too high, and the total impedance T_R is at a lower position in the curve, which is a preferred implementation.

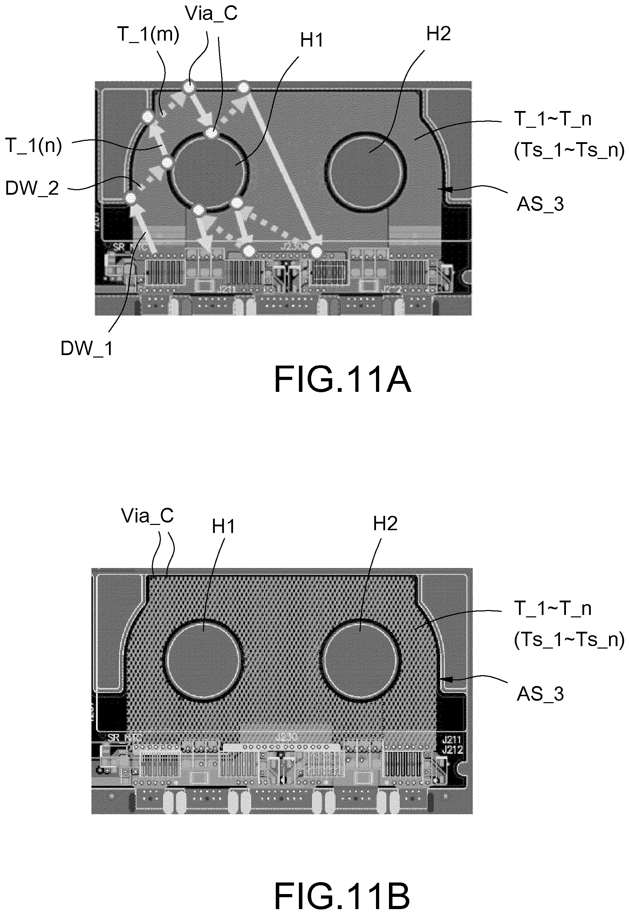

Please refer to FIG. 11A, which shows a schematic diagram of a wiring arrangement of the planar transformer according to the present disclosure. In the embodiment of FIG. 11A, the winding 22 of the planar transformer PE is mainly configured by applying the techniques of FIG. 8A to FIG. 10D. The planar transformer PE includes a plurality of vias Via_C for electrically connecting the first sub-layer board LA1 and the second sub-layer board LA2, and the vias Via_C are formed at the periphery of the wiring area AS_3 and the peripheries of the through holes H1, H2. The planar transformer PE further includes a plurality of wirings T_1 to T_n, and the wirings T_1 to T_n are formed in the wiring area AS_3.

In the embodiment of FIG. 11A, the solid arrow is the extension direction DW _1 of the wiring T_1(n) of the first sub-layer board LA1, and the dotted arrow is the extension direction DW _2 of the wiring T_1(m) of the second sub-layer board LA2, and directions DW_1, DW_2 are connected head to tail. In order to briefly and clearly illustrate the configuration of the winding 22, only a single wire T_1 (n), T_1 (m) is shown for illustration. At the head end of the arrow, the wiring T_1(n) of the first sub-layer board LA1 extends from the extension direction DW_1 of the arrow to the via Via_C at the periphery of the wiring area AS_3, and extends to the second sub-layer board LA2 through the via Via_C, and then extends from the extension direction DW_2 to the via Via_C at the periphery of the first through hole H1, and to be repeatedly interleaved to extend on the first sub-layer board LA1 and the second sub-layer board LA2 until the tail end of the arrow. Please refer to FIG. 11B, which shows a perspective plan view of a wiring structure of the planar transformer according to the present disclosure. The wirings T_2 to T_n are arranged in parallel with the wiring T_1, and the entire wiring area AS_3 is full to form a winding 22 composed of a plurality of wirings T_1 to T_n. In one embodiment, since the vias Via_C are formed at the periphery of the wiring area AS_3 and the peripheries of the through holes H1, H2, the castellation technology of the circuit board CB can be used for implementation.

In one embodiment, the angle θ between the two terminals of the via Via_C may be adjusted in conjunction with FIG. 8A to FIG. 8D, and the width of the wirings T_1 to T_n and the distance between the wirings T_1 to T_n may be adjusted by referring to FIG. 10A to FIG. 10D. In one embodiment, the sub-layer boards LA1, LA2 are the layers for setting the secondary-side winding 22B, and therefore the wirings T_1 to T_n are a plurality of secondary-side wirings Ts_1 to Ts_n for electrically connecting the secondary-side winding 22B of the secondary-side circuit 3A. Also referring to FIG. 6A to FIG. 6B, FIG. 6E to FIG. 6H, and FIG. 6K to 6L, the interleaving secondary-side wirings Ts_1 to Ts_n in FIG. 11B can replace the first secondary-side wiring Ts1 or the second secondary-side wiring Ts2, and apply the technology of FIG. 8A to FIG. 10D to set the angle θ and wire width and wire spacing. The primary-side wiring Tp of FIG. 6C to FIG. 6D and FIG. 6I to FIG. 6J may be set by applying or not applying the wiring interleaving technology of FIG. 8A to FIG. 10D and FIG. 11A to FIG. 11B, which can be determined according to the size of the AC impedance AC_R and the uniformity of magnetic flux.

In other embodiments, the primary-side wirings Tp of FIG. 6C to FIG. 6D and FIG. 6I to FIG. 6J may also be set by applying the wiring interleaving layout technology (not shown) of the wirings T_1 to T_n shown in FIG. 11B, and apply the techniques of FIG. 8A to FIG. 10D to set the angle θ, wire width, and wire spacing. The first secondary-side wiring Ts1 or the second secondary-side wiring Ts2 of FIG. 6A to FIG. 6B, FIG. 6E to FIG. 6H, and FIG. 6K to FIG. 6L may be optionally applied or not applied to the wiring interleaving layout technology of FIG. 8A to FIG. 10D and FIG. 11A to FIG. 11B, which can be determined according to the size of the AC impedance AC_R and the uniformity of magnetic flux. In another embodiment, the inductor wiring T1 of FIG. 6C and FIG. 6J may also optionally apply the wiring interleaving technology (not shown) of the wirings T_1 to T_n shown in FIG. 11B, and apply the techniques of FIG. 8A to FIG. 10D to set the angle θ, wire width, and wire spacing.

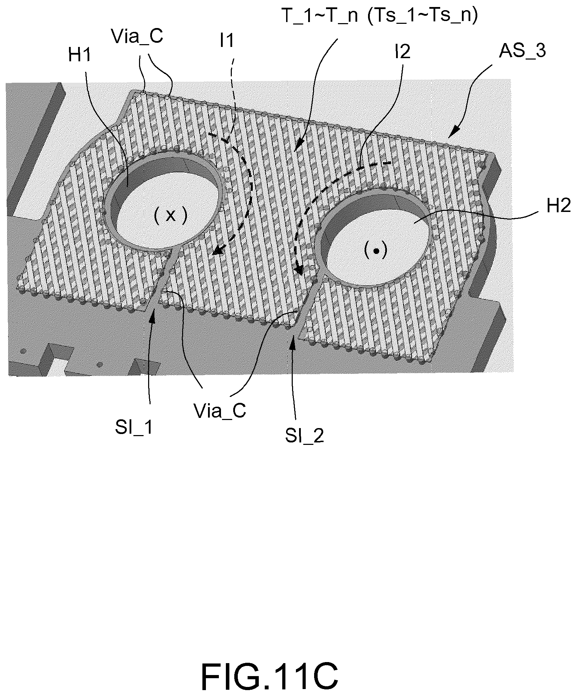

Please refer to FIG. 11C, which shows a perspective view of the wiring structure of the planar transformer according to the present disclosure. The sub-layer boards LA1, LA2 of the planar transformer PE for setting the secondary-side wiring Ts also include insulating sections SI_1, SI_2 extending from the through holes H1, H2 to the periphery of the wiring area AS_3. The insulating sections SI_1, SI_2 prevent the wirings Ts_1 to Ts_n from extending from the extension directions DW _1, DW_2 to surround the through holes H1, H2 and then electrically connect to the wirings Ts_1 to Ts_n at the arrow heads, thereby causing the winding 22 is short-circuited when currents I1, I2 flow through. The peripheries of the insulating sections SI_1, SI_2 also include a plurality of vias Via_C, and the vias Via_C are used to allow the wirings Ts_1 to Ts_n to be interleaved to extend on the first sub-layer board LA1 and the second sub-layer board LA2. The size of the wiring area AS_3 is mainly determined by the accommodation groove C1_4 for accommodating the winding 22 of the transformer 2A. When the accommodation groove C1_4 is larger, the wiring area AS_3 may be larger, and vice versa. Since the iron core C1 is located at the side portion C1_3 of the outer side of the circuit board CB, an air gap GP may be formed, and therefore at least one side of the wiring area AS_3 may be formed on the outer side of the circuit board CB in coordination with the iron core C1.

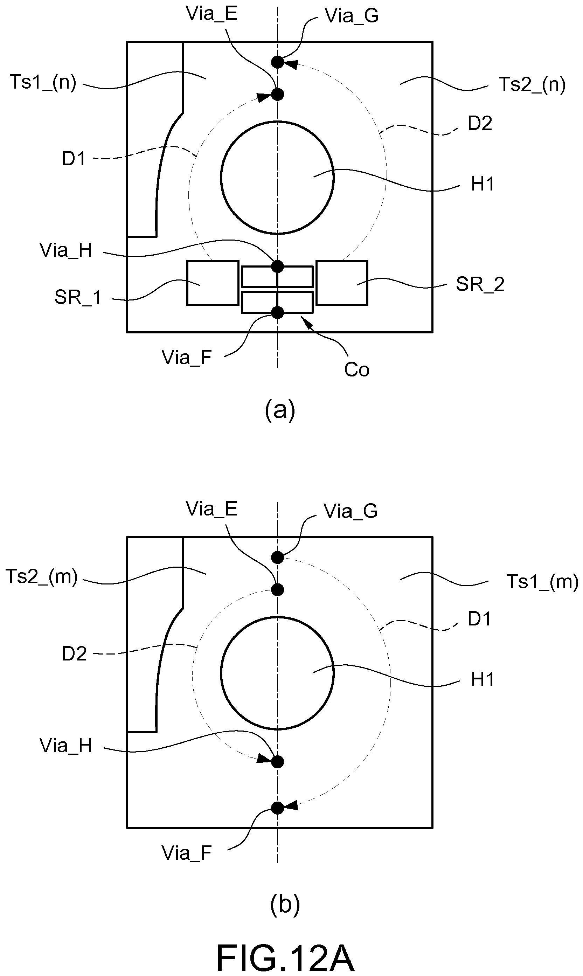

Please refer to FIG. 12A, which shows a schematic diagram of the extension of secondary-side wirings using wiring interleaving winding according to a first embodiment of the present disclosure. In the embodiment of FIG. 12A, the first secondary-side wiring Ts1_(n) of the first winding 22B-1 extends away from the first switch SR1 to the first secondary-side wiring Ts1_(m) of another layer, and the second secondary-side wirings Ts2_(n), Ts2_(m) of the second winding 22B-2 is also the same. The difference is that the laying direction of the second secondary-side wirings Ts2_(n), Ts2_(m) is opposite to that of the first secondary-side wirings Ts1_(n), Ts1_(m), forming an interleaving winding. In one embodiment, the planar transformer PE includes a first via Via_E, a second via Via_F, a third via Via_G, and a fourth via Via_H. The first via Via_E and the second via Via_F are respectively formed on a first side of the first through hole H1 and a second side opposite to the first side, and the first via Via_E and the second via Via_F are used to electrically connect the first sub-layer board LA1 and the second sub-layer board LA2 of the circuit board CB.

The third via Via_G and the fourth via Via_H are respectively formed on the first side and the second side of the first through hole H1, and the third via Via_G and the fourth via Via_H are used to electrically connect the first sub-layer board LA1 and the second sub-layer board LA2 of the circuit board CB. In one embodiment, the second side is a side close to the output terminal OUT, the first side is located at the other side of the first through hole H1, and the first switch SR1, the second switch SR2, and the output capacitor Co are disposed on the second side.

As shown in the sub-diagram (a) of FIG. 12A, the first secondary-side wiring Ts1_(n) may be located on the first sub-layer board LA1 and electrically connected to the first switch SR1. The first secondary-side wiring Ts1_(n) extends from the first sub-layer board LA1 in the first direction D1 around the first through hole H1 to the first via Via_E, and extends to the second sub-layer board LA2 through the first via Via_E. As shown in the sub-diagram (b) of FIG. 12A, the first secondary-side wiring Ts1_(m) extending to the second sub-layer board LA2 continues in the first direction D1 and extends to the second side to electrically connect the output capacitor Co through the second via Via_F.

The second secondary-side wiring Ts2_(n) may be located on the first sub-layer board LA1 and electrically connected to the second switch SR2. The second secondary-side wiring Ts2_(n) extends from the first sub-layer board LA1 in the second direction D2 around the first through hole H1 to the third via Via_G, and extends to the second sub-layer board LA2 through the third via Via_G. The second secondary-side wiring Ts2_(m) extending to the second sub-layer board LA2 continues in the second direction D2 and extends to the second side and electrically connected to the output capacitor Co through the fourth via Via_H. As shown in the sub-diagram (a) and the sub-diagram (b) of FIG. 12A, the first switch SR1 and the second switch SR2 are respectively disposed on two different sides of the second via Via_F (the fourth via Via_H), and the first direction D1 and the second direction D2 are in opposite directions along the first through hole H1 to form a ring-shaped interleaving wiring structure.

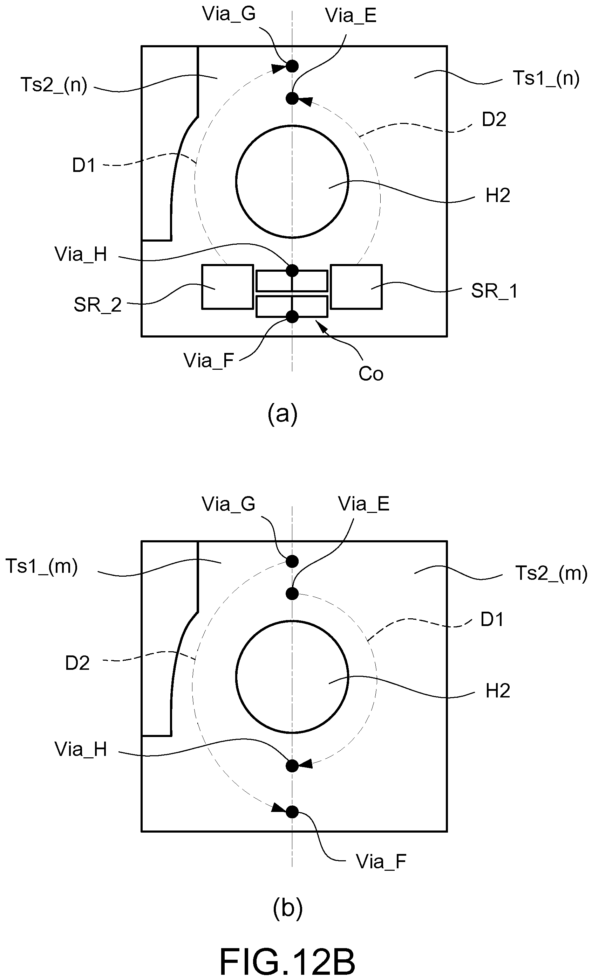

Please refer to FIG. 12B, which shows a schematic diagram of the extension of secondary-side wirings using wiring interleaving winding according to a second embodiment of the present disclosure. In the embodiment of FIG. 12B, the first via Via_E and the second via Via_F are respectively formed on the third side of the second through hole H2 and the fourth side opposite to the third side, and the first via Via_E and the second via Via_F are used to electrically connect the first sub-layer board LA1 and the second sub-layer board LA2 of the circuit board CB. The third side and the first side of FIG. 12A may be the same side, and the fourth side and the second side may be the same side. The only difference is that the positions of the first through hole H1 and the second through hole H2 are different.

As shown in the sub-diagram (a) and the sub-diagram (b) of FIG. 12B, the first secondary-side wiring Ts1_(n) extends from the first sub-layer board LA1 in the second direction D2 around the second through hole H2 to the first via Via_E, and extends to the second sub-layer board LA2 through the first via Via_E. The first secondary-side wiring Ts1_(m) extending to the second sub-layer board LA2 continues in the second direction D2 and extends to the fourth side and electrically connected to the output capacitor Co through the second via Via_F.

The second secondary-side wiring Ts2_(n) extends from the first sub-layer board LA1 in the first direction D1 around the second through hole H2 to the third via Via_G, and extends to the second sub-layer board LA2 through the third via Via_G. The second secondary-side wiring Ts2_(m) extending to the second sub-layer board LA2 continues in the first direction D1 and extends to the fourth side and electrically connected to the output capacitor Co through the fourth via Via_H. Another difference between FIG. 12B and FIG. 12A is that the first secondary-side wirings Ts1_(n), Ts1_(m) and the second secondary-side wirings Ts2_(n), Ts2_(m) are located in (left and right) opposite directions and extend in opposite directions.

By using the ring-shaped interleaving wiring structure shown in FIG. 12B and FIG. 12A, the current paths of the first secondary-side wirings Ts1_(n), Ts1_(m) and the second secondary-side wiring Ts2_(n), Ts2_(m) may be exactly opposite in direction, and the current paths are circular and can form the shortest current path. Therefore, the effect of magnetic flux cancellation can be achieved, and the AC impedance AC_R of the secondary-side circuit 3A can be reduced, thereby increasing the efficiency of the resonant converter 100.

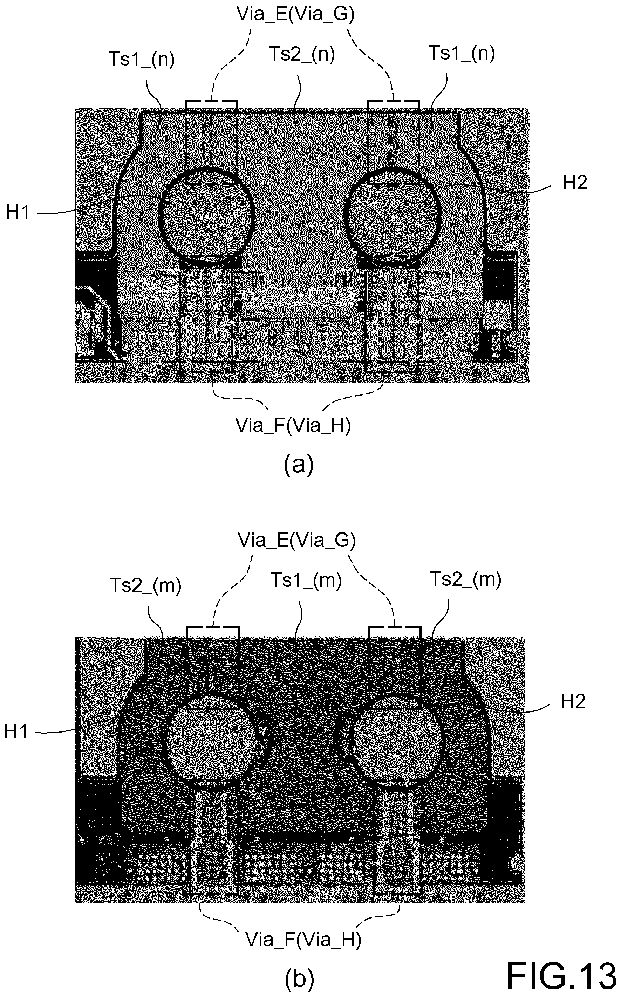

Please refer to FIG. 13, which shows a structural diagram of the arrangement of secondary-side wirings using wiring interleaving winding according to the present disclosure. In FIG. 6A to FIG. 6B, FIG. 6E to FIG. 6H, and FIG. 6K to FIG. 6L, since the secondary-side wiring Ts and the first through hole H1 and the second through hole H2 form an m-shaped wiring, the interleaving wiring extension manners of FIG. 12B and FIG. 12A can be integrated together to form the secondary-side wiring Ts of FIG. 13. As shown in the sub-diagram (a) of FIG. 13, when the two sides of the m-shaped wiring are the first secondary-side wirings Ts1_(n), the two groups of second secondary-side wirings Ts2_(n) in the first direction D1 and the second direction D2 in FIG. 12A and FIG. 12B may be sandwiched between the first secondary-side wirings Ts1_(n). Since the two groups of second secondary-side wirings Ts2_(n) in FIG. 12A and FIG. 12B have the same properties, they may be integrated into an integrally formed configuration. As shown in the sub-diagram (b) of FIG. 13, when the two sides of the m-shaped wiring are the second secondary-side wirings Ts2_(n), the two groups of first secondary-side wirings Ts1_(n) in the first direction D1 and the second direction D2 in FIG. 12A and FIG. 12B may be sandwiched between the second secondary-side wirings Ts2_(n), and therefore the two groups of first secondary-side wirings Ts1_(n) in FIG. 12A and FIG. 12B may be integrated into an integrally formed configuration.

In one embodiment, the wiring interleaving layout structure in FIG. 11A to FIG. 11C may be combined with the wiring interleaving winding structure in FIG. 12A to FIG. 13 for application. The wiring interleaving layout structure is at least applied to one of the primary-side wiring Tp and the secondary-side wiring Ts, and therefore at least two sub-layer boards, such as LA1, LA2, are required. The wiring interleaving winding structure is applied to the secondary-side wiring Ts, and therefore at least two sub-layer boards, such as LA3, LA4, are required. Therefore, if the two are used together, the wiring interleaving layout structure and the wiring interleaving winding structure need to use four layers of sub-layer boards LA1, LA2, LA3, LA4, and an additional layer is set for the other of the primary-side wiring Tp and the secondary-side wiring Ts, which is not applied to the wiring interleaving layout structure and the wiring interleaving winding structure, such as LA5.

It is assumed that the wiring interleaving layout structure is applied to the first secondary-side wiring Ts1 and the second secondary-side wiring Ts2, and the wiring interleaving winding structure is also applied to the first secondary-side wiring Ts1 and the second secondary-side wiring Ts2. The first secondary-side wiring Ts1 may be interleaved to extend to the sub-layer boards LA1, LA2, and when the first secondary-side wiring Ts1_(n) extends from the first sub-layer board LA1 to the first via Via_E, the first secondary-side wiring Ts1_(n) extends from the first via Via_E to the third sub-layer board LA3 and continues to be interleaved to extend to the second side in the first direction D1. When the first secondary-side wiring Ts1_(m) extends from the second sub-layer board LA2 to the first via Via_E, the first secondary-side wiring Ts1_(m) extends from the first via Via_E to the fourth sub-layer board LA4 and continues to be interleaved to extend to the second side in the first direction D1.

When the second secondary-side wiring Ts2_(n) extends from the first sub-layer board LA1 to the third via Via_G, the second secondary-side wiring Ts2_(n) extends from the third via Via_G to the third sub-layer board LA3 and continues to be interleaved to extend to the second side in the second direction D2. When the second secondary-side wiring Ts2_(m) extends from the second sub-layer board LA2 to the third via Via_G, the second secondary-side wiring Ts2_(m) extends from the third via Via_G to the fourth sub-layer board LA4 and continues to be interleaved to extend to the second side in the second direction D2.

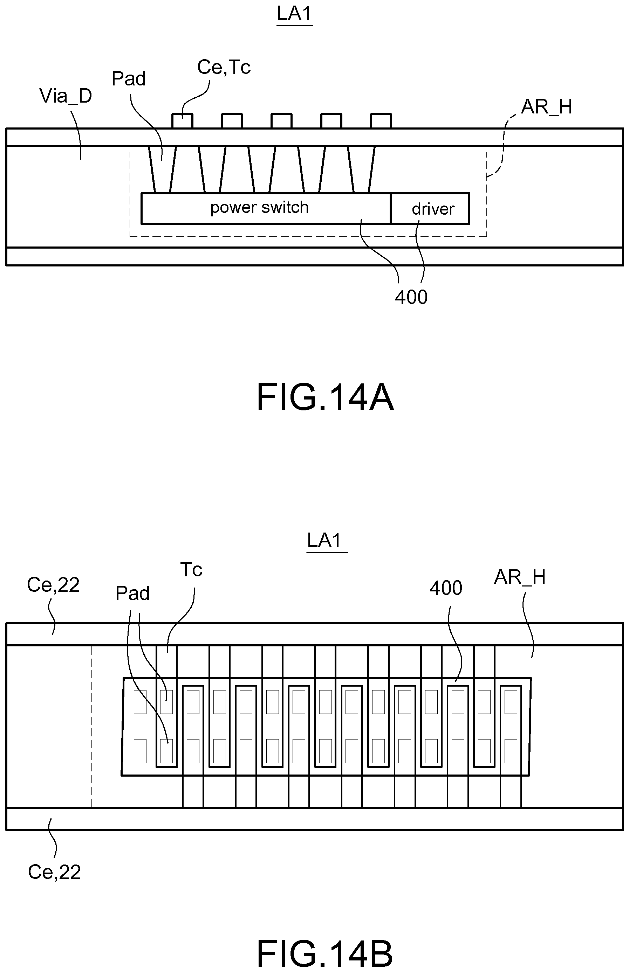

Please refer to FIG. 14A, which shows a cross-sectional view of the circuit board for power components of the resonant converter using an embedding technology according to the present disclosure. In one embodiment, the power components 400 (for example, the power switches Q1, Q2, first switch SR1, second switch SR2, output capacitor Co (non-electrolytic capacitor), and driver for turning on switches Q1, Q2, SR1, SR2) on the power path (refer to FIG. 3A) of the resonant converter 100 can be embedded in any sub-layer board LA1 to LA12 (shown as the sub-layer board LA1) in the circuit board CB using the embedding technology. The main purpose and effect of using the embedding technology is to reduce the AC impedance AC_R of the resonant converter 100 as much as possible to increase the circuit efficiency. The embedding technology mainly involves hollowing out the resin carrier board in the circuit board CB and then embedding power components 400 such as the power switches and driver into the hollowed-out area AR_H. Afterward, copper is melted into the pre-formed via Via_D on the circuit board CB to generate contact pads Pad on the surface layer so that the power components 400 can be electrically connected to electronic components Ce (e.g., components such as capacitor, resistor, and switch), any wiring T_1(n), T_1(m), T_2(n), T_2(m) of the winding 22, and electrical wirings Tc for electrically connecting the electronic components Ce through the via Via_D and the contact pads Pad. Please refer to FIG. 14B, which shows a top view of the circuit board for power components of the resonant converter using an embedding technology according to the present disclosure. The electronic components Ce (e.g., capacitor, resistor, and switch) or the electrical wirings Tc can be electrically connected to the power components 400 by soldering to the contact pads Pad. The reason for using this technology is that once the power components 400 are buried in the hollow-out area AR_H, the electronic components Ce or the electrical wirings Tc can be connected to the power components 400 with the shortest distance possible so as to reduce the AC impedance AC_R of the connection path as much as possible.

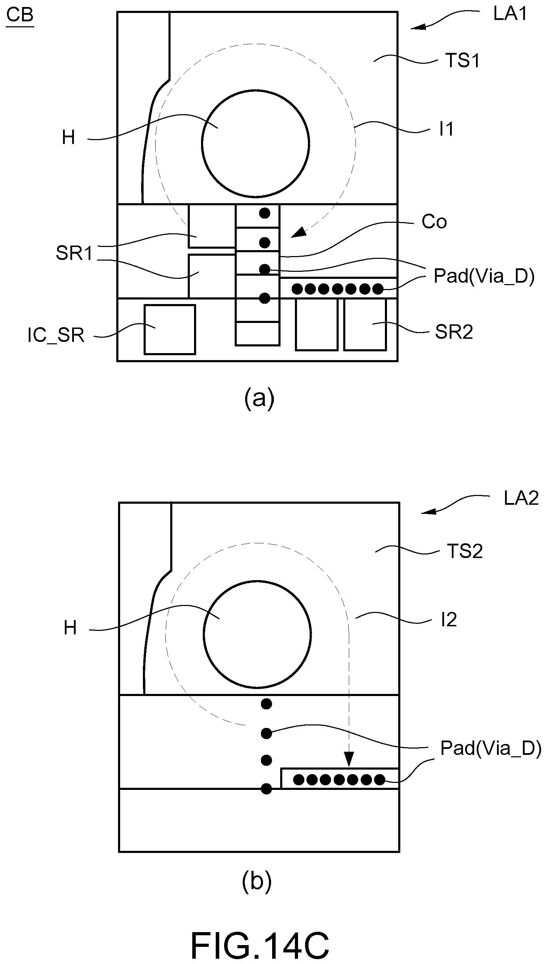

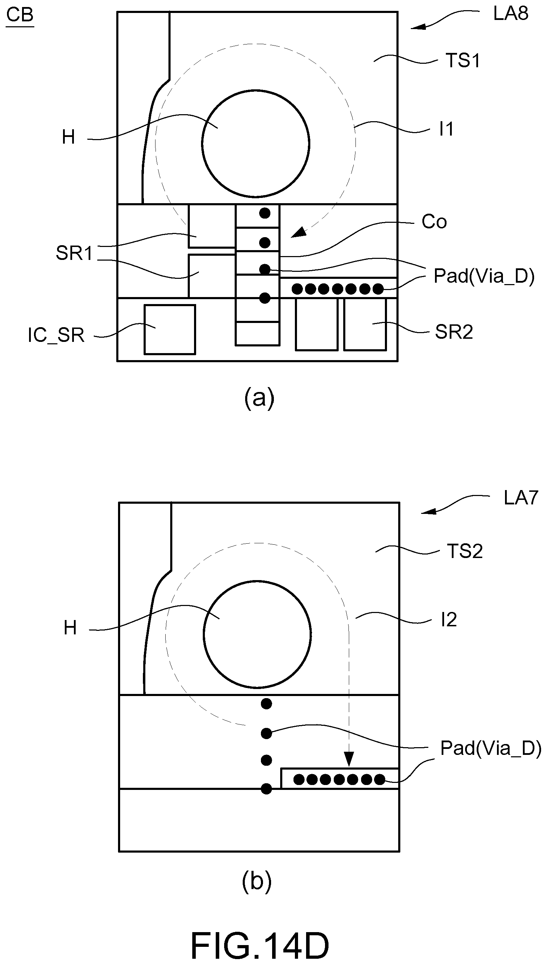

Please refer to FIG. 14C and FIG. 14D, which show circuit configuration diagrams of power components on the secondary side of the resonant converter using the embedding technology according to the present disclosure respectively. In the embodiment of FIG. 14C and FIG. 14D, the power component 400 (e.g., the first switch SR1, the second switch SR2, the controller IC_SR for controlling the first switch SR1 and the second switch SR2, and the output capacitor Co, etc., and the output capacitor Co is electrically connected to the first switch SR1 and the second switch SR2 to form the secondary-side circuit 3A) may be embedded in any sub-layer board of the circuit board CB (for example, embedded in the surface boards LA1, LA12 of the circuit board CB) by using the embedding technology shown in FIG. 14A and FIG. 14B. Afterward, copper is melted into the pre-formed via Via_D to generate contact pads Pad on the surface of the sub-layer boards LA1, LA12 so that the circuit board CB has only contact pads at the positions of the power component 400. Furthermore, the power component 400 (the first switch SR1, the second switch SR2, and the output capacitor Co) may be electrically connected to the secondary-side wiring 22B through the corresponding plural vias Via_D. In one embodiment, the secondary-side power component 400 is disposed on one side of the through hole H (referring to FIG. 11A to FIG. 11C, the through hole H may be the first through hole H1 or the second through hole H2), and the first switch SR1 and the second switch SR2 are respectively arranged on the two sides of the output capacitor Co, the first secondary-side wiring Ts1 is arranged on the sub-layer boards LA1, LA12, and the second secondary-side wiring Ts2 is arranged on the sub-layer boards LA2, LA11.

Since the power component 400 is embedded in the circuit board CB, they will not be affected by the first secondary-side wiring Ts1 or other electronic components Ce and controller IC_SR on the surface of the circuit board CB and will not be forced to adjust to a connection distance that is not the shortest distance. When the current I1 flows through the first switch SR1 and the first secondary-side wiring Ts1 to the output capacitor Co, a shorter current path may be formed (the same is true for the current I2). Since the power component 400 is disposed on the sub-layer boards LA1, LA12, the second secondary-side wiring Ts2 of the sub-layer boards LA2, LA11 can be electrically connected to the power component 400 through the contact pads Pad.

Please refer to FIG. 14C and FIG. 14D, the embedding technology may also be applied to the primary side of the resonant converter 100, and also refer to FIG. 3A to FIG. 3C. The primary-side circuit 1A includes a primary-side switch bridge arm SP_1, and the primary-side switch bridge arm SP_1 includes a first power switch Q1 and a second power switch Q2. The first power switch Q1 and the second power switch Q2 may be embedded in any sub-layer board of the circuit board CB by the embedding technology described in FIG. 14C and FIG. 14D, and the first power switch Q1 and the second power switch Q2 are electrically connected to the primary-side winding 22A through a plurality of corresponding vias Via_D.

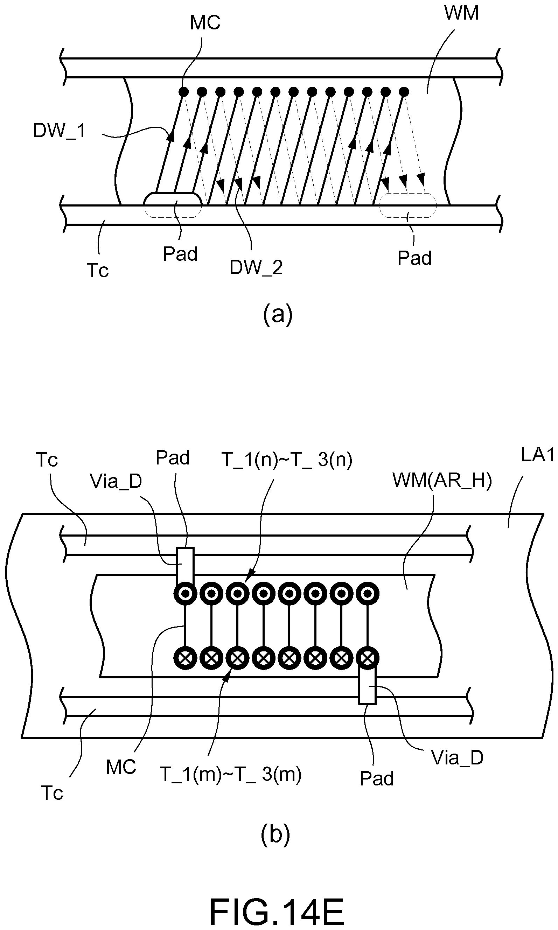

Please refer to FIG. 14E, which shows a top view and a cross-sectional view of the circuit board using the embedding technology for wiring the planar transformer according to a first embodiment of the present disclosure. In addition to the power component 400, the inductor winding Lc of the resonant inductor Lr and the winding 22 of the planar transformer PE may also be embedded in any sub-layer board LA1 to LA12 of the circuit board CB by using the embedding technology (the sub-layer board LA1 is used as an example). The embedding technology of the resonant inductor Lr and the planar transformer PE is mainly to use the structure of the modular winding WM for the inductor winding Lc and the winding 22 (i.e., the modular winding WM includes the inductor wiring T1 for forming the inductor winding Lc, or modular winding WM includes a primary-side wiring Tp or a secondary-side wiring Ts for forming the winding 22). Similarly, after the resin carrier in the circuit board CB is hollowed out, the modular inductor winding Lc and the winding 22 (i.e., the modular winding WM) are buried in the hollowed-out area AR_H. Afterward, copper is melted into the pre-formed via Via_D on the circuit board CB to form contact pads Pad on the surface layer so that the primary-side circuit 1A or the secondary-side circuit 3A can be electrically connected to the modular winding WM through the via Via_D. In one embodiment, the modular winding WM may be formed by, for example, using a non-conductive material such as resin to form a wiring layer structure of the entire inductor winding Lc or the winding 22 so that the wiring layer structure may be embedded in the hollowed-out area AR_H of the circuit board CB by using the embedding technology.

In FIG. 14E, and taking the wirings T_1(n), T_1(m) of FIG. 11A to form a modular winding WM as an example, and it is assumed that the wirings T_1(n), T_1(m) are embedded in the first sub-layer board LA1. The sub-diagram (a) of FIG. 14E shows a top view of the wirings T_1(n), T_1(m), and the sub-diagram (b) of FIG. 14D shows a cross-sectional view of the wirings T_1(n), T_1(m). The wirings T_1(n) to T_3(n) of the first layer (upper layer) of the modular winding WM are arranged in the same extension direction DW_1 and electrically connected to the wrings T_1(n) to T_3(n) of the second layer (lower layer) through the conductive material MC (for example, copper, aluminum, etc., preferably a columnar structure). The wirings T_1(m) to T_3(m) of the lower layer are also arranged in the same extension direction DW_2 so that the wirings T_1 to T_3 interleavingly extend on the first layer and the second layer through the conductive material MC. In one embodiment, the wirings T_1 to T_3 are similar to those shown in FIG. 8D, and the wirings T_1 to T_3 on different layers form an acute angle with the conductive material as the center, and the angle of the acute angle is preferably between 25 degrees and 30 degrees. Referring to FIG. 14E, when the embedding technology is applied to the inductor winding Lc and the winding 22 of the resonant converter 100, the modular inductor winding Lc and the winding 22 (i.e., the modular winding WM) may also be formed in the via Via_D of the circuit board CB to generate contact pads Pad on the surface. The modular inductor winding Lc may be electrically connected to the primary-side circuit 1A through the vias Via_D, and the modular winding 22 may be electrically connected to the primary-side circuit 1A or the secondary-side circuit 3A through the vias Via_D.

The first layer and the second layer are similar to the relationship between the sub-layer boards LA1, LA2 in FIG. 11C (i.e., the first layer and the second layer are stacked together), but the first layer and the second layer do not refer to the first sub-layer board LA1 and the second sub-layer board LA2. For example, the first sub-layer board LA1 may include the first layer and the second layer of the modular winding WM arranged on the first sub-layer board LA1, but it may also be that the first layer of the modular winding WM is arranged on the first sub-layer board LA1, and the second layer is arranged on the second sub-layer board LA2, which is not limited here. Contact pads Pad_1, Pad_2 are formed at the initial end of the upper wirings T_1(n) to T_3(n) and the terminal end of the lower wirings T_1(m) to T_3(m), and the contact pads Pad_1, Pad_2 may be electrically connected to the electrical wirings Tc_1, Tc_2 on the top surface and bottom surface (i.e., the top surface of the second sub-layer board LA2) of the first sub-layer board LA1 respectively so as to electrically connect to the power component 400 through the electrical wirings Tc_1, Tc_2.

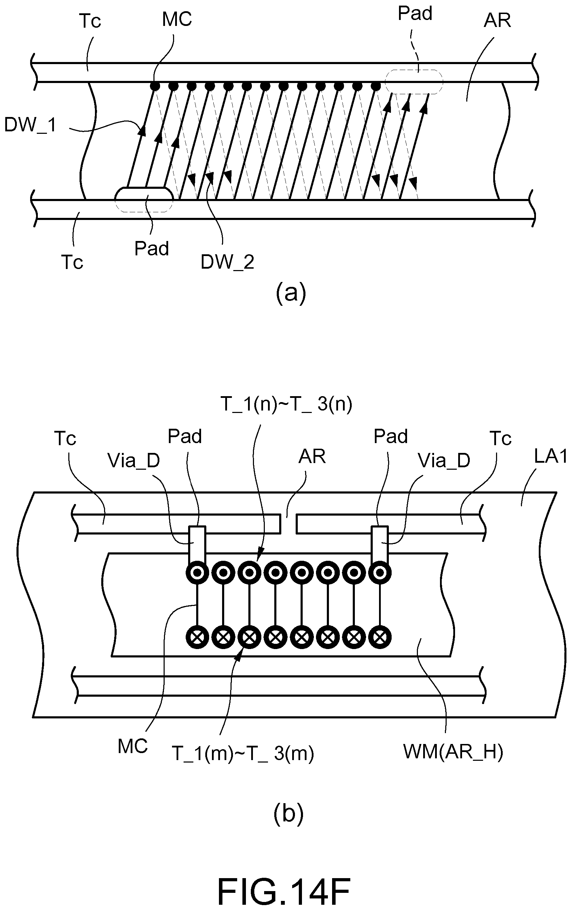

Please refer to FIG. 14F, which shows a top view and a cross-sectional view of the circuit board using the embedding technology for wiring the planar transformer according to a second embodiment of the present disclosure, and taking the wirings T_1(n), T_1(m) shown in FIG. 11A to form the module winding WM as an example. Referring to a top view of the sub-diagram (a) of FIG. 14F and a sectional view of the sub-diagram (b) of FIG. 14E, contact pads Pad_1, Pad_2 are formed at the initial end of the upper wirings T_1(n) to T_3(n) and the terminal end of the upper wirings T_1(n) to T_3(n), and the contact pads Pad_1, Pad_2 may be electrically connected to the electrical wirings Tc_1, Tc_2 on the top surface of the first sub-layer board LA1 respectively so as to electrically connect to the power component 400 through the electrical wirings Tc_1, Tc_2. Therefore, the electrical wirings Tc_1, Tc_2 are located on the same surface, and an isolation layer or a hollow area (i.e., area AR) is included between the two to prevent the two from being short-circuited.

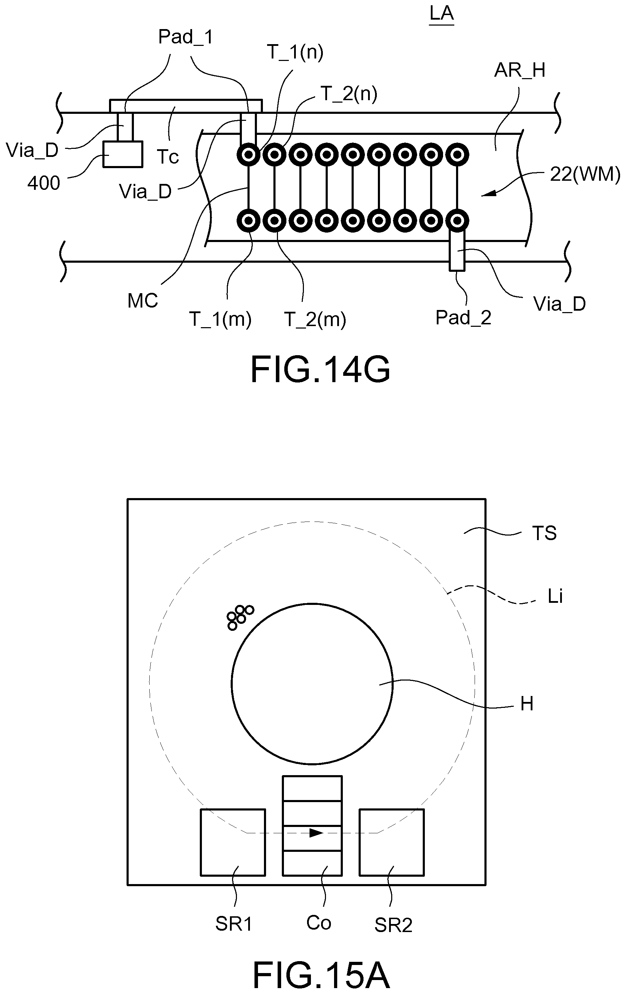

Please refer to FIG. 14G, which shows a side view of the circuit board using the embedding technology for wiring the power components and the planar transformer according to the present disclosure. In one embodiment, the technologies of FIG. 14A to FIG. 14G are integrated, and the power component 400 and the modular winding WM (including wirings T_1(n), T_1(m)) are embedded in any of the sub-layer boards LA1 to LA12 in the circuit board CB (for example, they are all embedded in the first sub-layer board LA1). The power component 400 may be electrically connected to the wirings T_1(n), T_1(m), T_2(n), T_2(m) of the modular winding WM through two vias Via_D by connecting the electrical wiring Tc_1 to the two contact pads Pad_1, and the modular winding WM may also be electrically connected to the electrical wiring Tc_2 on the bottom surface of the first sub-layer board LA1 (that is, the top surface of the second sub-layer board LA2) through the contact pads Pad_2. Therefore, the use of embedding technology can shorten the distance between the power component 400 and the wirings T_1(n), T_1(m), T_2 (n), T_2 (m) so as to reduce the AC impedance AC_R as much as possible and increase the circuit efficiency.

In one embodiment, the power component 400 and the wirings T_1(n), T_1(m), T_2(n), T_2(m) of the modular winding WM are embedded in the same sub-layer board LA to effectively shorten the distance between the power component 400 and the wirings T_1(n), T_1(m), T_2(n), T_2(m). For example, the power component 400 is a first switch SR1, and is embedded in a sub-layer board on the same layer as the first secondary-side wiring Ts1 (taking FIG. 11C as an example), and is electrically connected to the first switch SR1 through the electrical wiring Tc_1 and the contact pads Pd1 to effectively shorten the distance between the two, and so on. In other embodiments, the power component 400 and the wirings T_1(n), T_1(m), T_2(n), T_2(m) of the modular winding WM may also be embedded in a sub-layer board LA of a different layer. Compared with the conventional power component 400 which must be disposed on the surface of the circuit board CB, the power component 400 of the present disclosure does not need to be disposed on the surface of the circuit board CB, thereby avoiding other components and wirings on the surface of the circuit board CB to simplify the complexity of the circuit design.

Please refer to FIG. 15A, which shows an arrangement diagram of components of a secondary-side circuit of the resonant converter according to the present disclosure, and also refer to FIG. 12A to FIG. 12B. The secondary-side circuit 3A is disposed on the circuit board CB, and the secondary-side circuit 3A includes a first switch SR1, a second switch SR2, and an output capacitor Co. Referring to FIG. 3A to FIG. 3C, the first switch SR1, the second switch SR2, and the output capacitor Co are disposed on the circuit board CB, and the output capacitor Co is electrically connected to the first switch SR1 and the second switch SR2. The secondary-side wiring Ts may be disposed on any one or more sub-layer boards LA1 to LA12 in the circuit board CB and formed around the through hole H. One terminal of the secondary-side wiring Ts is electrically connected to the first switch SR1, and the other terminal of the secondary-side wiring Ts is electrically connected to the second switch SR2. For example, when the secondary-side wiring Ts is disposed on the surface layer of the circuit board CB (for example, the first sub-layer board LA1), the secondary-side wiring Ts may be directly connected to the first switch SR1 and the second switch SR2 by soldering the contact pads Pad, or when the secondary-side wiring Ts is disposed on the inner layer of the circuit board CB (for example, the second sub-layer board LA2), the secondary-side wiring Ts may be electrically connected to the first switch SR1 and the second switch SR2 through a via (not shown).

In FIG. 15A, the first switch SR1 and the second switch SR2 are disposed on the same side of the through hole H, and the output capacitor Co is disposed between the first switch SR1 and the second switch SR2. In one embodiment, when there are multiple output capacitors Co, they can be arranged in parallel in the same direction as shown in FIG. 15A, or they can be arranged in parallel in pairs as shown in the sub-diagram (a) of FIG. 11A and FIG. 11B. Due to the specific configuration of the first switch SR1, the second switch SR2, and the output capacitor Co, when the first switch SR1 and the second switch SR2 are turned on, a ring-shaped current path Li may be formed, that is, the current flows from one side of the secondary-side wiring Ts through the first switch SR1, the output capacitor Co, the second switch SR2 to the other side of the secondary-side wiring Ts. Since the current path Li is arc-shaped without other branches or irregular paths (for example, comparing to FIG. 14C), the device configuration of FIG. 15A can provide the shortest current path Li and reduce path loss.

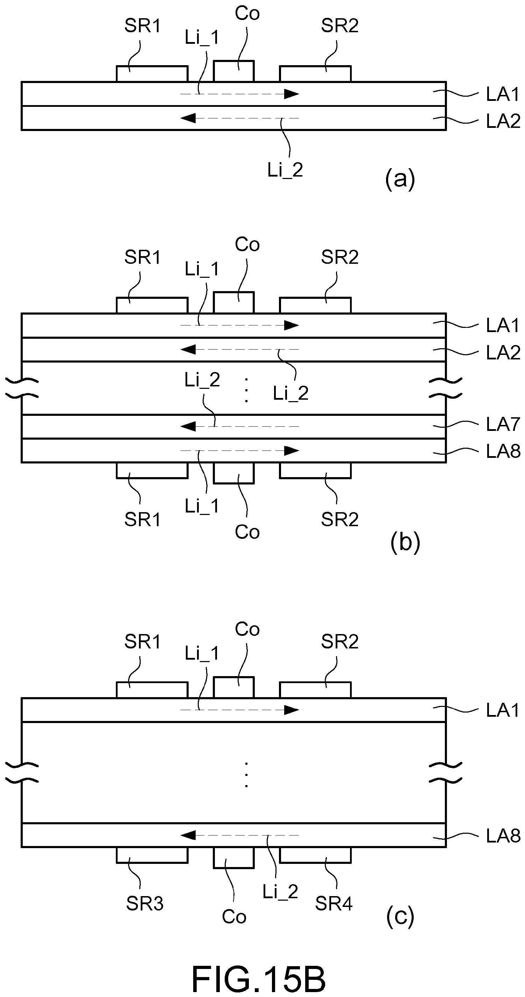

Please refer to FIG. 15B, which shows an arrangement diagram of components of different secondary-side circuits of the resonant converter according to the present disclosure, and also refer to FIG. 15A. FIG. 15B is a structural diagram mainly viewed from the output terminal OUT of the circuit board CB toward the iron core C1, and the first switch SR1, the second switch SR2, and the output capacitor Co may have different configurations according to the different secondary-side circuits 3A of FIG. 3A to FIG. 3C, but may also form the current path Li as shown in FIG. 15A. In the sub-diagram (a) of FIG. 15B, the first switch SR1, the second switch SR2, and the output capacitor Co are arranged on the same surface of the circuit board CB, and the first secondary-side wiring Ts1 and the second secondary-side wiring Ts2 are respectively arranged on at least any two layers of the circuit board CB (illustrated by the first sub-layer board LA1 and the second sub-layer board LA2), and the sub-diagram (a) of FIG. 15B is applicable to the circuits of FIG. 3A and FIG. 3B. When the first switch SR1 is turned on, the current I1 flows through the first switch SR1 in the first sub-layer board LA1 around the through hole H to the output capacitor Co to form a current path Li_1, and when the second switch SR2 is turned on, the current I2 flows through the second switch SR2 in the second sub-layer board LA2 around the through hole H to the output capacitor Co to form a current path Li_2. Since the directions of the current path Li_1 and the current path Li_2 are opposite, the magnetic flux cancellation effect can be achieved, thereby increasing the overall efficiency of the circuit.

In the sub-diagram (b) of FIG. 15B, the resonant converter 100 includes two groups of secondary-side circuits 3A and two groups of secondary-side wirings Ts, and each group of secondary-side wiring Ts includes a first secondary-side wiring Ts1 and a second secondary-side wiring Ts2. The first switches SR1, the second switches SR2, and the output capacitors Co of the two groups of secondary-side circuits 3A are respectively disposed on two surfaces of the circuit board CB. The first secondary-side wiring Ts1 and the second secondary-side wiring Ts2 are respectively arranged on at least any four layers of the circuit board CB (for example, the first secondary-side wiring Ts1 is arranged on the sub-layer boards LA1, LA2, and the second secondary-side wiring Ts2 is arranged on the sub-layer boards LA11, LA12, and the sub-diagram (b) of FIG. 15B is applicable to the circuits of FIG. 3A and FIG. 3B. When the first switch SR1 is turned on, the current I1 flows through the first switch SR1 around the through hole H to the output capacitor Co in the sub-layer boards LA1, LA2 to form a current path Li_1, and when the second switch SR2 is turned on, the current I2 flows through the second switch SR2 around the through hole H to the output capacitor Co in the sub-layer boards LA2, LA22 to form a current path Li_2, thereby achieving the effect of magnetic flux cancellation and increasing the overall efficiency of the circuit.

In the sub-diagram (c) of FIG. 15B, the first switch SR1, the second switch SR2, and the output capacitor Co are disposed on a surface of the circuit board CB, and the third switch SR3, the fourth switch SR4, and the output capacitor Co are disposed on the other surface of the circuit board CB. The secondary-side wiring Ts is arranged on at least any two layers of the circuit board CB (illustrated by the sub-layer boards LA1, LA12), and the sub-diagram (c) of FIG. 15B is applicable to the circuit of FIG. 3C. When the first switch SR1 and the second switch SR2 are turned on, the current I1 flows through the first switch SR1 and the second switch SR2 around the through hole H to the output capacitor Co in the sub-layer board LA1 to form a current path Li_1. When the third switch SR3 and the fourth switch SR4 are turned on, the current I2 in the same wiring (i.e., the secondary side wiring Ts) but in the opposite direction flows through the third switch SR3 and the fourth switch SR4 around the through hole H to the output capacitor Co in the sub-layer board LA2 to form a current path Li_2, thereby achieving the effect of magnetic flux cancellation and increasing the overall efficiency of the circuit. In one embodiment, referring to FIG. 15A, the positions of the first switch SR1 and the second switch SR2 are substantially mirrored with the output capacitor Co as the center, which is a preferred embodiment, and can form current paths Li_1, Li_2 with roughly the same path to achieve a better magnetic flux cancellation effect. Furthermore, the positions of the first switch SR1 and the second switch SR2 are mirrored with the output capacitor Co as the center to achieve the best magnetic flux cancellation effect, and the same is true for the third switch SR3 and the fourth switch SR4.

Referring to FIG. 3A to FIG. 15B, the resonant converter 100 uses a single-chip circuit board CB, which can be optionally matched with Litz wire, interleaving winding, embedding technology, component settings, and other technologies to increase the overall circuit efficiency of the resonant converter 100. In one embodiment, the winding 22 described in the embodiments of FIG. 3A to FIG. 15B, if not specifically named, may be a general term for the primary-side winding 22A and the secondary-side winding 22B, or may simply refer to the primary-side winding 22A or the secondary-side winding 22B, or even refer to only the first winding 22B-1 or the second winding 22B-2, which is not limited here. In another embodiment, if the wirings disclosed in the embodiments of FIG. 3A to FIG. 15B are not specifically named, they may be generally referred to as the primary-side wiring Tp and the secondary-side wiring Ts, or may simply refer to the primary-side wiring Tp or the secondary-side wiring Ts, or even refer to only the first secondary-side wiring Ts1 or the second secondary-side wiring Ts2, which is not limited here.

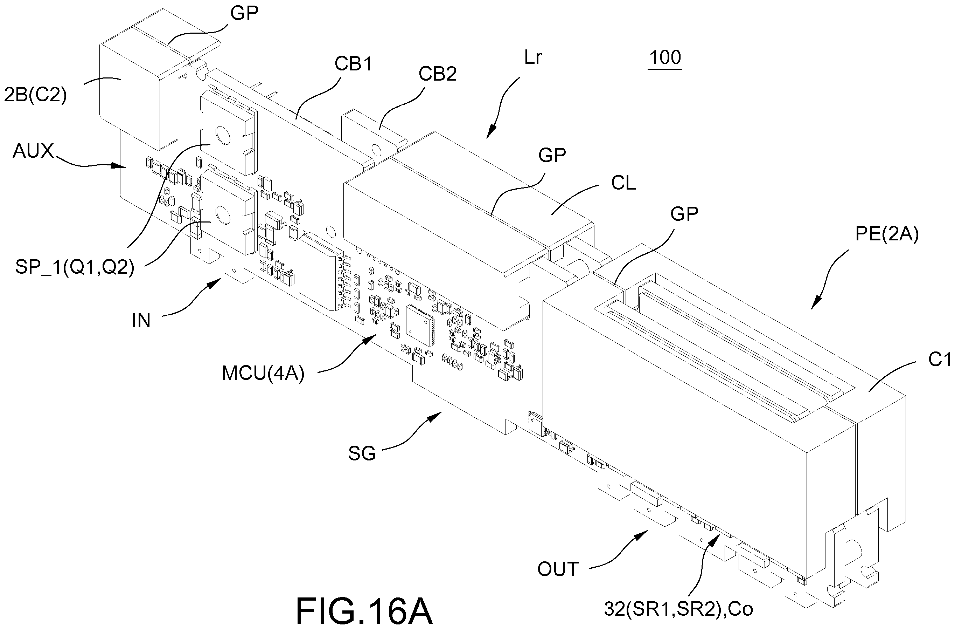

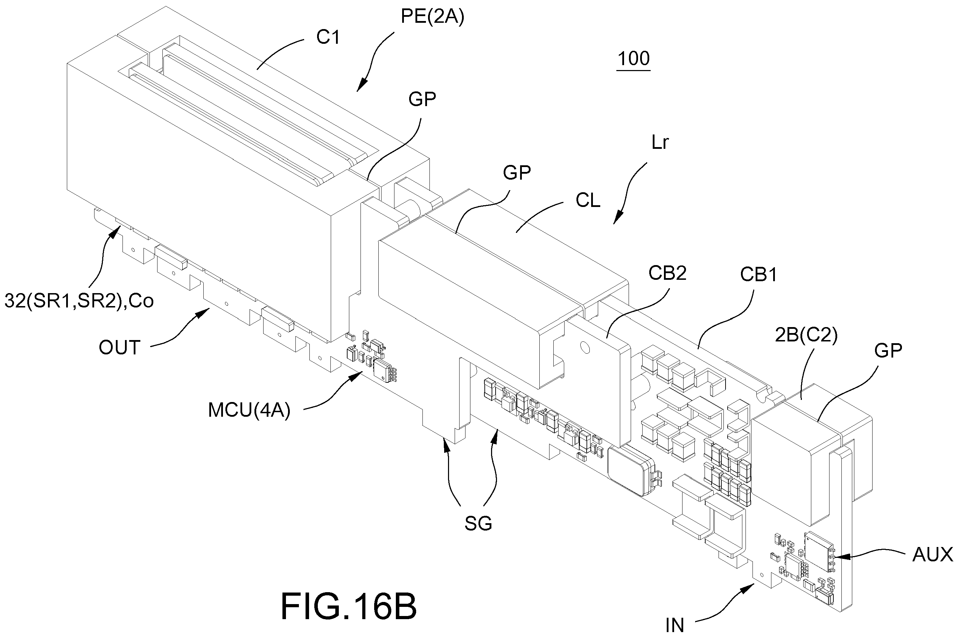

Please refer to FIG. 16A, which shows a perspective circuit structure assembled diagram in a first perspective of the resonant converter according to a second embodiment of the present disclosure; please refer to FIG. 16B, which shows a perspective circuit structure assembled diagram in a second perspective of the resonant converter according to the second embodiment of the present disclosure, and also refer to FIG. 4A. FIG. 16A and FIG. 16B are mainly circuit diagrams of the resonant converter 100 (for example, the circuit diagrams of FIG. 3A to FIG. 3C) converted into a physical structure of two circuit boards CB1, CB2 so that the resonant converter 100 composed of the circuit boards CB1, CB2 has the function of converting the DC power source Pdc into output power source Po. In terms of physical structure, the resonant converter 100 includes a first circuit board CB1 and a second circuit board CB2, a primary-side circuit 1A, a secondary-side circuit 3A, and a planar transformer PE as a transformer 2A. The first circuit board CB1 includes a plurality of sub-layer boards, and an input terminal IN and an output terminal OUT are formed at an edge of the first circuit board CB1. The input terminal IN of the first circuit board CB1 receives the DC power source Pdc, and the output terminal OUT provides the output power source Po. The second circuit board CB2 includes a plurality of sub-layer boards, and an output terminal OUT is formed at an edge of the second circuit board CB2, and the output terminal OUT provides an output power source Po. The input terminal IN and the output terminal OUT are formed at the edge of the circuit boards CB1, CB2, and the circuit boards CB1, CB2 may be plugged into any device that needs power conversion, such as power supply unit, uninterruptible power supply, etc., and vertical plugging can save device space.

The primary-side circuit 1A is disposed on the first circuit board CB1 and the second circuit board CB2, and the circuit components of the primary-side circuit 1A that can be clearly seen on the first circuit board CB1 include the power switches Q1, Q2 of the primary-side switch bridge arm SP_1 and an inductor core CL used to form a resonant inductor Lr. Referring to FIG. 16B, the second circuit board CB2 includes a part of the circuit of the resonant converter 100, mainly the first circuit board CB1 may include a part of the inductor winding Lc of the resonant inductor Lr and a part of the winding 22 of the transformer 2A, and the second circuit board CB2 includes another portion of the inductor winding Lc and another portion of the winding 22 of the transformer 2A. The iron core C1 sets the first circuit board CB1 and the second circuit board CB2 together to form the transformer 2A of the resonant converter 100.

Referring to FIG. 3A to FIG. 3C and FIG. 16A to 16B, the resonant converter 100 having the two circuit boards CB1, CB2 includes two (or more) groups of secondary-side circuits 3A, and therefore the first circuit board CB1 and the second circuit board CB2 may each be provided with one group of secondary-side circuit 3A. The circuit components of the secondary-side circuit 3A that can be clearly seen on the circuit boards CB1, CB2 include the first switch SR1, the second switch SR2, and the output capacitor Co of the rectifier circuit 32. The planar transformer PE is disposed on the first circuit board CB1 and the second circuit board CB2 and electrically connected to the primary-side circuit 1A and the secondary-side circuit 3A. The planar transformer PE includes an iron core C1 for forming the planar transformer PE. In particular, the resonant inductor Lr and the planar transformer PE are arranged on the circuit boards CB1, CB2 by using wirings to achieve planarization so that the original large winding transformer/inductor is replaced to reduce the volume occupied by the resonant converter 100. The system control circuit MCU (including a controller 4A for controlling the resonant converter 100) may be disposed on the first circuit board CB1 or the second circuit board CB2, and the system control circuit MCU can communicate with external devices through the signal transmission terminal SG of the first circuit board CB1 or the second circuit board CB2.

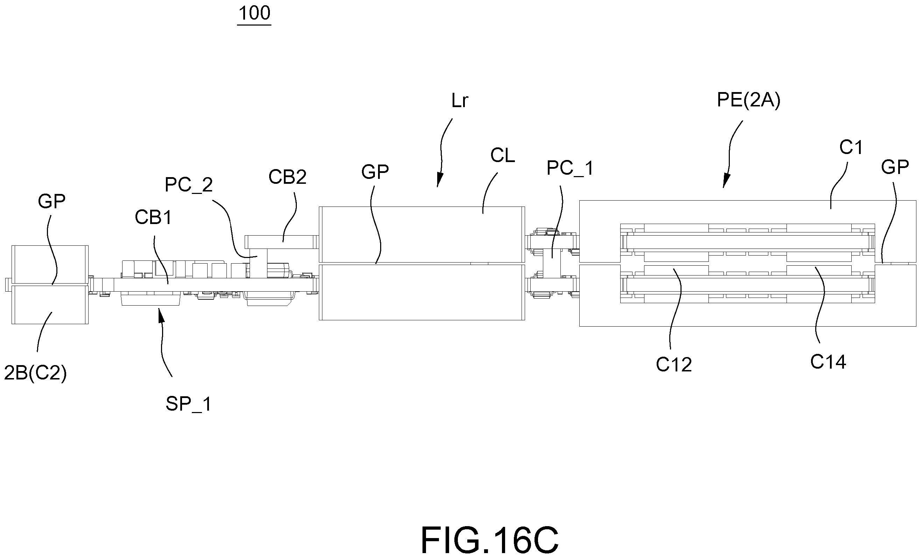

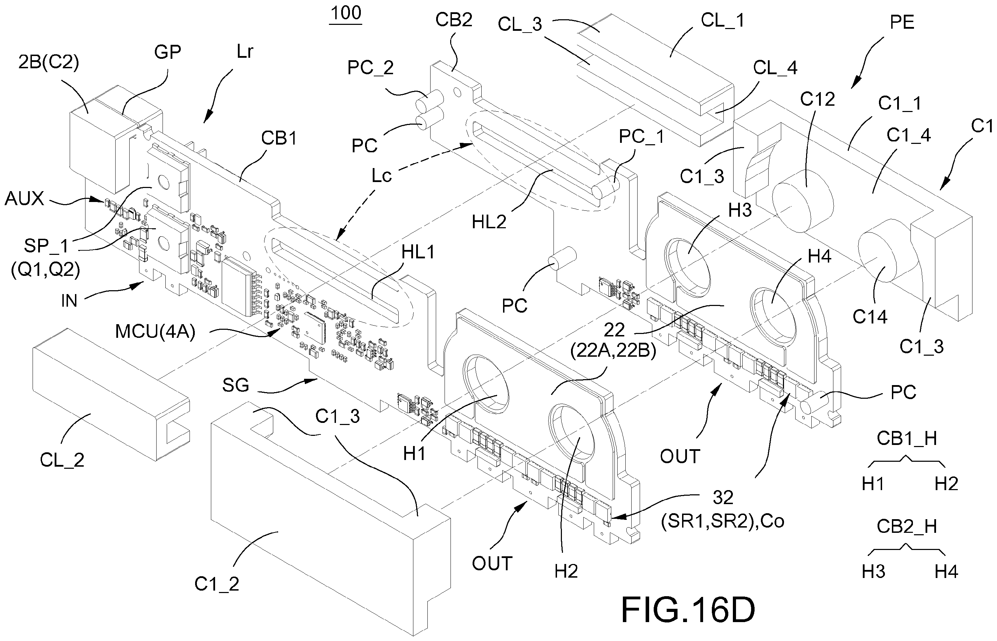

Please refer to FIG. 16C, which shows a perspective circuit structure assembled diagram in a third perspective of the resonant converter according to the second embodiment of the present disclosure, and also refer to FIG. 3A to FIG. 3C and FIG. 16A to FIG. 16B. The planar transformer PE further includes a conductive column PC_1, and the conductive column PC_1 is disposed between the first circuit board CB1 and the second circuit board CB2. Since the first circuit board CB1 includes a portion of the winding 22 of the transformer 2A formed by wirings, and the second circuit board CB2 includes another portion of the winding 22 of the transformer 2A formed by wirings, and therefore each portion of the winding 22 may be electrically connected together through the conductive column PC_1 to form a complete winding 22A. Please refer to FIG. 16D, which shows a perspective circuit structure exploded diagram of the resonant converter according to the second embodiment of the present disclosure, and which mainly decomposes the inductor core CL of the resonant inductor Lr and the iron core C1 of the transformer 2A, and the planar transformer PE also includes a first circuit board through hole CB1_H, a second circuit board through hole CB2_H, a primary-side winding 22A, and a secondary-side winding 22B.

The first circuit board through hole CB1_H includes a first through hole H1 and a second through hole H2, and the first through hole H1 and the second through hole H2 respectively penetrate the first circuit board CB1. The second circuit board through hole CB2_H includes a third through hole H3 and a fourth through hole H4, and the third through hole H3 and the fourth through hole H4 respectively penetrate through the second circuit board CB2. The primary-side winding 22A and the secondary-side winding 22B respectively surround the first through hole H1 and the second through hole H2 of the first circuit board through hole CB 1_H and the third through hole H3 and the fourth through hole H4 of the second circuit board through hole CB2_H. That is, the primary-side winding 22A and the secondary-side winding 22B are formed on the sub-layer boards of the first circuit board CB1 and the second circuit board CB2 in a wiring structure, and surround the first circuit board through hole CB1_H and the second circuit board CB2, and the primary-side winding 22A and the secondary-side winding 22B are sleeved by the iron core C1 to form the planar transformer PE.

In one embodiment, the iron core C1 may be an EI-type, EE-type, ER-type core, etc. The iron core C1 includes two covers C1_1, C1_2, and at least one of the two covers C1_1, C1_2 forms a first core column C12 and a second core column C14. The two covers C1_1, C1_2 further include a main body and a plurality of side portions C1_3 respectively, and the side portions C1_3 of the two covers C1_1, C1_2 are correspondingly protruded from edges of the main body. An accommodation groove C1_4 is formed between the side portions C1_3 of the two covers C1_1, C1_2 and the first core column C12 and the second core column C14, and the accommodation groove C1_4 is used to accommodate a portion of the winding 22 of the first circuit board CB1 and another portion of the winding 22 of the second circuit board CB2. In one embodiment, the winding 22 may be a primary-side winding 22A and a secondary-side winding 22B, and in other embodiments, for example, the winding 22 may be at least one of the primary-side winding 22A and the secondary-side winding 22B as shown in FIG. 3A to FIG. 3C.

If the circuit structures of FIG. 16A to FIG. 16D is implemented by the circuit structures of FIG. 3A to FIG. 3C, since the primary-side winding 22A of the resonant converter 100 is connected in series, the primary-side winding 22A of a portion of the first circuit board CB 1 and the primary-side winding 22A of another part of the second circuit board CB2 may be electrically connected together through the conductive column PC_1 to form a complete primary-side winding 22A. Since the secondary-side of the resonant converter 100 includes two groups of secondary-side circuits 3A, and each secondary-side circuit 3A is output in parallel, the first circuit board CB1 and the second circuit board CB2 may be provided with one group of secondary-side winding 22B, respectively. Since the secondary side of the transformer 2A is a parallel structure, the secondary-side windings 22B of the first circuit board CB1 and the second circuit board CB2 do not need to be electrically connected by conductive columns, and may be electrically connected to each other by connecting their respective output terminals OUT in parallel.

The planar transformer PE is covered by two covers C1_1, C1_2 so that the first core column C12 penetrates the first through hole H1 of the first circuit board through hole CB1_H and the third through hole H3 of the second circuit board through hole CB2_H, and the second core column C14 penetrates the second through hole H2 of the first circuit board through hole CB1_H and the fourth through hole H4 of the second circuit board through hole CB2_H. Therefore, the first circuit board CB1 and the second circuit board CB2 may be set together by covering the two covers C1_1, C1_2 to form the transformer 2A of the resonant converter 100. Referring to FIG. 16A to FIG. 16C, the side portion C1_3 located at the outer side of the first circuit board CB1 and the second circuit board CB2 may form an air gap GP, and the air gap GP is formed on the outer side of the first circuit board CB1 and the second circuit board CB2. Therefore, the size of the air gap GP can be easily adjusted to adjust the magnetic resistance of the planar transformer PE to avoid magnetic saturation when the circuit is in operation. Since the air gap GP is located between the first circuit board CB1 and the second circuit board CB2, the magnetic field lines generated around the air gap GP are not easy to cut the primary-side winding 22A and the secondary-side winding 22B, and the air gap avoidance effect is actively generated, thereby reducing the heat loss of the winding and increasing the efficiency.

In one embodiment, the iron core C1 includes two iron core columns C12, C14, which respectively penetrate the first circuit board through holes CB1_H (i.e., the first through hole H1 and the second through hole H1) and the second circuit board through holes CB2_H (i.e., the third through hole H3 and the fourth through hole H4) of the first circuit board CB1 and the second circuit board CB2. In other embodiments, for example, the first circuit board CB1 and the second circuit board CB2 may include only a single through hole (i.e., the first circuit board through hole CB1_H includes only the first through hole H1, and the second circuit board CB2 includes only the third through hole H3). Furthermore, the winding 22 surrounds the single through hole, and the single iron core column C12 of the iron core C1 penetrates through the first through hole H1 and the third through hole H3 to form the planar transformer PE. The conductive column PC_1 is also electrically connected to the primary-side wiring disposed around the first circuit board through hole CB 1_H and the primary-side wiring disposed around the second circuit board through hole CB2_H to form the primary-side winding 22A. The secondary-side wiring can form the secondary-side winding 22B without using conductive columns for electrical connection so that the total is the winding 22 of the planar transformer PE.

Please refer to FIG. 16A to FIG. 16D, the resonant converter 100 further includes an inductor through hole HL and an inductor winding Lc. The inductor through hole HL includes a first inductor through hole HL1 formed on the first circuit board CB1 and a second inductor through hole HL2 formed on the second circuit board CB2, and the first inductor through hole HL1 and the second inductor through hole HL2 respectively penetrate the first circuit board CB1 and the second circuit board CB2. The inductor winding Lc is electrically connected to the winding 22 and surrounds the inductor through hole HL. Similar to the winding 22 of the transformer 2A, the inductor winding Lc is formed on the sub-layer boards of the first circuit board CB1 and the second circuit board CB2 in a wiring structure. The first circuit board CB1 may include a portion of the inductor winding Lc, and the second circuit board CB2 may include a portion of the inductor winding Lc. The planar transformer PE further includes a conductive column PC_2, and the conductive column PC_2 is also disposed between the first circuit board CB1 and the second circuit board CB2. Since the first circuit board CB1 includes a portion of the inductor winding Lc, and the second circuit board CB2 includes another portion of the inductor winding Lc, these portions of inductor windings Lc may be electrically connected together through the conductive column PC_2 to form a complete inductor winding Lc. The inductor core CL sets the first circuit board CB1 and the second circuit board CB2 together to form the resonant inductor Lr of the resonant converter 100.

In one embodiment, the inductor core CL may be an UI-type, UU-type core, etc. The inductor core CL includes two covers CL_1, CL_2. The two covers CL_1, CL_2 include a main body, and at least one of the two covers CL_1, CL_2 includes two side portions CL_3. The two portions CL_3 are protruded from edges of the main body, and one of the two side portions CL_3 penetrates through the inductor through hole HL. An accommodation space CL_4 is formed between the side portions CL_3 of the two covers CL_1, CL_2, and the accommodation space CL_4 is used to accommodate a portion of the inductor winding Lc of the first circuit board CB1 and another portion of the inductor winding Lc of the second circuit board CB2. A portion of the side portions Cl_3 of the two covers CL_1, CL_2 are located outside the circuit board CB, and in one embodiment, the side portions CL_3 located outside the first circuit board CB1 and the second circuit board CB2 can form an air gap GP, which functions like the air gap GP of the iron core C1.

In one embodiment, the conductive columns PC_1, PC_2 are, for example, copper columns, aluminum columns, or other columns having a conductive function. In another embodiment, the resonant converter 100 of the present disclosure may include a plurality of supporting columns PC (as shown in FIG. 16D) in addition to the conductive columns PC_1, PC_2. The supporting columns PC may be made of suitable materials according to their functions. For example, a portion of the supporting columns PC may have conductive properties like the conductive columns PC_1, PC_2 to guide the current to flow through and serve as supports for the first circuit board CB1 and the second circuit board CB2, while another portion of the supporting columns PC may be made of non-conductive material and only serve as supports.

As shown in FIG. 16A to FIG. 16D, the first circuit board CB1 further includes an auxiliary power circuit AUX, and the auxiliary power circuit AUX is electrically connected to the input terminal IN to receive a DC power source Pdc. The auxiliary power circuit AUX may be an isolated conversion circuit (for example, a flyback conversion circuit) and includes a transformer 2B. The transformer 2B is similar to the transformer 2A, and the wiring may be set on the first circuit board CB1 and the transformer 2B may be formed by sleeving the iron core C2. The iron core C2 may also correspond to the iron core C1 and form an air gap GP at the side portion, and its function is the same as the air gap GP of the iron core C1. In one embodiment, a controller (not shown) of the auxiliary power circuit AUX may also be optionally integrated into the system control circuit MCU, which is not limited herein. Therefore, the single circuit board CB shown in FIG. 16A and FIG. 16B may include the auxiliary power circuit AUX, the system control circuit MCU, and the resonant converter 100, and save a lot of wiring space and at least save the space SE in FIG. 2.

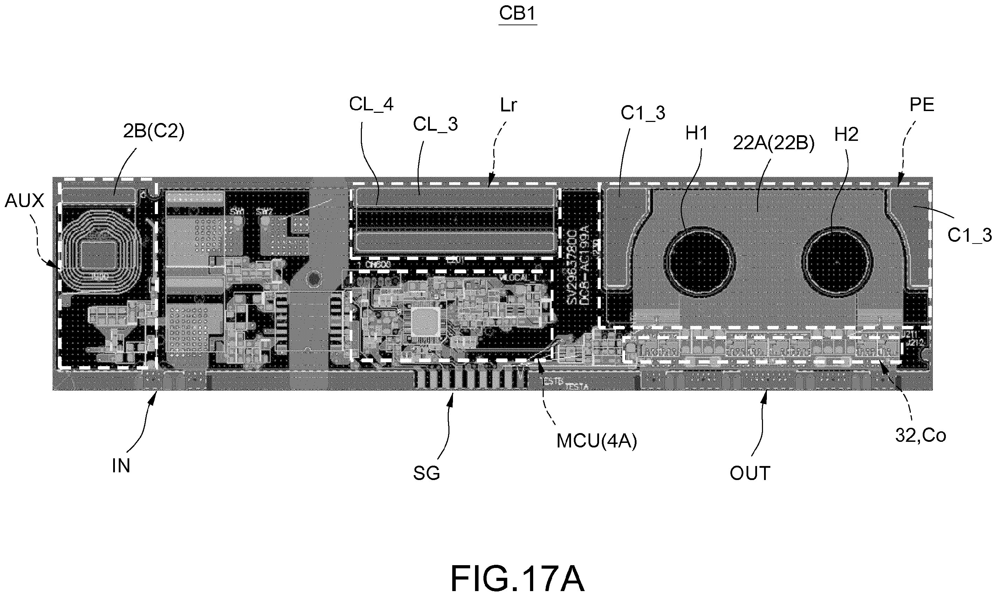

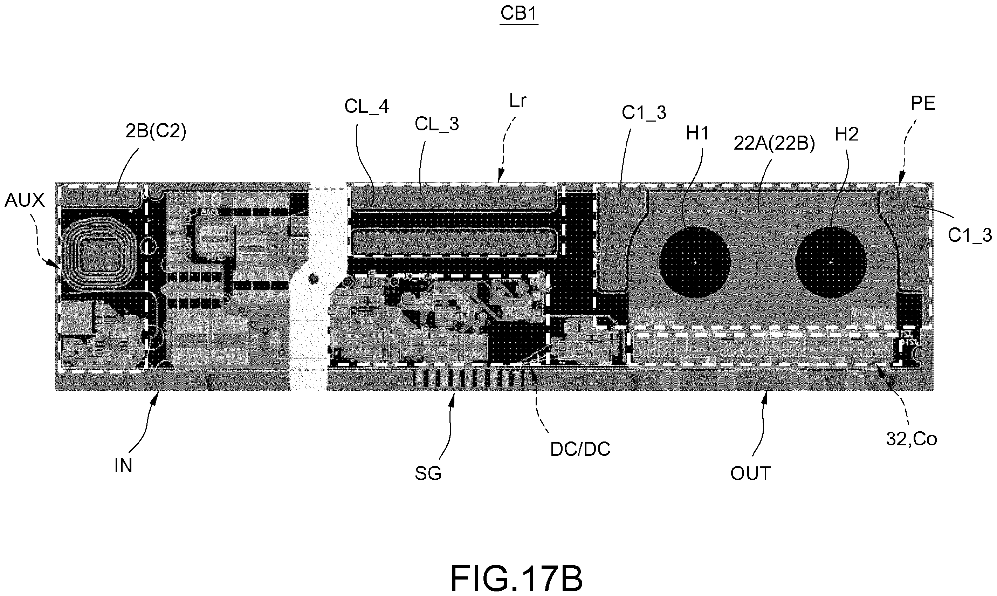

Please refer to FIG. 17A, which shows a wiring structure diagram of one surface layer of a first circuit board according to a second embodiment of the present disclosure; please refer to FIG. 17B, which shows a wiring structure diagram of one surface layer of the first circuit board according to the second embodiment of the present disclosure. The DC power source Pdc enters from the input terminal IN and passes through the primary-side switch bridge arm SP_1 and the resonant inductor Lr to the planar transformer PE. The DC power source Pdc is also provided to the auxiliary power circuit AUX so that the auxiliary power circuit AUX converts the DC power source Pdc into the auxiliary power source Paux. The planar transformer PE provides energy to the rectifier circuit 32 and the output capacitor Co through the coupling of the primary-side winding 22A and the secondary-side winding 22B, and finally provides the output power source Po to the load 300 through the output terminal OUT. According to the above path, the first circuit board CB takes the path of large current (referred to as the power path) as described above, from the input terminal IN to the output terminal OUT, which is an n-type path, and the system control circuit MCU and its peripheral control and compensation circuits are located in the center of the n-type path and separated from the power path. The signal transmission terminal SG is directly electrically connected to the system control circuit MCU. The system control circuit MCU is short in distance from the power switches Q1, Q2, the first switch SR1 and the second switch SR2, and is less likely to pass through the power path and be separated from the power path. Therefore, the noise in the power path is less likely to interfere with the signal transmission of the system control circuit MCU, thereby reducing the path loss on the transmission path.

In FIG. 17B, the other side opposite to the position of the control circuit MCU includes a DC conversion circuit DC/DC, which is mainly composed of a number of small step-down converters (for example, buck). The main reason for configuring a plurality of step-down (buck) converters is that the auxiliary power source Paux converted by the auxiliary power circuit AUX is a single voltage (for example but not limited to, 12V). However, some controllers, drivers, etc. on the first circuit board CB1 require different power sources (such as but not limited to, 5V, 3.3V, 1.8V, etc.), and therefore several small step-down converters of the DC conversion circuit DC/DC are used. The converter performs power conversion, that is, converting the appropriate voltage to supply power to these components for normal operation. The power switches Q1, Q2 of the primary-side switch bridge arm SP_1 are, for example but not limited to, transistors made of GaN materials, and the power switches Q1, Q2 are arranged with the shortest path. The secondary-side winding 22B, the first switch SR1, and the second switch SR2 are also arranged with the shortest path to facilitate the layout of the output terminal OUT. On the other hand, the wiring distance of the secondary-side winding 22B, the first switch SR1, the second switch SR2, and the output capacitor Co is closely related to their AC impedance, and therefore the closer the first switch SR1, the second switch SR2, and the output capacitor Co are to the secondary-side winding 22B, the smaller the AC impedance and the better the efficiency.

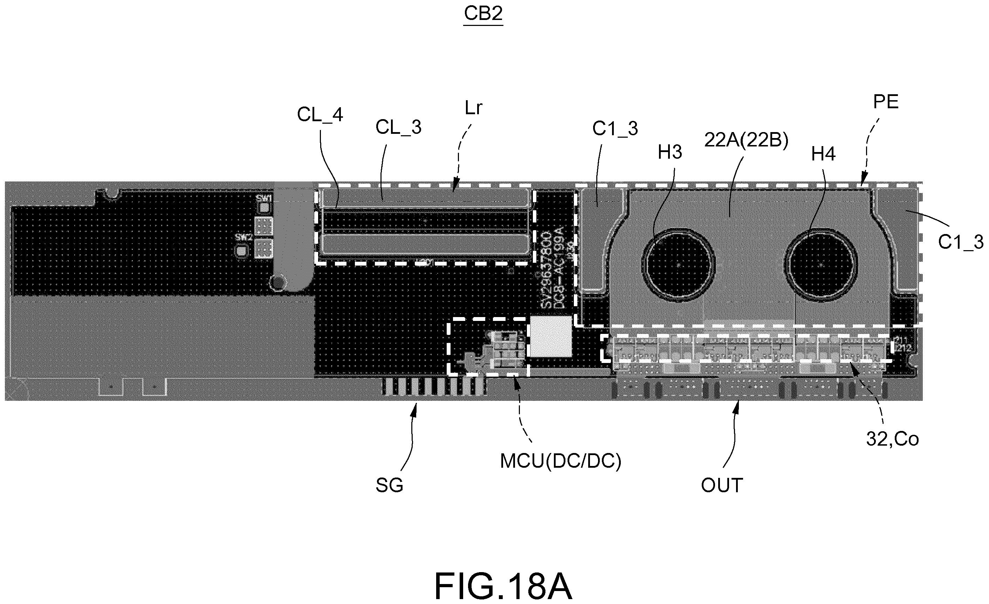

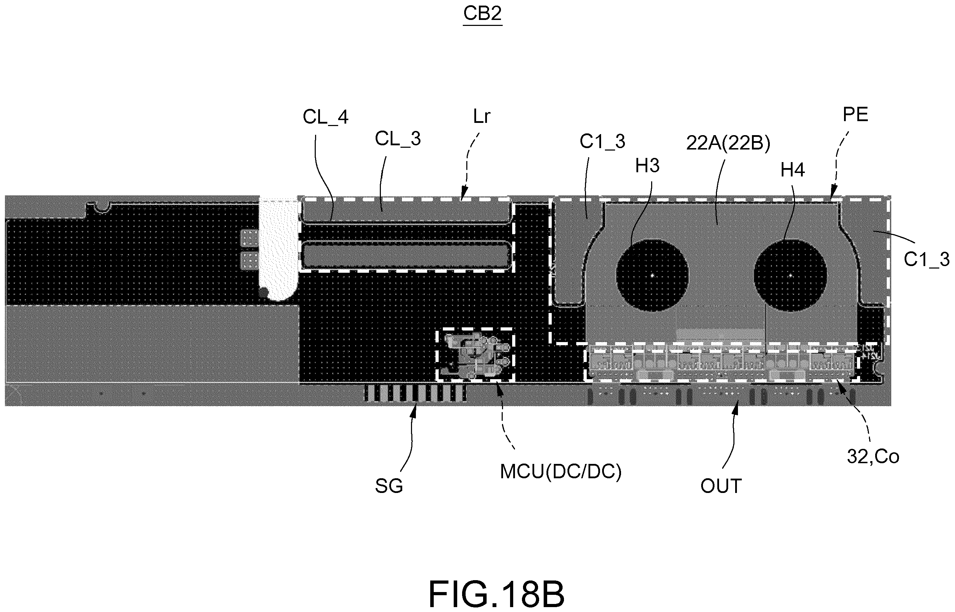

Please refer to FIG. 18A, which shows a wiring structure diagram of one surface layer of a second circuit board according to the second embodiment of the present disclosure; please refer to FIG. 18B, which shows a wiring structure diagram of one surface layer of the second circuit board according to the second embodiment of the present disclosure. The second circuit board CB2 may optionally include a signal transmission terminal SG so that the second circuit board CB2 may directly communicate with an external device through the signal transmission terminal SG without transmitting the signal back to the first circuit board CB1. The second circuit board CB2 may be electrically connected to the first circuit board CB1 through the conductive columns PC_1, PC_2 to receive the DC power source Pdc. In one embodiment, the second circuit board CB2 is not provided with the auxiliary power circuit AUX, and therefore the second circuit board CB2 can save space for providing the auxiliary power circuit AUX so that the length of the second circuit board CB2 is shorter than that of the first circuit board CB1 (referring to FIG. 16A to FIG. 16D).

Please refer to FIG. 18B, the two sides of the second circuit board CB2 may also include a system control circuit MCU or a DC conversion circuit DC/DC, and the DC conversion circuit DC/DC may be composed of at least one small step-down (buck) converter. Its function is similar to the system control circuit MCU and DC conversion circuit DC/DC of the first circuit board CB1, mainly communicating with the external device through the signal transmission terminal SG or converting a suitable voltage to the second circuit board CB2 to supply power to some controllers, drivers and other components. Since the resonant converter 100 uses a physical structure of two circuit boards CB1, CB2 with four surfaces, the heat can be evenly dispersed and the heat dissipation area can be effectively increased. The windings 22 of the resonant converter 100 may be dispersedly arranged on two circuit boards CB1, CB2 so as to reduce the heat generated by the resonant converter 100 and increasing circuit efficiency. Since the resonant converter 100 uses a structure with a primary-side series connection and a secondary-side parallel connection, the first switch SR1 and the second switch SR2 of the secondary-side circuit 3A may be dispersedly arranged on the circuit boards CB1, CB2 to provide better heat dissipation.

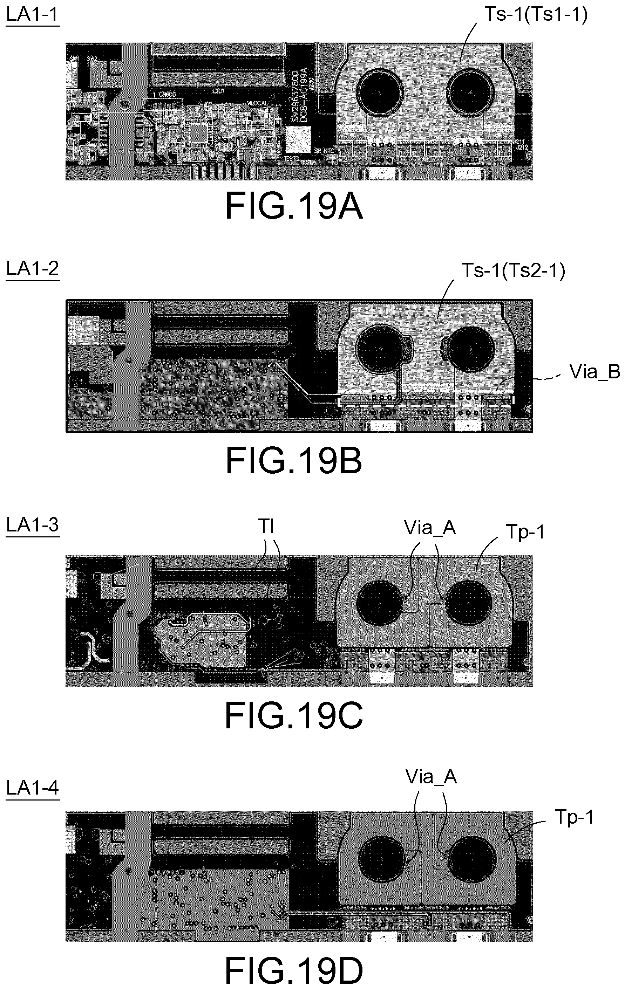

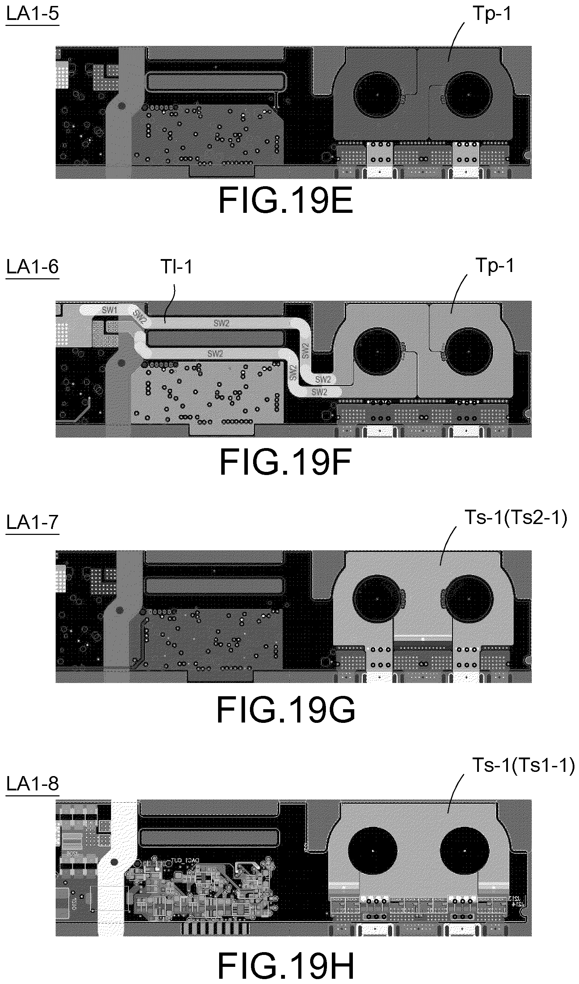

Please refer to FIG. 19A to FIG. 19H, which show schematic diagrams of wiring the windings of the planar transformer on each sub-layer board of the first circuit board according to a second embodiment of the present disclosure. In one embodiment, the first circuit board CB1 is taken as an example of 8-layer sub-layer boards LA1-1 to LA1-8, and the sub-layer boards LA1-1 to LA1-8 are sequentially from a top layer board to a bottom layer board. In other embodiments, the number of layers of the first circuit board CB1 may be increased or decreased according to actual circuit requirements. Please refer to FIG. 3A to FIG. 3C, in the wirings of the sub-layer boards LA1-1 to LA1-8, the inductor wiring T1-1 is used as the inductor winding Lc arranged on the first circuit board CB1 (i.e., a portion of the inductor winding Lc) in the resonant inductor Lr, and the primary-side wiring Tp-1 is used as the primary-side winding 22A arranged on the first circuit board CB1 (i.e., a portion of the primary-side winding 22A) in the transformer 2A. The secondary-side wiring Ts-1 includes a first secondary-side wiring Ts1-1 and a second secondary-side wiring Ts2-1. The first secondary-side wiring Ts1-1 is used as the first winding 22B-1 arranged on the first circuit board CB1, and the second secondary-side wiring Ts2-1 is used as the second winding 22B-2 arranged on the first circuit board CB1.

In one embodiment, the copper foil of the primary-side wiring Tp-1 and the copper foil of the inductor wiring Tl-1 are integrally formed to form a common-wiring structure, and the primary-side wiring Tp-1 and the secondary-side wiring Ts-1 are located on different sub-layer boards LA1 to LA8 so that when the current flows through the sub-layer boards LA1 to LA8, the current can be evenly distributed. In other embodiments, the inductor wiring T1-1, the primary-side wiring Tp-1, and the secondary-side wiring Ts-1 may be located on the same sub-layer boards LA1 to LA8 according to actual circuit requirements. The primary-side wiring Tp-1 and the secondary-side wiring Ts-1 are formed and surround the first through hole H1 and the second through hole H2 of the first circuit board through hole CB1_H respectively, and the inductor wiring Tl-1 is formed and surrounds the inductor through hole HL.

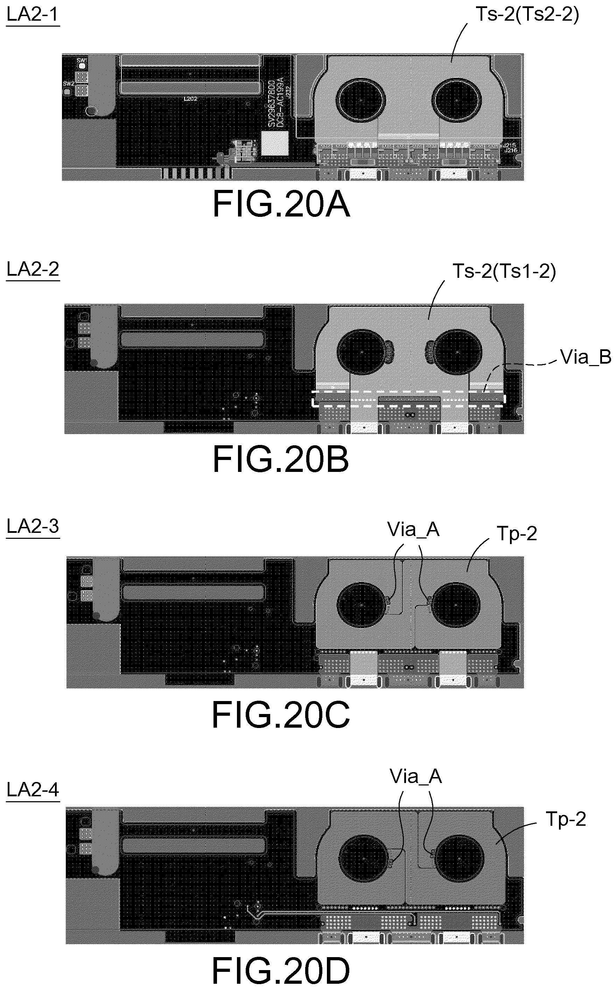

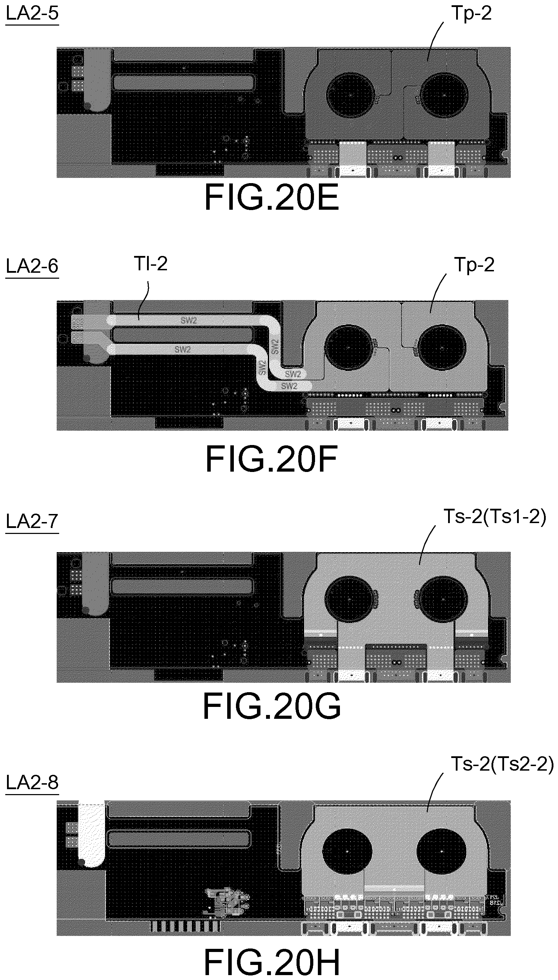

Please refer to FIG. 20A to FIG. 20H, which show schematic diagrams of wiring the windings of the planar transformer on each sub-layer board of the second circuit board according to the second embodiment of the present disclosure. In one embodiment, taking the second circuit board CB2 having 8 layers of sub-layer boards LA2-1 to LA2-8 as an example (from the top layer to the bottom layer in order). The number of layers of the sub-layer boards LA2 - 1 to LA2 - 8 of the second circuit board CB2 is the same as that of the first circuit board CB1 so that the current can be evenly distributed, which is a preferred implementation. In other embodiments, the number of layers of the second circuit board CB2 may be increased or decreased according to actual circuit requirements. Please refer to FIG. 3A to FIG. 3C and FIG. 20A to FIG. 20H, in the wirings of the sub-layer boards LA2-1 to LA2-8, the structures and functions of the first secondary-side wiring Ts1-2 and the second secondary-side wiring Ts2-2 of the secondary-side wiring Ts-2, the primary-side wiring Tp-2, and the inductor wiring T1-2 are similar to the corresponding wirings of the first circuit board CB1, and the difference is that the positions of the first secondary-side wiring Ts1-2 and the second secondary-side wiring Ts2-2 are swapped. The main purpose of swapping the positions of the first secondary-side wiring Ts1-2 and the second secondary-side wiring Ts2-2 is to allow the current of the secondary-side circuit 3A to be evenly distributed when it is in operation, rather than being concentrated on the adjacent two sub-layer boards, that is, if both FIG. 19H and FIG. 20A are the first secondary-side wirings Ts1-1, Ts1-2, and the first switch SR1 is turned on, the two layers are closer and less likely to evenly distribute the current.

Please refer FIG. 19A to FIG. 20H, the primary-side wiring Tp-1 of the first circuit board CB 1 is electrically connected to the primary-side wiring Tp-2 of the second circuit board CB2 through the conductive column PC_1 to form a structure with a primary-side series connection. After the iron core C1 is sleeved on the primary-side wiring Tp-1, the primary-side wiring Tp-2, the secondary-side wiring Ts-1, and the secondary-side wiring Ts-2, a closed magnetic circuit may be formed to form a transformer 2A. The inductor wiring T1-1 of the first circuit board CB1 is electrically connected to the inductor wiring T1-2 of the second circuit board CB2 through the conductive column PC_2 so that after the inductor core CL is sleeved on the inductor wiring Tl-1 and the inductor wiring Tl-2, a closed magnetic circuit may be formed to form a resonant inductor Lr. In one embodiment, since each of the circuit boards CB1, CB2 has inductor wirings Tl-1, Tl-2, the primary-side circuit 1Ais disposed on the first circuit board CB1 and the second circuit board CB2. However, the inductor wirings T1-1, T1-2 may also be disposed on the first circuit board CB1 and then electrically connected to the primary-side winding 22A of the first circuit board CB1 or electrically connected to the primary-side winding 22A through the conductive columns PC_1, PC_2 and the supporting columns PC, and therefore the primary-side circuit 1A may be provided only on the first circuit board CB1.

In FIG. 19C to FIG. 19F and FIG. 20C to FIG. 20F, the primary-side wirings Tp-1, TP-2 respectively surround the first circuit board through hole CB1_H and the second circuit board through hole CB2_H for more than one circle (depending on the turns ratio of the transformer 2A) in different directions to form an ∞-shaped wiring. A plurality of vias Via_A are respectively formed on one side of the first through hole H1 and the second through hole H2 of the first circuit board through hole CB1_H and the third through hole H3 and the fourth through hole H4 of the second circuit board through hole CB2_H. The vias Via_A are located at the end of the primary-side wirings Tp-1, Tp-2, and the vias Via_A are filled with a conductive material (such as but not limited to, a conductive material such as solder paste) so that the primary-side wirings Tp-1, Tp-2 of each sub-layer board LA1-3 to LA1-6, LA2-3 to LA2-6 may be electrically connected through the vias Via_A, and electrically connected to the primary-side wirings Tp-1, Tp-2 through the conductive column PC_1.

In FIG. 19A to FIG. 19B and FIG. 19G to FIG. 19H, the secondary-side wiring Ts-1 and the first through hole H1 and the second through hole H2 of the first circuit board CB1 form an m-shaped wiring. Due to Ampere's right-hand rule, the direction of the current determines the direction of the magnetic field. Therefore, the current direction of the primary-side wiring Tp-1 and the secondary-side wiring Ts-1 formed and surround around the first through hole H1 is the same (for example, clockwise). The current direction of the primary-side wiring Tp-1 and the secondary-side wiring Ts-1 formed and surround around the second through hole H2 is opposite to that of the first through hole H1 (for example, counterclockwise). The secondary-side wiring Ts may include a plurality of vias Via_B near the output terminal OUT, and the vias Via_B are filled with conductive material so that the secondary-side wiring Ts-1 of each sub-layer board LA1-1 to LA1-2 and LA1-7 and LA1-8 may be electrically connected through the vias Via_B to form the secondary-side winding 22B. The secondary-side wiring Ts-2 of FIG. 20A to FIG. 20B and FIG. 20G to FIG. 20H is relative to the secondary-side wiring Ts-1, and may be electrically connected through the vias Via_B to form another secondary-side winding 22B.

In FIG. 19F and FIG. 20F, the inductor wiring T1-1 is formed and surrounds the first inductor through hole HL1, and the inductor wiring T1-2 is formed and surrounds the second inductor through hole HL2. In one embodiment, the copper foil of the inductor wiring Tl-1 and the cooper foil of the primary-side wiring Tp-1 are integrally formed, and copper foil of the inductor wiring Tl-2 and the copper foil of the primary-side wiring Tp-2 are integrally formed. Therefore, a portion of the integrally formed copper foil belongs to the inductor wiring Tl-1, and the other portion belongs to the primary-side wiring Tp-1 (the same is true for the inductor wiring Tl-2). In other embodiments, the inductor wiring T1-1 and the primary-side wiring Tp-1 may be separately arranged (the same is true for the inductor wiring T1-2 and the primary-side wiring Tp-2), for example, other circuit components such as a resonant capacitor Cr may be included between the two. In one embodiment, the inductor wiring Tl-1, the primary-side wiring Tp-1, and the secondary-side wiring Ts1 are not limited to be stacked in the order of FIG. 18A to FIG. 18H. The first and second sub-layer boards described below are not in a stacking order, but only represent a sub-layer board LA1-1 and another sub-layer board LA1-8 in the first circuit board CB1.

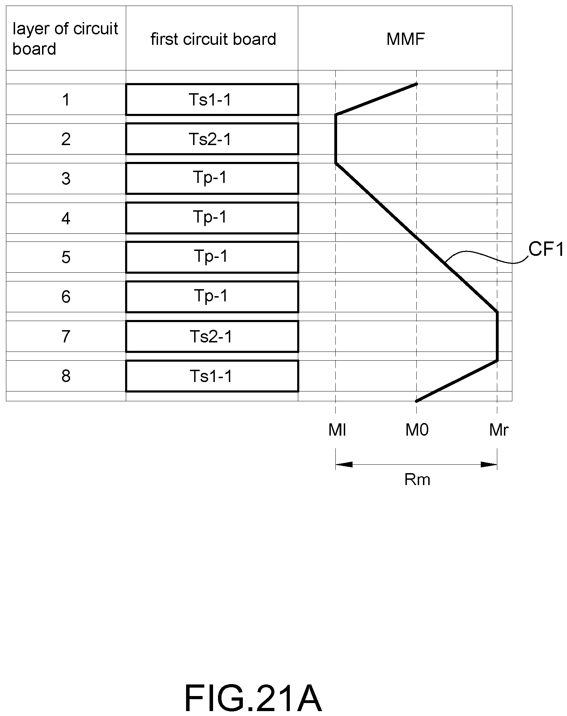

Please refer to FIG. 21A, which shows a schematic diagram of a wiring stacking structure of the planar transformer of FIG. 19A to FIG. 19H on each sub-layer board of the first circuit board according to a second embodiment, and a magnetomotive force curve when using the first circuit board for the first secondary-side wirings in operation. The left side of FIG. 21A shows the wiring stacking structure diagrams of FIG. 19A to FIG. 19H in order from top to bottom, and the right side of FIG. 21A shows the magnetomotive-force curve CF1 formed by the wiring stacking structure corresponding to the left side of FIG. 21A. In this embodiment, the sub-layer boards LA1-1 to LA1-2 and LA1-7 to LA1-8 form a circle of the first secondary-side wiring Ts1-1 or the second secondary-side wiring Ts2-1 with the through holes H1, H2 as the center, and the sub-layer boards LA3 to LA6 form a circle of the primary-side wiring Tp-1 with the through holes H1, H2 as the center. The spacing between each wiring may be regarded as the thickness between each sub-layer board LA1-1 to LA1-8. In one embodiment, since the layer space of the first circuit board CB1 is sufficient, the insulating layer of the primary-side, secondary-side layer boards (i.e., between the sub-layer boards LA1-2, LA1-3, and between the sub-layer boards LA1-6, LA1-7) can be thickened to reduce parasitic capacitance, thereby optimizing the dead time, increasing efficiency, and improving electromagnetic interference. The horizontal axis of the magnetomotive-force graph is magnetomotive force (MMF), and the vertical axis is position. The origin of the vertical axis is the magnetic flux origin M0, and the left and right of the magnetic flux origin M0 respectively include a first predetermined offset Ml and a second predetermined offset Mr.

In one embodiment, the first predetermined offset Ml and the second predetermined offset Mr are ideal predetermined offsets acquired after the parameters of the transformer 2A are calculated. Furthermore, when the transformer 2A actually operates, the actual offset may not be completely equal to the first predetermined offset Ml and the second predetermined offset Mr, but it may still be within an error range between the first predetermined offset Ml and the second predetermined offset Mr. The formation of the primary-side wiring Tp-1 enables the primary-side wiring Tp-1 to generate a first direction magnetic flux F_D1 when the primary-side circuit 1A operates. The formation of the first secondary-side wiring Ts1-1 enables the first secondary-side wiring Ts1-1 to generate a second direction magnetic flux F_D2 opposite to the first direction magnetic flux F_D1 when the first switch SR1 of the secondary-side circuit 3A operates.

When the primary-side wiring Tp-1 generates the first direction magnetic flux F_D1, resulting in magnetic flux deviation, the second direction magnetic flux F_D2 generated by the first secondary-side wiring Ts1-1 will deviate the magnetomotive force MMF in the opposite direction so as to maintain the first direction magnetic flux F_D1 and the second direction magnetic flux F_D2 within a specific range Rm formed by the magnetic flux origin M0 and the first predetermined offset Ml and the second predetermined offset Mr. Therefore, the magnetomotive-force curve CF1 of the first circuit board CB1 is maintained within the specific range Rm so that the magnetomotive force MMF is kept balanced when the planar transformer 2A operates.

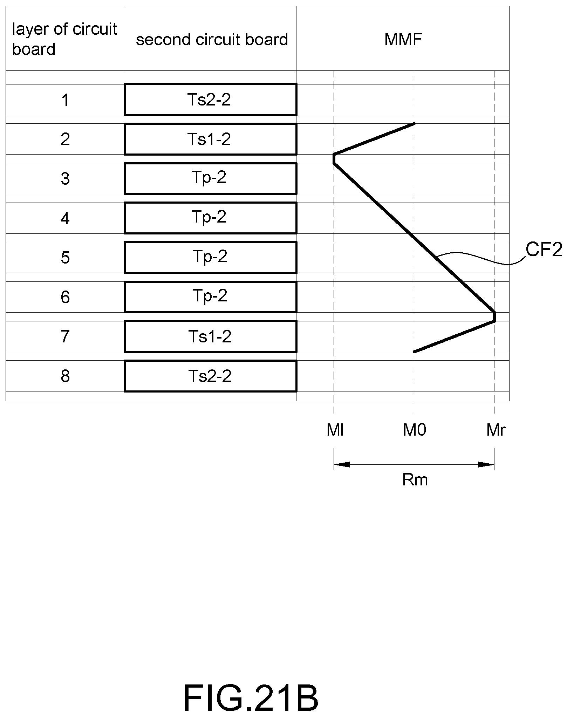

In the center tap structure of the first winding 22B-1, since only the first switch SR1 or the second switch SR2 works in the same half cycle, when the first switch SR1 is turned on and the second switch SR2 is not turned on, the second winding 22B-2 and the rectifier switch SR2 do not form a current path so that the magnetomotive force MMF of the second secondary-side wiring Ts2-1 does not deviate toward the first predetermined offset Ml or the second predetermined offset Mr. According to the above logic, the magnetomotive-force curve CF can be inferred when the first switch SR1 is not turned on and the second switch SR2 is turned on, which will not be described in detail here. Please refer to FIG. 21B, which shows a schematic diagram of a wiring stacking structure of the planar transformer of FIG. 20A to FIG. 20H on each sub-layer board of the second circuit board according to the second embodiment, and a magnetomotive force curve when using the second circuit board for the first secondary-side wirings in operation. Since the wiring stacking structure of each layer of the second circuit board CB2 is exactly the same as that of the first circuit board CB1, the wiring stacking structure of the second circuit board CB2 may also maintain the first direction magnetic flux F_D1 and the second direction magnetic flux F_D2 within a specific range Rm formed by the magnetic flux origin M0 and the first predetermined offset Ml and the second predetermined offset Mr. Therefore, the magnetomotive-force curve CF2 of the second circuit board CB2 is maintained within the specific range Rm so that the magnetomotive force MMF is kept balanced when the planar transformer 2A operates.

FIG. 4A to FIG. 4B and FIG. 16A to FIG.16B are both converting the circuit of the resonant converter 100 into a physical structure. The main difference is that FIG. 4A and FIG. 4B is a physical structure of a single circuit board CB, and FIG. 16A and FIG. 16B is a physical structure of two circuit boards CB1, CB2. Therefore, the technologies such as Litz wire, interleaving winding, embedding technology, component setting (disclosed in FIG. 8A to FIG. 14B) may also be applied to the physical structure of two circuit boards CB1, CB2.

FIG. 8A to FIG. 11C and FIG. 16A to FIG. 16B, in the technology of using a physical structure of two circuit boards CB1, CB2 matched with Litz wire, the inductor wiring Tl-1, the primary-side wiring Tp-1 and the secondary wiring Ts-1 of the circuit board CB1 can be wound around each other using multiple insulated wires, and the inductor wiring Tl-2, the primary-side wiring Tp-2 and the secondary wiring Ts-2 of the circuit board CB2 can also be wound around each other using multiple insulated wires to effectively reduce the AC impedance. Please refer to FIG. 12A to FIG. 13, FIG. 16A, and FIG. 16B, in the technology of using a physical structure of two circuit boards CB1, CB2 matched with interleaving winding, the first secondary-side wiring Ts1-1 and the second secondary-side wiring Ts2-1 of the secondary-side wiring Ts1 on the circuit board CB1 use the ring-shaped interleaving wiring structure, and the first secondary-side wiring Ts1-2 and the second secondary-side wiring Ts2-12 of the secondary-side wiring Ts2 on the circuit board CB2 also use the ring-shaped interleaving wiring structure to achieve the effect of magnetic flux cancellation.

In the technology of using a physical structure of two circuit boards CB1, CB2 matched with Litz wire shown in FIG. 8B, the periphery of the wiring area of the first circuit board CB1 and the periphery of the through hole H1 include a plurality of vias Via__C, and the vias Via_C are electrically connected to the first sub-layer board LA1 and the second sub-layer board LA2. The periphery of the wiring area of the second circuit board CB2 and the periphery of the through hole H3 also include a plurality of vias Via_C, and the vias Via_C are also electrically connected to the first sub-layer board LA1 and the second sub-layer board LA2. The wirings T_1 to T_3 of the first circuit board CB1 may be interleaved to extend to the first sub-layer board LA1 and the second sub-layer board LA2 through the vias Via_C on the first circuit board CB1, and the wirings T_1 to T_3 of the second circuit board CB2 can be to extend to the first sub-layer board LA1 and the second sub-layer board LA2 through the vias Via_C on the first circuit board CB1. When the entire wiring area is full, the wirings T_1 to T_3 on the same layer are arranged in parallel, and the wirings T_1(n) to T_3(n) of the first sub-layer board LA1 may be arranged in an overlapping and interleaving manner with the wirings T_1(m) to T_3(m) of the second sub-layer board LA2.

In the technology of using a physical structure of two circuit boards CB1, CB2 of FIG. 11B, the sub-layer boards LA1, LA2 of the first circuit board CB1 are the layers for setting the secondary-side winding 22B, and therefore the wirings T_1 to T_n are a plurality of secondary-side wirings Ts-1_1 to Ts-1_n for electrically connecting the secondary-side winding 22B of one of the two secondary-side circuits 3A. The sub-layer boards LA1, LA2 of the second circuit board CB2 are the layers for setting the secondary-side winding 22B, and therefore the wirings T_1 to T_n are a plurality of secondary-side wirings Ts-1_1 to Ts-1_n for electrically connecting the secondary-side winding 22B of the other of the two secondary-side circuits 3A. Also referring to FIG. 19A to FIG. 19B, FIG. 19G to FIG. 19H, FIG. 20A to FIG. 20B, and FIG. 20G to FIG. 20H, the interleaving secondary-side wirings Ts_1 to Ts_n in FIG. 11B can replace the first secondary-side wirings Ts1-1, Ts1-2 or the second secondary-side wirings Ts2-1, Ts2-2, and apply the technology of FIG. 8A to FIG. 10D to set the angle θ and wire width and wire spacing. The primary-side wirings Tp-1, Tp-2 of FIG. 19C to FIG. 19F and FIG. 20C to FIG. 20F may be set by applying or not applying the wiring interleaving technology of FIG. 8A to FIG. 10D and FIG. 11A to FIG. 11B, which can be determined according to the size of the AC impedance AC_R and the uniformity of magnetic flux.

In the technology of using a physical structure of two circuit boards CB1, CB2 matched with interleaving winding, the planar transformer PE includes two first vias Via_E, two second vias Via_F, two third vias Via_G, and two fourth vias Via_H. One first via Via_E and one second via Via_F are formed on a first side and a second side opposite to the first side of the first through hole H1 respectively, and the first via Via_E and the second via Via_F are used to electrically connect the first sub-layer board LA1 and the second sub-layer board LA2 of the first circuit board CB1. One third via Via_G and one fourth via Via_H are formed on the first side and the second side opposite to the first side of the first through hole H1 respectively, and the third via Via_G and the fourth via Via_H are used to electrically connect the first sub-layer board LA1 and the second sub-layer board LA2 of the first circuit board CB1. The other first via Via_E, the other second via Via_F, the other third via Via__G, and the other fourth via Via_H are disposed on the second circuit board CB2, and the disposed position is the same as that of the first circuit board CB2. In one embodiment, the second side is a side close to the output terminal OUT, the first side is located at the other side of the first through hole H1, and the first switch SR1, the second switch SR2, and the output capacitor Co are disposed on the second side.

In the physical structure of the two circuit boards CB1, CB2 as shown in the sub-diagram (a) of FIG. 12A, the first secondary-side wiring Ts1-1_(n) of the first circuit board CB1 may be located on the first sub-layer board LA1 and electrically connected to the first switch SR1. The first secondary-side wiring Ts1-1_(n) extends from the first sub-layer board LA1 in the first direction D1 surrounding the first through hole H1 to the first via Via_E, and extends through the first via Via_E to the second Sub-layer board LA2. As shown in the sub-diagram (b) of FIG. 12A, the first secondary-side wiring Ts1-1_(m) extending to the second sub-layer board LA2 continues in the first direction D1 and extends to the second side to electrically connect the output capacitor Co through the second via Via_F.

The second secondary-side wiring Ts2-2_(n) of the first circuit board CB1 may be located on the first sub-layer board LA1 and electrically connected to the second switch SR2. The second secondary-side wiring Ts2-1_(n) extends from the first sub-layer board LA1 in the second direction D2 around the first through hole H1 to the third via Via_G, and extends to the second sub-layer board LA2 through the third via Via_G. The second secondary-side wiring Ts2-1_(m) extending to the second sub-layer board LA2 continues in the second direction D2 and extends to the second side and electrically connected to the output capacitor Co through the fourth via Via_H. As shown in the sub-diagram (a) and the sub-diagram (b) of FIG. 12A, the first switch SR1 and the second switch SR2 are respectively disposed on two different sides of the second via Via_F (the fourth via Via__H), and the first direction D1 and the second direction D2 are in opposite directions along the first through hole H1 to form a ring-shaped interleaving wiring structure.

Please refer to FIG. 12B, the first via Via_E and the second via Via_F are respectively formed on a third side of the second through hole H2 of the first circuit board CB1 and a fourth side opposite to the third side, and the first via Via_E and the second via Via _F are used to electrically connect the first sub-layer board LA1 and the second sub-layer board LA2 of the first circuit board CB1. The third side and the first side of FIG. 12A may be the same side, and the fourth side and the second side may be the same side. The only difference is that the positions of the first through hole H1 and the second through hole H2 are different.

As shown in the sub-diagram (a) and the sub-diagram (b) of FIG. 12B, the first secondary-side wiring Ts1-1_(n) of the first circuit board CB1 extends from the first sub-layer board LA1 in the second direction D2 around the second through hole H2 to the first via Via__E, and extends to the second sub-layer board LA2 through the first via Via_E. The first secondary-side wiring Ts1-1_(m) extending to the second sub-layer board LA2 continues in the second direction D2 and extends to the fourth side and electrically connected to the output capacitor Co through the second via Via_F. The second secondary-side wiring Ts2-1_(n) of the first circuit board CB1 extends from the first sub-layer board LA1 in the first direction D1 around the second through hole H2 to the third via Via_G, and extends to the second sub-layer board LA2 through the third via Via_G. The second secondary-side wiring Ts2-1_(m) extending to the second sub-layer board LA2 continues in the first direction D1 and extends to the fourth side and electrically connected to the output capacitor Co through the fourth via Via_H. Another difference between FIG. 12B and FIG. 12A is that the first secondary-side wirings Ts1-1_(n), Ts1-1_(m) and the second secondary-side wirings Ts2-1_(n), Ts2-1_(m) of the first circuit board CB1 are arranged at opposite positions on the left and right, and extending directions are also opposite.

The second circuit board CB2 is arranged similarly to the first circuit board CB1, that is, the first secondary-side wiring Ts1-2 and the second secondary-side wiring Ts2-2 are respectively arranged along the third through hole H3 in the opposite directions of the first direction D1 and the second direction D2, and the first secondary-side wiring Ts1-2 and the second secondary-side wiring Ts2-2 are respectively arranged along the fourth through hole H4 in the opposite directions of the first direction D1 and the second direction D2 to form a ring-shaped interleaving wiring structure.

In FIG. 19A to FIG. 19B and FIG. 19G to FIG. 19H, and also refer to FIG. 13, since the secondary-side wiring Ts1 and the first through hole H1 and the second through hole H2 of the first circuit board CB1 form an m-shaped wiring, the interleaving wiring extension manners of FIG. 12A and FIG. 12B may be integrated together to form the secondary-side wiring Ts of FIG. 13. As shown in the sub-diagram (a) of FIG. 13, when the two sides of the m-shaped wiring are the first secondary-side wirings Ts1_(n), the two groups of second secondary-side wirings Ts2-1_(n) in the first direction D1 and the second direction D2 in FIG. 12A and FIG. 12B may be sandwiched between the first secondary-side wirings Ts1-1_(n). Since the two groups of second secondary-side wirings Ts2-1_(n) in FIG. 12A and FIG. 12B have the same properties, they may be integrated into an integrally formed configuration. As shown in the sub-diagram (b) of FIG. 13, when the two sides of the m-shaped wiring are the second secondary-side wirings Ts2-1_(n), the two groups of first secondary-side wirings Ts1-1_(n) in the first direction D1 and the second direction D2 in FIG. 12A and FIG. 12B may be sandwiched between the second secondary-side wirings Ts2-1_(n), and therefore the two groups of first secondary-side wirings Ts1-1_(n) may be integrated into an integrally formed configuration. The second circuit board CB2 has the same characteristics as the first circuit board CB1 and may also integrate wirings with the same properties into an integrated configuration.

In one embodiment, FIG. 19A to FIG. 19H and FIG. 20A to FIG. 20H may be combined with the wiring interleaving layout structure in FIG. 11A to FIG. 11C and the wiring interleaving winding structure in FIG. 12A to FIG. 13 for application. The two circuit boards CB1, CB2 need to use four sub-layer boards, such as LA1, LA2, LA3, LA4, and an additional layer is set for the other of the primary-side wiring Tp and the secondary-side wiring Ts, which is not applied to the wiring interleaving layout structure and the wiring interleaving winding structure, such as LA5.

Please refer to FIG. 14A to FIG. 14G and FIG. 16A to FIG. 16B, in the technology of using a physical structure of two circuit boards CB1, CB2 matched with embedding technology, the inductor winding Lc, the winding 22, or the power component 400 may be embedded between the circuit boards CB1, CB2. In the first circuit board CB1, the power component 400 of the first circuit board CB1, a portion of the inductor winding Lc, a portion of the primary-side winding 22A and the secondary-side winding 22B of the first circuit board CB1 may be embedded in the first circuit board CB1; in the second circuit board CB2, the power component 400 of the second circuit board CB2, a portion of the inductor winding Lc, a portion of the primary-side winding 22A and the secondary-side winding 22B of the first circuit board CB1 may be embedded in the second circuit board CB2 so as to simplify the complexity of the circuit design, reduce the AC impedance AC_R of the circuit boards CB1, CB2 as much as possible, and increase the circuit efficiency.

In the physical structure of the two circuit boards CB1, CB2 as shown in FIG. 14A, the power component 400 (for example, power switches Q1, Q2, the first switch SR1, the second switch SR2, the output capacitor Co (non-electrolytic capacitor), and a driver for driving switches Q1, Q2, SR1, SR2) may be embedded in any sub-layer LA1 to LA8 (sub-layer LA1 is used as an example) of the two circuit boards CB1, CB2 by using embedded technology. Afterward, the vias Via_D formed on the circuit boards CB1, CB2 are used to generate contact pads on the surface so that the power component 400 may be electrically connected to the contact pads through the vias Via_D, for example, electronic components Ce (for example, capacitors, resistors, etc.), any wiring T_1(n), T_1(m), T_2(n), T_2(m) of the winding 22, and electrical wirings Tc used to electrically connect the electronic component Ce. Please refer to FIG. 14B, the electronic component Ce (for example, capacitors, resistors, switches, etc.) or the electrical wiring Tc may be electrically connected to the power component 400 by soldering to the contact pads.

In the physical structure of the two circuit boards CB1, CB2 as shown in FIG. 14C, each of the two circuit boards CB1, CB2 includes one group of secondary-side circuit 3A and one group of secondary-side wiring Ts-1. The secondary-side wring Ts-1 serves as one group of secondary-side winding 22B, that is, the resonant converter 100 includes two groups of secondary-side windings 22B and two groups of secondary-side circuits 3A. In one embodiment, the power components 400 (for example, the first switch SR1, the second switch SR2, the controller IC_SR that controls the first switch SR1 and the second switch SR2, the output capacitor Co, etc.). The output capacitor Co is electrically connected to the first switch SR1 and the second switch SR2 to form the secondary-side circuit 3A) and may be embedded in any sub-layer board of the first circuit board CB1 (for example, embedded in the surface boards LA1, LA8 of the first circuit board CB1) by using the embedding technology shown in FIG. 14A to FIG. 14B. Afterward, copper is melted into the pre-formed via Via_D to generate contact pads Pad on the sub-layer boards LA1, LA8 so that the first circuit board CB1 has only contact pads at the positions of the power component 400. Furthermore, the power component 400 (the first switch SR1, the second switch SR2, and the output capacitor Co) may be electrically connected to the secondary-side wiring 22B of the first circuit board CB1 through the corresponding plural vias Via_D. In one embodiment, the power component 400 of the secondary side of the first circuit board CB1 is disposed on one side of the first circuit board through hole CB1_H (referring to FIG. 11A to FIG. 11C, the first circuit board through hole CB1_H may be the first through hole H1 or the second through hole H2), and the first switch SR1 and the second switch SR2 are respectively disposed on two sides of the output capacitor Co. Furthermore, the first secondary-side wiring Ts1-1 is disposed on the sub-layer boards LA1, LA8, and the second secondary-side wiring Ts2-1 is disposed on the sub-layer boards LA2, LA7. The configuration of the second circuit board CB2 is similar to that of the first circuit board CB1. The power component 400 may be electrically connected to the secondary winding 22B of the second circuit board CB2 through the corresponding plurality of vias Via_D, and the power component 400 is disposed on one side of the second circuit board through hole CB2_H.

In the physical structure of the two circuit boards CB1, CB2 as shown in FIG. 14C, the embedding technology may also be applied to the primary side of the resonant converter 100, and also refer to FIG. 3A to FIG. 3C. The primary-side circuit 1A includes a primary-side switch bridge arm SP_1, and the primary-side switch bridge arm SP_1 includes a first power switch Q1 and a second power switch Q2. The first power switch Q1 and the second power switch Q2 may be embedded in any sub-layer board of the first circuit board CB1 by the embedding technology described in FIG. 14C, and the first power switch Q1 and the second power switch Q2 are electrically connected to the primary-side winding 22A through a plurality of corresponding vias Via_D.

In the physical structure of the two circuit boards CB1, CB2 as shown in FIG. 14F, the inductor winding Lc of the resonant inductor Lr and the winding 22 of the planar transformer PE may also be embedded in any sub-layer board LA1 to LA8 of the circuit boards CB1, CB2 by using the embedding technology (the sub-layer board LA1 is used as an example). In particular, each of the two circuit boards CB1, CB2 includes one group of inductor wiring Tl-1, Tl-2, one group of primary-side wiring Tp-1, Tp-2, and one group of secondary-side wiring Ts-1, Ts-2. The inductor wirings Tl-1, Tl-2 are electrically connected through the conductive column PC_2 to form the inductor winding Lc, and the primary-side wirings Tp-1, Tp-2 are electrically connected through the conductive column PC_1 to form the primary-side winding 22A. The primary-side winding 22A and the secondary-side winding 22B formed by the secondary-side wirings Ts-1, Ts-2 together constitute the winding 22 of the planar transformer PE. The embedding technology of the resonant inductor Lr and the planar transformer PE is mainly to use the structure of the modular winding WM for the inductor winding Lc and the winding 22, and the modular winding WM may also be embedded in any sub-layer board of the circuit boards CB1, CB2 by using embedding technology. The wirings T_1(n) to T_3(n) of the first layer (upper layer) of the modular winding WM are arranged in the same extension direction DW_1 and electrically connected to the wrings T_1(n) to T_3(n) of the second layer (lower layer) through the conductive material MC (for example, copper, aluminum, etc., preferably a columnar structure). The wirings T_1(m) to T_3(m) of the lower layer are also arranged in the same extension direction DW_2 so that the wirings T_1 to T_3 interleavingly extend on the first layer and the second layer through the conductive material MC. The wirings T_1 to T_3 on different layers form an acute angle with the conductive material as the center, and the angle of the acute angle is preferably between 25 degrees and 30 degrees.

In the physical structure of the two circuit boards CB1, CB2 as shown in FIG. 14E, when the embedding technology is applied to the inductor winding Lc and the winding 22 of the resonant converter 100, the modular inductor winding Lc and the winding 22 (i.e., the modular winding WM) may also be formed in the via Via_D of the circuit board CB1, CB2 to generate contact pads Pad on the surface. The modular inductor winding Lc may be electrically connected to the primary-side circuit 1A of the circuit board CB1, CB2 through the vias Via_D, and the modular winding 22 may be electrically connected to the primary-side circuit 1A or the secondary-side circuit 3A of the circuit board CB1, CB2 through the vias Via_D. In the physical structure of the two circuit boards CB1, CB2 as shown in FIG. 14F, when the power components 400 and the wirings T (i.e., the modular winding WM) of the circuit boards CB1, CB2 are embedded in the circuit boards CB1, CB2 by using the embedding technology, the power component 400 and the modular winding WM of each circuit board CB1, CB2 may be electrically connected through electrical wirings Tc_1, Tc_2 to shorten the distance between the power component 400 and the modular winding WM.

Please refer to FIG. 14A to FIG. 14B and FIG. 16A to FIG. 16B, in the technology of using a physical structure of two circuit boards CB1, CB2 matched with component setting of the secondary-side circuit 3A, the first switch SR1, the second switch SR2, and the output capacitor Co of the circuit board CB1 may be disposed at one terminal of the circuit board CB1, and the output capacitor Co is disposed between the first switch SR1 and the second switch SR2. The first switch SR1, the second switch SR2, and the output capacitor Co of the circuit board CB2 may also be disposed at one terminal of the circuit board CB2, and the output capacitor Co is disposed between the first switch SR1 and the second switch SR2. The circuit boards CB1, CB2 can be configured as described above to make the current paths Li of the secondary-side wirings Ts-1, Ts- 2 arc-shaped so as to provide the shortest current path Li and reduce path loss. In one embodiment, the detailed circuit structures of FIG. 16A and FIG. 16B in combination with FIG. 8A to FIG. 14B can be used in conjunction with reference to FIG. 8A to FIG. 14B and FIG. 16A to FIG. 16B.

In the physical structure of the two circuit boards CB1, CB2 as shown in FIG. 15A and FIG. 15B, each of the two circuit boards CB1, CB2 includes a first switch SR1, a second switch SR2, and an output capacitor Co. Furthermore, the configuration of the first switch SR1, the second switch SR2, and the output capacitor Co of the two circuit boards CB1, CB2 is the same as that of FIG. 15A. That is, the first switch SR1 and the second switch SR2 of the two circuit boards CB1, CB2 are respectively disposed on the same side of the first circuit board through hole CB1_H and the second circuit board through hole CB2_H, and the output capacitor Co is disposed between the first switch SR1 and the second switch SR2. In one embodiment, the positions of the first switch SR1 and the second switch SR2 are mirrored with the output capacitor Co as the center, and the components of the two circuit boards CB1, CB2 are preferably mirrored.

Please refer to sub-diagram (a) of FIG. 15B, in the physical structure of two circuit boards CB1, CB2, the first switch SR1, the second switch SR2, and the output capacitor Co of the first circuit board CB1 are arranged on the same surface of the first circuit board CB1, and the first secondary-side wiring Ts1 and the second secondary-side wiring Ts2 are respectively arranged on at least any two layers of the circuit board CB (illustrated by the first sub-layer board LA1 and the second sub-layer board LA2 of the first circuit board CB 1). When the first switch SR1 of the first circuit board CB1 is turned on, the current I1 flows from the first switch SR1 around the first circuit board through hole CB1_H (which may include the first through hole H1 or the first through hole H1 and the second through hole H2) on the first sub-layer board LA1 to the output capacitor Co to form a current path Li_1. Furthermore, when the second switch SR2 of the first circuit board CB1 is turned on, the current I2 flows from the second switch SR2 around the first circuit board through hole CB1_H in the second sub-layer board LA2 to the output capacitor Co to form a current path Li_2. The components of the second circuit board CB2 are arranged in the same manner as those of the first circuit board CB1, and the current paths Li_1, Li_2 are also the same as those of the first circuit board CB1. Since the directions of the current path Li_1 and the current path Li_2 are opposite, the magnetic flux cancellation effect can be achieved, thereby increasing the overall efficiency of the circuit.

Please refer to sub-diagram (b) of FIG. 15B, in the physical structure of two circuit boards CB1, CB2, the resonant converter 100 includes two groups of secondary-side circuits 3A and two groups of secondary-side wirings Ts, and each group of secondary-side wiring Ts includes a first secondary-side wiring Ts1 and a second secondary-side wiring Ts2. The two groups of secondary-side circuits 3A are respectively disposed on the first circuit board CB1 and the second circuit board CB2, and each group of secondary-side circuits 3A includes a first switch SR1, a second switch SR2, and more than two output capacitors Co. In the first circuit board CB1, two first switches SR1, two second switches SR2, and at least one output capacitor Co are respectively arranged on two surfaces of the first circuit board CB1, and the first secondary-side wiring Ts1 and the second secondary-side wiring Ts2 are respectively arranged on at least any four layers of the circuit board CB (illustrated by the first secondary-side wirings Ts1 arranged on the sub-layer boards LA1, LA2 of the first circuit board CB1 and the second secondary-side wirings Ts2 arranged on the sub-layer boards LA7, LA8). When the two first switches SR1 of the first circuit board CB1 are turned on, the current I1 flows from the first switch SR1 around the first circuit board through hole CB1_H (which may include the first through hole H1 or the first through hole H1 and the second through hole H2) on the sub-layer boards LA1, LA8 to the output capacitor Co to form a current path Li_1. When the two second switches SR1 of the first circuit board CB1 are turned on, the current I2 flows from the second switch SR2 around the first circuit board through hole CB1_H on the sub-layer boards LA2, LA7 to the output capacitor Co to form a current path Li_2. The components of the second circuit board CB2 are arranged in the same manner as those of the first circuit board CB1, and the current paths Li_1, Li_2 are also the same as those of the first circuit board CB1. Since the directions of the current path Li_1 and the current path Li_2 are opposite, the magnetic flux cancellation effect can be achieved, thereby increasing the overall efficiency of the circuit.

Please refer to sub-diagram (c) of FIG. 15B, in the physical structure of two circuit boards CB1, CB2, the resonant converter 100 includes two groups of secondary-side circuits 3A and two groups of secondary-side wirings Ts, and each group of secondary-side wiring Ts includes a first secondary-side wiring Ts1 and a second secondary-side wiring Ts2. The two groups of secondary-side circuits 3A are respectively disposed on the first circuit board CB1 and the second circuit board CB2, and each group of secondary-side circuits 3A includes a first switch SR1, a second switch SR2, a third switch SR3, a fourth switch SR4, and more than two output capacitors Co. In the first circuit board CB1, the first switch SR1, the second switch SR2, and at least one output capacitor Co are arranged on one surface of the first circuit board CB1, and the third switch SR3, the fourth switch SR4, and at least another output capacitor Co are arranged on the other surface of the first circuit board CB1. The secondary-side wiring Ts is arranged on at least any two layers of the first circuit board CB1 (illustrated by the sub-layers LA1, LA8 of the first circuit board CB1). When the first switch SR1 and the second switch SR2 of the first circuit board CB1 are turned on, the current I1 flows from the first switch SR1 and the second switch SR2 around the first circuit board through hole CB1_H (which may include the first through hole H1 or the first through hole H1 and the second through hole H2) on the sub-layer board LA1 to the output capacitor Co to form a current path Li_1. When the third switch SR3 and the fourth switch SR4 of the first circuit board CB1 are turned on, the current I2 (in the same wiring, i.e., the secondary-side wiring Ts, but in the opposite direction) flows from the third switch SR3 and the fourth switch SR4 around the first circuit board through hole CB1_H on the sub-layer board LA2 to the output capacitor Co to form a current path Li_2. The components of the second circuit board CB2 are arranged in the same manner as those of the first circuit board CB1, and the current paths Li_1, Li_2 are also the same as those of the first circuit board CB1. Since the directions of the current path Li_1 and the current path Li_2 are opposite, the magnetic flux cancellation effect can be achieved, thereby increasing the overall efficiency of the circuit.

## Claims

1. A resonant converter (100), **characterized in that** the resonant converter (100) comprising:
a circuit board (CB) comprising a plurality of sub-layer boards (LA1 to LA12),
a primary-side circuit (1A) disposed on the circuit board (CB),
a secondary-side circuit (3A) disposed on the circuit board (CB), and
a planar transformer (PE) disposed on the circuit board (CB) and electrically connected to the primary-side circuit (1A) and the secondary-side circuit (3A), and the planar transformer (PE) comprising:
a first through hole (H1) penetrating the circuit board (CB),
an iron core (C1) comprising a first core column (C12) penetrating the first through hole (H1),
a plurality of vias (Via_A to Via_H) electrically connected to a first sub-layer board (LA1 to LA12) and a second sub-layer board (LA1 to LA12) of the circuit board (CB), and
a plurality of wirings (T_1 to T_n, T_(n), T_(m), T_1(n) to T_n(n), T_1(m) to T_n(m)) formed around the first through hole (H1), and configured to be as a winding (22) of the planar transformer (PE); wherein the plurality of wirings (T_1 to T_n, T_(n), T_(m), T_1(n) to T_n(n), T_1(m) to T_n(m)) interleavingly extend to the first sub-layer board (LA1 to LA12) and the second sub-layer board (LA1 to LA12) through the plurality of vias (Via_A to Via_H), and the wirings (T_1 to T_n, T_(n), T_(m), T_1(n) to T_n(n), T_1(m) to T_n(m)) on the same layer are arranged in parallel.

2. The resonant converter (100) as claimed in claim 1, wherein the planar transformer (PE) further comprises:
a second through hole (H2) penetrating the circuit board (CB),
wherein the iron core (C1) further comprises a second core column (C14) penetrating the first through hole (H1), and the plurality of wirings (T_1 to T_n, T_(n), T_(m), T_1(n) to T_n(n), T_1(m) to T_n(m)) are formed around the first through hole (H1) and the second through hole (H2).

3. The resonant converter (100) as claimed in claim 1, wherein the plurality of wirings (T_1 to T_n, T_(n), T_(m), T_1(n) to T_n(n), T_1(m) to T_n(m)) are a plurality of secondary-side wirings (T_1 to T_n, T_(n), T_(m), T_1(n) to T_n(n), T_1(m) to T_n(m)), and used as a secondary-side winding (22B) electrically connected to the secondary-side circuit (3A), and the planar transformer (PE) further comprises:
a primary-side wiring (Tp, Tp-1, Tp-2) formed on a third sub-layer board (LA1 to LA12) of the circuit board (CB), and used as a primary-side winding (22A) electrically connected to the primary-side circuit (1A).

4. The resonant converter (100) as claimed in claim 3, wherein the planar transformer (PE) further comprises:
a first via (Via_A to Via_H) and a second via (Via_A to Via_H) respectively formed on a first side of the first through hole (H1) and a second side opposite to the first side; the first via (Via_A to Via_H) configured to electrically connect to the first sub-layer board (LA1 to LA12) and a fourth sub-layer board (LA1 to LA12) of the circuit board (CB), and the second via (Via_A to Via_H) configured to electrically connect to the second sub-layer board (LA1 to LA12) and a fifth sub-layer board (LA1 to LA12) of the circuit board (CB); wherein a first switch (SR1), a second switch (SR2), and an output capacitor (Co) of the secondary-side circuit (3A) are disposed on the second side, and
a third via (Via_A to Via_H) and a fourth via (ViaA to Via_H) respectively formed on the first side and the second side; the third via (Via_A to Via_H) configured to electrically connect to the first sub-layer board (LA1 to LA12) and the fourth sub-layer board (LA1 to LA12), and the fourth via (Via_A to Via_H) configured to electrically connect to the second sub-layer board (LA1 to LA12) and the fifth sub-layer board (LA1 to LA12),
wherein the plurality of wirings (T_1 to T_n, T_(n), T_(m), T_1(n) to T_n(n), T_1(m) to T_n(m)) comprise:
a plurality of first secondary-side wirings (Ts1, Ts1-1, Ts1-2, Ts1_(n), Ts1_(m)) electrically connected to the first switch (SR1), and
a plurality of second secondary-side wirings (Ts2, Ts2-1, Ts2-2, Ts2_(n), Ts2_(m)) electrically connected to the plurality of first secondary-side wirings (Ts1, Ts1-1, Ts1-2, Ts1_(n), Ts1_(m)) and the second switch (SR2),
wherein the plurality of first secondary-side wirings (Ts1, Ts1-1, Ts1-2, Ts1_(n), Ts1_(m)) extend from the first sub-layer board (LA1 to LA12) to the first via (Via_A to Via_H) in a first direction (D1) surrounding the first through hole (H1), extend to the fourth sub-layer board (LA1 to LA12) through the first via (Via_A to Via_H), and continue to extend to the second side in the first direction (D1) to be electrically connected to the output capacitor (Co) through the second via (Via_A to Via_H),
wherein the plurality of first secondary-side wirings (Ts1, Ts1-1, Ts1-2, Ts1_(n), Ts1_(m)) extend from the second sub-layer board (LA1 to LA12) to the first via (Via_A to Via_H) in the first direction (D1), extend to the fifth sub-layer board (LA1 to LA12) through the first via (Via_A to Via_H), and continue to extend to the second side in the first direction (D1) to be electrically connected to the output capacitor (Co) through the second via (Via_A to Via_H),
wherein the plurality of second secondary-side wirings (Ts2, Ts2-1, Ts2-2, Ts2_(n), Ts2_(m)) extend from the first sub-layer board (LA1 to LA12) to the third via (Via_A to Via_H) in a second direction (D2) surrounding the first through hole (H1), extend to the fourth sub-layer board (LA1 to LA12) through the third via (Via_A to Via_H), and continue to extend to the second side in the second direction (D2) to be electrically connected to the output capacitor (Co) through the fourth via (Via_A to Via_H), and
wherein the plurality of second secondary-side wirings (Ts2, Ts2-1, Ts2-2, Ts2_(n), Ts2_(m)) extend from the second sub-layer board (LA1 to LA12) to the third via (Via_A to Via_H) in the second direction (D2), extend to the fifth sub-layer board (LA1 to LA12) through the third via (Via_A to Via_H), and continue to extend to the second side in the second direction (D2) to be electrically connected to the output capacitor (Co) through the fourth via (Via_A to Via_H),
wherein the first direction (D1) and the second direction (D2) are in opposite directions along the first through hole (H1).

5. The resonant converter (100) as claimed in claim 1, wherein the plurality of wirings (T_1 to T_n, T_(n), T_(m), T_1(n) to T_n(n), T_1(m) to T_n(m)) are a plurality of primary-side wirings (Tp, Tp-1, Tp-2), and used as a primary-side winding (22A) electrically connected to the primary-side circuit (1A), and the planar transformer (PE) further comprises:
a secondary-side wiring (Ts, Ts-1, Ts-2, Ts_1 to Ts_n) formed on the circuit board (CB), and used as a secondary-side winding (22B) electrically connected to the secondary-side circuit (3A).

6. The resonant converter (100) as claimed in claim 1, further comprising:
an inductor through hole (HL) penetrating the circuit board (CB),
an inductance iron core (CL) comprising two covers (CL_1, CL_2), each cover (CL_1, CL_2) comprising a main body, and one of the two covers (CL_1, CL_2) comprising two side portions (CL_3), and
an inductor wiring (Tl, Tl-1, Tl-2) electrically connected to the plurality of wirings (T_1 to T_n, T_(n), T_(m), T_1(n) to T_n(n), T_1(m) to T_n(m)), and surrounding the inductor through hole (HL),
wherein the two side portions (CL_3) are protruded at a periphery of the main body, and one of the two side portions (CL_3) penetrates through the inductor through hole (HL).

7. The resonant converter (100) as claimed in claim 1, wherein the plurality of wirings (T_1 to T_n, T_(n), T_(m), T_1(n) to T_n(n), T_1(m) to T_n(m)) are formed in a wiring area (AS_ 1 to AS_3) of the circuit, and the plurality of vias (Via_A to Via_H) are formed at a periphery of the wiring area (AS_ 1 to AS_3) and a periphery of the first through hole (H1).

8. The resonant converter (100) as claimed in claim 1, wherein the iron core (C1) further comprises:
two covers (CL_1, CL_2), one of the two covers (CL_1, CL_2) forming the first core column (C12), and each cover (CL_1, CL_2) comprising a main body and a plurality of side portions (CL_3),
wherein the side portions (CL_3) of the two covers (CL_1, CL_2) are correspondingly protruded at a periphery of the main body, and one of the side portions (CL_3) located at an outer side of the circuit board (CB) forms an air gap (GP).

9. The resonant converter (100) as claimed in claim 1, wherein the wirings (T_1 to T_n, T_(n), T_(m), T_1(n) to T_n(n), T_1(m) to T_n(m)) on different layers form an acute angle with the vias (Via_A to Via_H) as the center, and the acute angle is between 25 degrees and 35 degrees.

10. A resonant converter (100), **characterized in that** the resonant converter (100) comprising:
a circuit board (CB) comprising a plurality of sub-layer boards (LA1 to LA12),
a primary-side circuit (1A) disposed on the circuit board (CB),
a secondary-side circuit (3A) disposed on the circuit board (CB), and comprising:
a first switch (SR1) disposed on the circuit board (CB),
a second switch (SR2) disposed on the circuit board (CB), and
an output capacitor (Co) disposed on the circuit board (CB), and a first terminal of the output capacitor (Co) electrically connected to a first terminal of the first switch (SR1) and a first terminal of the second switch (SR2),
a planar transformer (PE) disposed on the circuit board (CB) and electrically connected to a second terminal of the first switch (SR1), a second terminal of the second switch (SR2), and a second terminal of the output capacitor (Co), and the planar transformer (PE) comprising:
a first through hole (H1) penetrating the circuit board (CB),
an iron core (C1) comprising a first core column (C12) penetrating the first through hole (H1),
a first via (Via_A to Via_H) and a second via (Via_A to Via_H) respectively formed on a first side of the first through hole (H1) and a second side opposite to the first side, and configured to electrically connect to a first sub-layer board (LA1 to LA12) and a second sub-layer board (LA1 to LA12); wherein the first switch (SR1), the second switch (SR2), and the output capacitor (Co) are disposed on the second side,
a third via (Via_A to Via_H) and a fourth via (Via_A to Via_H) respectively formed on the first side and the second side, and configured to electrically connect to the first sub-layer board (LA1 to LA12) and the second sub-layer board (LA1 to LA12),
a first secondary-side wiring (Ts1, Ts1-1, Ts1-2, Ts1_(n), Ts1_(m)) electrically connected to the first switch (SR1), and
a second secondary-side wiring (Ts2, Ts2-1, Ts2-2, Ts2_(n), Ts2_(m)) electrically connected to the second switch (SR2) and the first secondary-side wiring (Ts1, Ts1-1, Ts1-2, Ts1_(n), Ts1_(m)),
wherein the first secondary-side wiring (Ts1, Ts1-1, Ts1-2, Ts1_(n), Ts1_(m)) extends from the first sub-layer board (LA1 to LA12) to the first via (Via _Ato Via_H) in a first direction (D1) surrounding the first through hole (H1), extends to the second sub-layer board (LA1 to LA12) through the first via (Via_A to Via_H), and continues to extend to the second side in the first direction (D1) to be electrically connected to the output capacitor (Co) through the second via (Via_A to Via_H),
wherein the second secondary-side wiring (Ts2, Ts2-1, Ts2-2, Ts2_(n), Ts2_(m)) extends from the first sub-layer board (LA1 to LA12) to the third via (Via_A to Via_H) in a second direction (D2) surrounding the first through hole (H1), extends to the second sub-layer board (LA1 to LA12) through the third via (Via_A to Via_H), and continues to extend to the second side in the second direction (D2) to be electrically connected to the output capacitor (Co) through the fourth via (Via_A to Via_H),
wherein the first direction (D1) and the second direction (D2) are in opposite directions along the first through hole (H1).

11. The resonant converter (100) as claimed in claim 10, wherein the planar transformer (PE) further comprises:
a second through hole (H2) penetrating the circuit board (CB), and the iron core (C1) further comprising a second core column (C14) penetrating the second through hole (H2),
wherein the first via (Via_A to Via_H) and the second via (Via_A to Via_H) are respectively formed on a third side of the second through hole (H2) and a fourth side opposite to the third side, and configured to electrically connect to the first sub-layer board (LA1 to LA12) and the second sub-layer board (LA1 to LA12); the third via (Via_A to Via_H) and the fourth via (Via_A to Via_H) are respectively formed on the third side and the fourth side, and configured to electrically connect to the first sub-layer board (LA1 to LA12) and the second sub-layer board (LA1 to LA12); the first switch (SR1) and the second switch (SR2) are arranged on the fourth side,
wherein the first secondary-side wiring (Ts1, Ts1-1, Ts1-2, Ts1_(n), Ts1_(m)) extends from the first sub-layer board (LA1 to LA12) to the first via (Via_A to Via_H) in the second direction (D2) surrounding the second through hole (H2), extends to the second sub-layer board (LA1 to LA12) through the first via (Via_A to Via_H), and continues to extend to the fourth side in the second direction (D2) to be electrically connected to the output capacitor (Co) through the second via (Via_A to Via_H),
wherein the second secondary-side wiring (Ts2, Ts2-1, Ts2-2, Ts2_(n), Ts2_(m)) extends from the first sub-layer board (LA1 to LA12) to the third via (Via_A to Via_H) in the first direction (D1) surrounding the second through hole (H2), extends to the second sub-layer board (LA1 to LA12) through the third via (Via_A to Via_H), and continues to extend to the fourth side in the first direction (D1) to be electrically connected to the output capacitor (Co) through the fourth via (Via_A to Via_H).

12. The resonant converter (100) as claimed in claim 11, wherein the first secondary-side wirings (Ts1, Ts1-1, Ts1-2, Ts1_(n), Ts1_(m)) in the first direction (D1) and the second direction (D2) are integrally formed, or the second secondary-side wirings (Ts2, Ts2-1, Ts2-2, Ts2_(n), Ts2_(m)) in the first direction (D1) and the second direction (D2) are integrally formed.

13. The resonant converter (100) as claimed in claim 10, wherein the planar transformer (PE) further comprises:
a primary-side wiring (Tp, Tp-1, Tp-2) formed on a third sub-layer board (LA1 to LA12) of the circuit board (CB) as a primary-side winding (22A) electrically connected to the primary-side circuit (1A).

14. The resonant converter (100) as claimed in claim 10, further comprising:
an inductor through hole (HL) penetrating the circuit board (CB),
an inductance iron core (CL) comprising two covers (CL_1, CL_2), each cover (CL_1, CL_2) comprising a main body, and one of the two covers (CL_1, CL_2) comprising two side portions (CL_3), and
an inductor wiring (Tl, Tl-1, Tl-2) electrically connected to the primary-side wiring (Tp, Tp-1, Tp-2),
a plurality of wirings (T_1 to T_n, T_(n), T_(m), T_1(n) to T_n(n), T_1(m) to T_n(m)), and surrounding the inductor through hole (HL), and surrounding the inductor through hole (HL),
wherein the two side portions (CL_3) are protruded at a periphery of the main body, and one of the two side portions (CL_3) penetrates through the inductor through hole (HL).

15. The resonant converter (100) as claimed in claim 10, wherein the iron core (C1) further comprises:
two covers (CL_1, CL_2), one of the two covers (CL_1, CL_2) forming the first core column (C12), and each cover (CL_1, CL_2) comprising a main body and a plurality of side portions (CL_3),
wherein the side portions (CL_3) of the two covers (CL_1, CL_2) are correspondingly protruded at a periphery of the main body, and one of the side portions (CL_3) located at an outer side of the circuit board (CB) forms an air gap (GP).
